# EUROPEAN PATENT SPECIFICATION

(11) **EP 3 147 958 B1**
(45) Date of publication and mention of the grant of the patent: **23.10.2019**
(21) Application number: 15187135.7
(22) Date of filing: 28.09.2015
(51) Int. Cl.: H01L 51/54, H01L 51/50, C08K 3/38

(54) **ORGANIC ELECTROLUMINESCENT DEVICES COMPRISING BORANE COMPOUNDS**
ORGANISCHE ELEKTROLUMINESZENTE VORRICHTUNGEN MIT BORANVERBINDUNGEN
DISPOSITIFS ÉLECTROLUMINESCENTS ORGANIQUES CONTENANT DES COMPOSÉS DE BORANE

(43) Date of publication of application: 29.03.2017
(73) Proprietor: Novaled GmbH, 01099 Dresden (DE)
(72) Inventor: Cardinali, François, 01099 Dresden (DE); Pavicic, Domagoj, 01279 Dresden (DE); Rothe, Carsten, 01326 Dresden (DE); Fadhel, Omrane, 01099 Dresden (DE); Kaufmann, Dieter, 38678 Clausthal-Zellerfeld (DE); Zapolskii, Viktor, 38678 Clausthal-Zellfeld (DE)
(74) Representative: Bittner, Thomas L.

(56) References cited:
- WO-A1-2005/062675
- JP-A- 2005 317 314
- US-A1- 2003 157 366

## Description

The present invention relates to an organic electroluminescent device, to a borane compound comprised therein as well as to a method for preparing said compound.

### DESCRIPTION OF THE RELATED ART

Organic light-emitting diodes (OLEDs), which are self-emitting devices, have a wide viewing angle, excellent contrast, quick response, high brightness, excellent driving voltage characteristics, and color reproduction. A typical OLED includes an anode, a hole transport layer (HTL), an emission layer (EML), an electron transport layer (ETL), and a cathode, which are sequentially stacked on a substrate. In this regard, the HTL, the EML, and the ETL are thin films formed from organic and / or organometallic compounds.

When a voltage is applied to the anode and the cathode, holes injected from the anode electrode move to the EML, via the HTL, and electrons injected from the cathode electrode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency.

However, there is a continuous need to improve the performance of OLEDs, in particular matrix compounds in the emission layer, electron transport layer and electron injection layer which enable high efficiency and low operating voltage.
WO 2005/062675 A1 discloses a material for organic electroluminescent devices, organic electroluminescent devices comprising the same and illuminating devices and display devices comprising the same.
JP 2005 317314 A discloses an organic electroluminescent element as well as an illumination or display device comprising the same.
US 2003/157366 A1 discloses an organic electroluminescent element which comprises a light emitting layer containing a host compound and a phosphorescent compound, wherein the host compound contains a boron atom in the molecule.

Early attempts at developing efficient charge transport materials based on tri(aryl)borane compounds have failed. For example, use of tri(anthracen-9-yl)borane (CAS 281668-48-2) having the Formula A which is known from WO2000/040586 Alas electron transport material results in very low external quantum efficiency EQE and high operating voltage V.

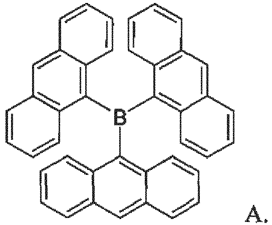

More recent attempts at improving conductivity of borane compounds through substitution of aryl through heteroaryl group have also failed. 3TPYMB (Tris(2,4,6-trimethyl-3-(pyridin-3-yl)phenyl)borane, CAS 929203-02-1) having the Formula B which has been frequently used as electron transport material, for example in JP2007070282A, has several drawbacks.

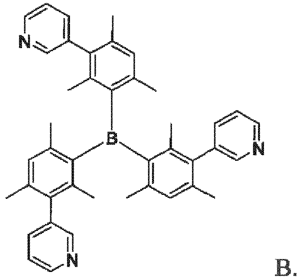

The conductivity is still poor, resulting in high operating voltage V and the external quantum efficiency (EQE), while improved over compound of formula A, is still too low for commercial products. Additionally, the lifetime is poor.

Thus, it is still desired to provide compounds which enable low operating voltage, high external quantum efficiency (EQE) and long lifetime of the OLED.

### SUMMARY

Therefore, it is the object of the present invention to provide organic electroluminescent devices and novel compounds for use therein overcoming drawbacks of the prior art, in particular featuring reduced operating voltage and/or improved external quantum efficiency (EQE) and/or improved lifetime in OLEDs, in particular in fluorescent blue devices.

This object is achieved in accordance with the subject-matter of the independent claims. Preferred embodiments result from the sub-claims.

This object is achieved by an organic electroluminescent device comprising at least one semiconductive layer comprising a compound of formula (I) 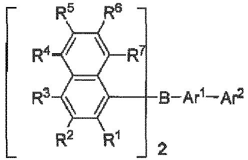 wherein R¹, R³ and R⁷ are independently selected from a group consisting of H, D, C₁-C₁₆ alkyl and C₁-C₁₆ alkoxy; R², R⁴, R⁵ and R⁶ are independently selected from a group consisting of H, D, C₁-C₁₆ alkyl, C₁-C₁₆ alkoxy and C₆-C₂₀ aryl; Ar¹ is selected from substituted or unsubstituted C₆-C₂₀ aryl, wherein, in case that Ar¹ is substituted, the substituents are independently selected from a group consisting of D, C₁-C₁₂ alkyl, C₁-C₁₆ alkoxy and C₆-C₂₀ aryl; and Ar² is selected from a group consisting of H, D, substituted or unsubstituted C₆-C₄₀ aryl and groups of the following formulas (IIa) to (IIh), wherein * marks the position in the respective Ar² group for binding the Ar² to the Ar¹ group, 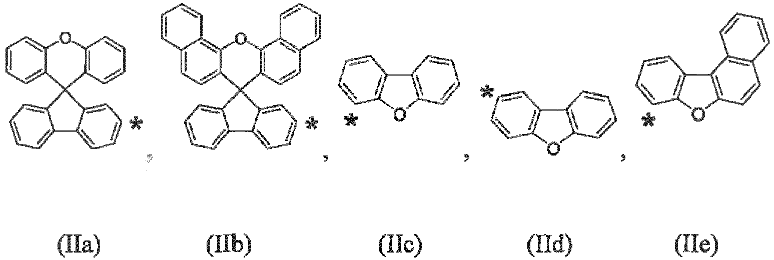 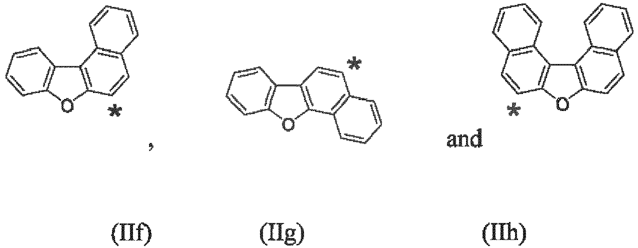 wherein in case that Ar² is substituted, the substituents are independently selected from a group consisting of D, halide, C₁-C₁₆ alkyl, C₁-C₁₆ alkoxy, and C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl; wherein Ar¹ and Ar² may be further linked via a methylene (-CR⁸R⁹⁻) or an oxy (-O-) moiety to form a fluorene or dibenzofuran structure, wherein R⁸ and R⁹ may be independently selected from H, C₁-C₁₆ alkyl and C₁-C₁₆ alkoxy and C₆-C₂₀ aryl wherein the organic electroluminescent device further comprises an emission layer and a cathode, wherein the semiconductive layer comprising the compound of formula (I) is arranged between the emission layer and the cathode electrode.

According to another aspect, there is provided an organic electroluminescent device comprising at least one semiconductive layer comprising a compound of formula (I) 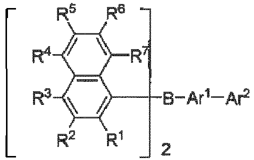 wherein R¹, R³ and R⁷ are independently selected from a group consisting of H, D, C₁-C₁₆ alkyl and C₁-C₁₆ alkoxy; R², R⁴, R⁵ and R⁶ are independently selected from a group consisting of H, D, C₁-C₁₆ alkyl, C₁-C₁₆ alkoxy and C₆-C₂₀ aryl; Ar¹ is selected from substituted or unsubstituted C₆ aryl, wherein, in case that Ar¹ is substituted, the substituents are independently selected from a group consisting of D, C₁-C₁₂ alkyl, C₁-C₁₆ alkoxy and C₆-C₂₀ aryl; and Ar² is selected from a group consisting of H, D, substituted or unsubstituted C₆-C₄₀ aryl and groups of the following formulas (IIa) to (IIh), wherein * marks the position in the respective Ar² group for binding the Ar² to the Ar¹ group, 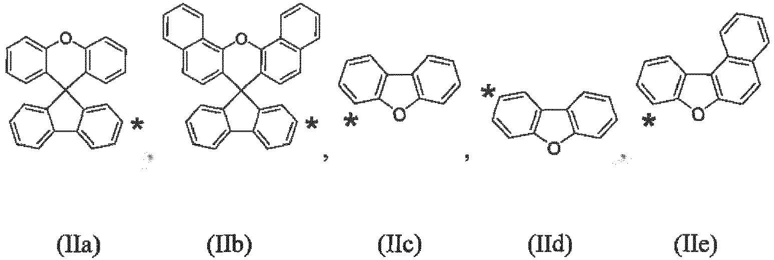 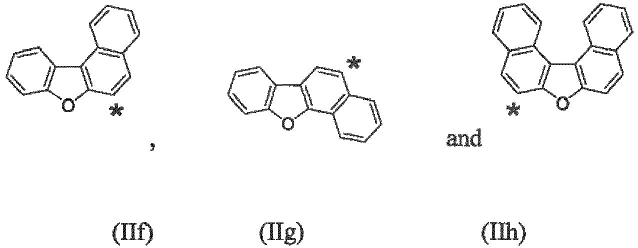 wherein in case that Ar² is substituted, the substituents are independently selected from a group consisting of D, halide, C₁-C₁₆ alkyl, C₁-C₁₆ alkoxy, and C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl; wherein Ar¹ and Ar² may be further linked via a methylene (-CR⁸R⁹-) or an oxy (-O-) moiety to form a fluorene or dibenzofuran structure, wherein R⁸ and R⁹ may be independently selected from H, C₁-C₁₆ alkyl and C₁-C₁₆ alkoxy and C₆-C₂₀ aryl wherein the organic electroluminescent device further comprises an emission layer and a cathode, wherein the semiconductive layer comprising the compound of formula (I) is arranged between the emission layer and the cathode electrode.

According to another aspect, there is provided an organic electroluminescent device comprising at least one semiconductive layer comprising a compound of formula (I) 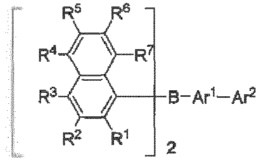 wherein R¹, R³ and R⁷ are independently selected from a group consisting of H, D, C₁-C₁₆ alkyl and C₁-C₁₆ alkoxy; R², R⁴, R⁵ and R⁶ are independently selected from a group consisting of H, D, C₁-C₁₆ alkyl, C₁-C₁₆ alkoxy and C₆-C₂₀ aryl; Ar¹ is selected from substituted or unsubstituted C₆-C₂₀ aryl, wherein, in case that Ar¹ is substituted, the substituents are independently selected from a group consisting of D, C₁-C₁₂ alkyl, C₁-C₁₆ alkoxy and C₆-C₂₀ aryl; and Ar² is selected from a group consisting of H, D, substituted or unsubstituted C₆-C₄₀ aryl and groups of the following formulas (IIa) to (IIh), wherein * marks the position in the respective Ar² group for binding the Ar² to the Ar¹ group, 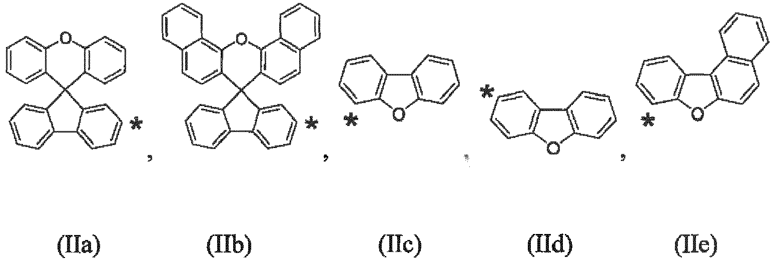 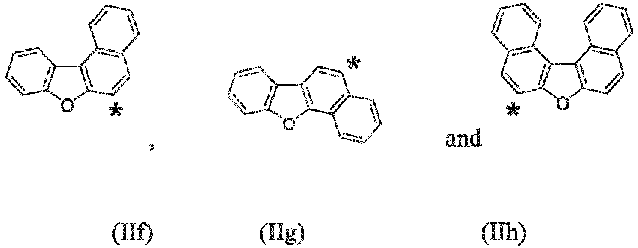 wherein in case that Ar² is substituted, the substituents are independently selected from a group consisting of D, halide, C₁-C₁₆ alkyl, C₁-C₁₆ alkoxy, and C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl; wherein Ar¹ and Ar² may be further linked via an oxy (-O-) moiety to form a dibenzofuran structure wherein the organic electroluminescent device further comprises an emission layer and a cathode, wherein the semiconductive layer comprising the compound of formula (I) is arranged between the emission layer and the cathode electrode.

According to another aspect, there is provided an organic electroluminescent device comprising at least one semiconductive layer comprising a compound of formula (I) 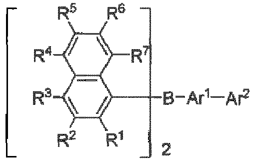 wherein R¹, R³ and R⁷ are independently selected from a group consisting of H, D, C₁-C₁₆ alkyl and C₁-C₁₆ alkoxy; R², R⁴, R⁵ and R⁶ are independently selected from a group consisting of H, D, C₁-C₁₆ alkyl, C₁-C₁₆ alkoxy and C₆-C₂₀ aryl; Ar¹ is selected from substituted or unsubstituted C₆-C₂₀ aryl, wherein, in case that Ar¹ is substituted, the substituents are independently selected from a group consisting of D, C₁-C₁₂ alkyl, C₁-C₁₆ alkoxy and C₆-C₂₀ aryl; and Ar² is selected from a group consisting of H, D, substituted or unsubstituted C₆-C₄₀ aryl and groups of the following formulas (IIa) to (Ilh), wherein * marks the position in the respective Ar² group for binding the Ar² to the Ar¹ group, 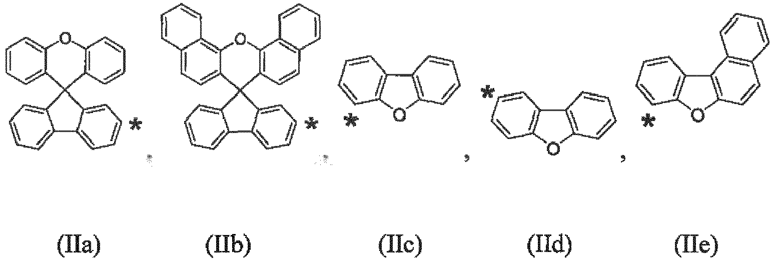 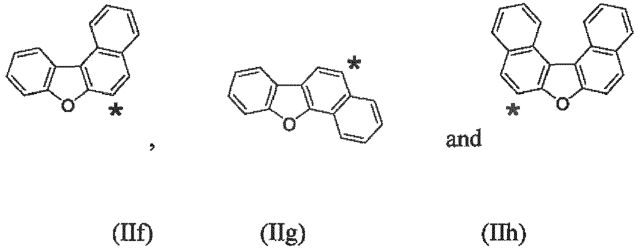 wherein in case that Ar² is substituted, the substituents are independently selected from a group consisting of D, halide, C₁-C₁₆ alkyl, C₁-C₁₆ alkoxy, and C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl wherein the organic electroluminescent device further comprises an emission layer and a cathode, wherein the semiconductive layer comprising the compound of formula (I) is arranged between the emission layer and the cathode electrode.

According to another aspect, there is provided an organic electroluminescent device comprising at least one semiconductive layer comprising a compound of formula (I) 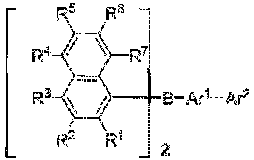 wherein R¹, R³ and R⁷ are independently selected from a group consisting of H, D, C₁-C₁₆ alkyl and C₁-C₁₆ alkoxy; R², R⁴, R⁵ and R⁶ are independently selected from a group consisting of H, D, C₁-C₁₆ alkyl, C₁-C₁₆ alkoxy and C₆-C₂₀ aryl; Ar¹ is selected from substituted or unsubstituted C₆ aryl, wherein, in case that Ar¹ is substituted, the substituents are independently selected from a group consisting of D, C₁-C₁₂ alkyl, C₁-C₁₆ alkoxy and C₆-C₂₀ aryl; and Ar² is selected from a group consisting of H, D, substituted or unsubstituted C₆-C₄₀ aryl and groups of the following formulas (IIa) to (IIh), wherein * marks the position in the respective Ar² group for binding the Ar² to the Ar¹ group, 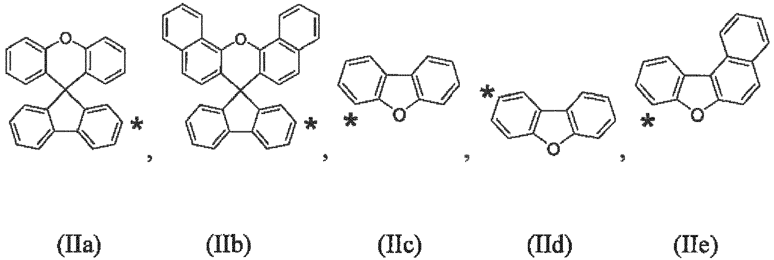 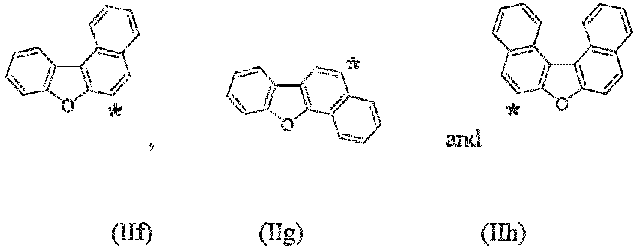 wherein in case that Ar² is substituted, the substituents are independently selected from a group consisting of D, halide, C₁-C₁₆ alkyl, C₁-C₁₆ alkoxy, and C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl wherein the organic electroluminescent device further comprises an emission layer and a cathode, wherein the semiconductive layer comprising the compound of formula (I) is arranged between the emission layer and the cathode electrode.

It is preferred that the organic electroluminescent device according to the present invention is an organic light-emitting diode (OLED).

The organic light-emitting diode (OLED) may be a bottom- or top-emitting diode.

According to another aspect, the organic electroluminescent device according to the present invention may comprise more than one emission layer, preferably two or three emission layers.

The compound of formula (I) may function in the semiconductive layer of the inventive organic luminescent device as an electron transport material.

In the present invention, the following defined terms, these definitions shall be applied, unless a different definition is given in the claims or elsewhere in this specification.

In the context of the present specification the term "different" or "differs" in connection with the matrix material means that the matrix material differs in their structural formula.

In the context of the present specification the term "different" or "differs" in connection with the lithium compound means that the lithium compound differs in their structural formula.

The external quantum efficiency, also named EQE, is measured in percent (%).

The lifetime, also named LT, between starting brightness and 97 % of the original brightness is measured in hours (h).

The voltage, also named V, is measured in Volt (V) at 10 milliAmpere per square centimeter (mA/cm²) in bottom emission devices and at 15 mA/cm² in top emission devices.

The color space is described by coordinates CIE-x and CIE-y (International Commission on Illumination 1931). For blue emission the CIE-y is of particular importance. A smaller CIE-y denotes a deeper blue color.

The highest occupied molecular orbital, also named HOMO, and lowest unoccupied molecular orbital, also named LUMO, are measured in electron volt (eV).

The term "OLED" and "organic light-emitting diode" is simultaneously used and having the same meaning.

The term "electron transport layer stack" as used in the specification comprises at least two electron transport layers or at least three electron transport layers.

The term "different compound" as used in connection with the matrix compound means that the matrix compound differs from the other matrix compound in its chemical formula.

As used herein, "weight percent", "wt.-%", "percent by weight", "% by weight", and variations thereof refer to a composition, component, substance or agent as the weight of that component, substance or agent of the respective electron transport layer divided by the total weight of the respective electron transport layer thereof and multiplied by 100. It is understood that the total weight percent amount of all components, substances and agents of the respective electron transport layer are selected such that it does not exceed 100 wt.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention.

The term "alkyl" as used herein shall encompass linear as well as branched alkyl. For example, C₃-alkyl may be selected from n-propyl and iso-propyl. Likewise, C₄-alkyl encompasses n-butyl, sec-butyl and t-butyl.

The term "alkoxy" as used herein shall encompass linear and branched alkoxy. For example, C₃-alkoxy encompasses n-propoxy and iso-propoxy.

The subscripted number n in Cₙ relates to the total number of carbon atoms in the respective alkyl, alkoxy, aryl or heteroaryl group.

With respect to the groups R¹ to R⁷, short alkyl and alkoxy chains (C₁ to C₄) are preferred for deposition in high vacuum. Longer alkyl chains (C₄ to C₁₆) are preferred for solution processing. Typically, a total number of 1 to 3 long alkyl chains is sufficient to achieve the desired properties for solution processing.

If Ar¹ and Ar² are linked via a methylene (-CR⁸R⁹-) moiety to form a fluorene structure, R⁸ and R⁹ are preferably independently selected from C₁-C₁₆ alkyl and C₁-C₁₆ alkoxy and C₆-C₂₀ aryl. Short alkyl and alkoxy chains (C₁ to C₄) are preferred for deposition in high vacuum. Longer alkyl chains (C₄ to C₁₆) are preferred for solution processing. Typically, a total number of 1 to 2 long alkyl chains is sufficient to achieve the desired properties for solution processing.

The term "aryl" as used herewith shall encompass phenyl (C₆-aryl), fused aromatics, such as naphthalene, anthracene, phenanthrene, tetracene etc. Further encompassed are biphenyl and oligo- or polyphenyls, such as terphenyl etc. Further encompassed shall be any further aromatic hydrocarbon substituents, such as fluorenyl etc.

Depending from the number of groups attached to the aryl moiety, the term aryl as used herein may be synonymous to the term arylene. For example, in case of Ar¹ being C₆ to C₂₀ aryl, it is clear from the two moieties (B and Ar²) attached to Ar¹ that aryl is arylene in this case.

In case of the aryl group being substituted, the aryl group may comprise one or more substituents.

In the formula representing the methylene- and the oxy- moiety "-" is for the chemical bond to the adjacent moiety.

In case of Ar² being substituted with fluorenyl, it may be preferred to substitute the 9-position thereof to stabilize the respective compound. Likewise, if anthranyl is chosen in this regard as a substituent of Ar², it may be preferred that the anthranyl compound is substituted in 9- and/ or 10-position.

It may be further preferred that the organic electroluminescent device comprises an emission layer and the emission layer comprises the compound of formula (I) as defined above. Preferably, the semiconductive layer comprising a compound of formula (I) further comprises a dopant of an emitter. The emitter may be a fluorescent or phosphorescent or TADF emitter (TADF =thermally activated delayed fluorescence). The emitter may emit light in the blue, green or red region of the visible spectrum.

The dopant may be a phosphorescent or fluorescent emitter. Phosphorescent emitters are preferred due to their higher efficiency
Examples of a red dopant which may be used together with the inventive compound (I) are PtOEP, Ir(piq) 3, and Btp 21r(acac), but are not limited thereto. These compounds are phosphorescent emitters, however, fluorescent red dopants could also be used.

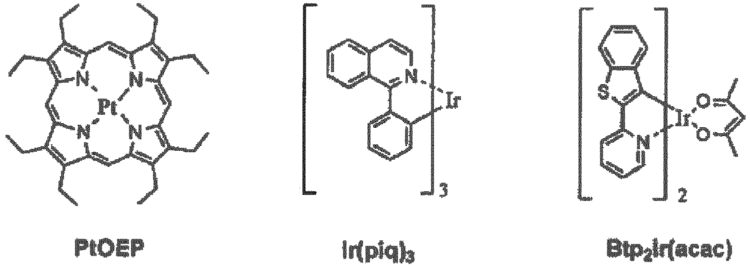

Examples of a phosphorescent green dopant which may be used together with the inventive compound (I) are Ir(ppy) 3 (ppy = phenylpyridine), Ir(ppy) 2(acac), Ir(mpyp) 3 are shown below. Compound 3 is an example of a fluorescent green emitter and the structure is shown below.

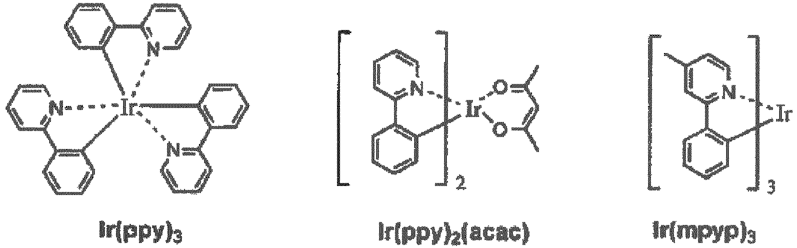

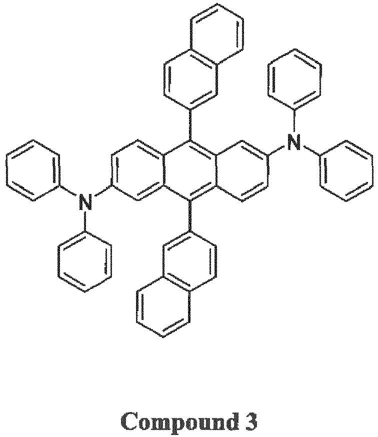

Examples of a phosphorescent blue dopant which may be used together with the inventive compound (I) are F₂Irpic, (F₂ppy) ₂Ir(tmd) and Ir(dfppz) 3, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue dopants which may be used together with the inventive compound (I).

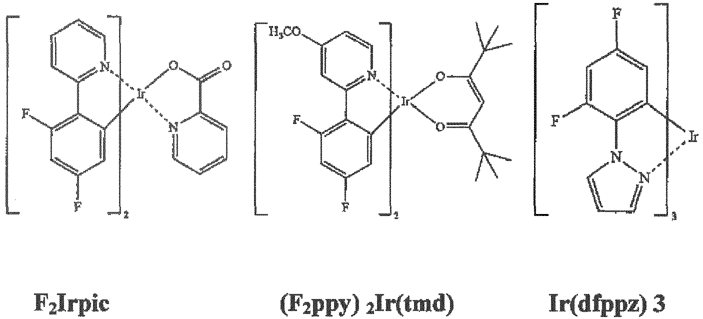

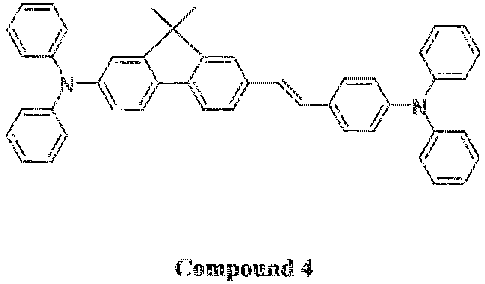

The amount of the dopant may be in the range of about 0.01 to about 50 parts by weight, based on 100 parts by weight of the host. The EML may have a thickness of about 10 nm to about 100 nm, for example, about 20 nm to about 60 nm. When the thickness of the EML is within this range, the EML may have excellent light emission, without a substantial increase in driving voltage.

In a further preferred embodiment, the organic electroluminescent device further comprises an emission layer and a cathode, wherein the semiconductive layer comprising the compound of formula (I) is arranged between the emission layer and the cathode electrode, wherein the semiconductive layer is an electron transport layer.

Likewise, it may be preferred that the organic electroluminescent device further comprises an emission layer and a cathode electrode, wherein the semiconductive layer comprising the compound of formula (I) is arranged between the emission layer and the cathode electrode, wherein the semiconductive layer is a hole blocking layer.

Preferably, the organic electroluminescent device further comprises an electron injection layer, wherein the semiconductive layer comprising the compound for formula (I) is arranged between the emission layer and the electron injection layer.

It may be further preferred that the organic electroluminescent device comprises an electron injection layer, the electron injection layer comprising the compound of formula (I).

According to another aspect, the organic electroluminescent device comprises at least two electron transport layers and at least one electron injection layer.

In a further preferred embodiment, the organic electroluminescent device further comprises an emission layer and a cathode electrode, wherein the semiconductive layer comprising the compound of formula (I) is arranged between the emission layer and the cathode electrode, and wherein the semiconductive layer is an electron transport layer and is free of a dopant.

In a further preferred embodiment, the organic electroluminescent device further comprises an emission layer and a cathode electrode, wherein the semiconductive layer comprising the compound of formula (I) is arranged between the emission layer and the cathode electrode, and wherein the semiconductive layer is an electron transport layer and further comprises a dopant of a lithium halide and/or lithium organic complex, i.e. a lithium organic compound formed by at least one lithium ion and one or more suitable organic ligands coordinated to the lithium ion(s).

Suitable organic ligands to form a lithium organic complex that can be used for the electron transport layer are disclosed, and incorporated by reference, for example in US 2014/0048792 and Kathirgamanathan, Poopathy; Arkley, Vincent; Surendrakumar, Sivagnanasundram; Chan, Yun F.; Ravichandran, Seenivasagam; Ganeshamurugan, Subramaniam; Kumaraverl, Muttulingam; Antipan-Lara, Juan; Paramaswara, Gnanamolly; Reddy, Vanga R., Digest of Technical Papers - Society for Information Display International Symposium (2010), 41(Bk. 1), 465-468.

Particularly preferred lithium organic complexes are shown in Table 1.

**Table 1**

| Lithium organic complex that can be suitable used for the ETL-and/or EIL-layer | | | |
|---|---|---|---|
| Compound | Name | Structure | Reference |
| LiQ | lithium 8-hydroxyquinolate | 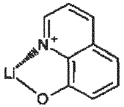 | WO 2013079217 A1 |
| Li-1 | lithium tetra(1H-pyrazol-1-yl)borate | 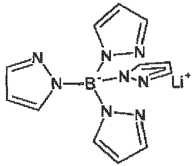 | WO 2013079676 A1 |
| Li-2 | lithium 2-(diphenylphosphoryl)phenolate | 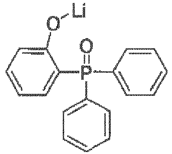 | WO 2013079678A1 |
| Li-3 | lithium 2-(pyridin-2-yl)phenolate | 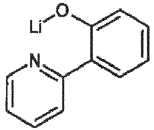 | JP 2008195623 |
| Li-4 | lithium 2-(1-phenyl-1H-benzo[d]imidazol-2-yl)phenolate | 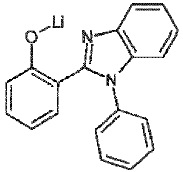 | JP 2001291593, |
| Li-5 | lithium 2-(benzo[d]oxazol-2-yl)phenolate | 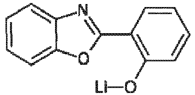 | US 20030165711 |
| Li-6 | lithium 2-(diphenylphosphoryl)pyridin-3-olate | 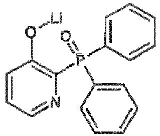 | EP 2724388 |

The organic ligand of the lithium organic complex of the electron transport layer may be selected from the group comprising a quinolate, a borate, a phenolate, a pyridinolate or a Schiff base ligand, or Table 1;
- preferably the lithium quinolate complex has the formula III: 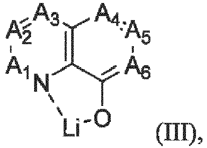 wherein
   A₁ to A₆ are same or independently selected from CH, CR, N, O;
   R is same or independently selected from hydrogen, halogen, alkyl or aryl or heteroaryl with 1 to 20 carbon atoms; and more preferred A₁ to A₆ are CH;
- preferably the borate based organic ligand is a tetra(1H-pyrazol-1-yl)borate;
- preferably the phenolate is a 2-(pyridin-2-yl)phenolate or a 2-(diphenylphosphoryl)phenolate;
- preferably the lithium Schiff base has the structure 100, 101, 102 or 103: 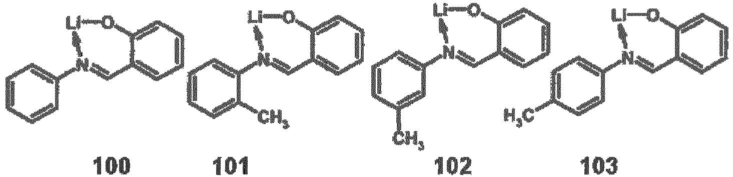
- more preferred the lithium organic complex is selected from a compound of Table 1.

The lithium halide of the electron transport layer may be selected from the group comprising a LiF, LiCl, LiBr or LiJ, and preferably LiF.

When the semiconductive layer comprising a compound of formula (I) is an electron transport layer or electron injection layer and further comprises a dopant selected from a Li-organic complex and/or of a Li-halide, particularly low operating voltage and high efficiency are obtained.

In a further preferred embodiment, the organic electroluminescent device further comprises an emission layer and a cathode, wherein the semiconductive layer comprising the compound of formula (I) is arranged between the emission layer and the cathode electrode, wherein the semiconductive layer is an electron transport layer and further comprises a dopant of a metal in its elemental form, and wherein the metal is selected from an alkali, alkaline earth or rare earth metal.

Preferably, the metal dopant is selected from Li, Na, K, Rb, Cs, Mg, Ca, Sr, Ba, Yb, Sm, Y, Eu, even more preferred the metal dopant is selected from Li, Na, K, Cs, Mg, Ca, Ba, Yb. When the semiconductive layer comprising a compound of formula (I) is an electron transport layer or electron injection layer and further comprises a metal dopant, particularly low operating voltage and high efficiency are obtained.

According to another aspect, the organic electroluminescent device comprises a charge generation layer (CGL).

Preferably, the organic electroluminescent device is a fluorescent blue device. In this regard, it may be preferred that the organic electroluminescent device is a fluorescent blue OLED.

A fluorescent blue OLED may comprise a semiconductive matrix compound and a fluorescent blue emitter dopant.

Example of the semiconductive matrix compound are Alq3, 4,4'-N,N'-dicarbazole-biphenyl (CBP), poly(n-vinylcarbazole) (PVK), 9,10-di(naphthalene-2-yl)anthracene (ADN), 4,4',4"-Tris(carbazol-9-yl)-triphenylamine (TCTA), 1,3,5-tris(N-phenylbenzimidazole-2-yl)benzene (TPBI), 3-tert-butyl-9,10-di-2-naphthylanthracenee (TBADN), distyrylarylene (DSA), Bis(2-(2-hydroxyphenyl)benzothiazolate)zinc (Zn(BTZ) 2), E3 below, AND, Compound 1 below, and Compound 2 below.

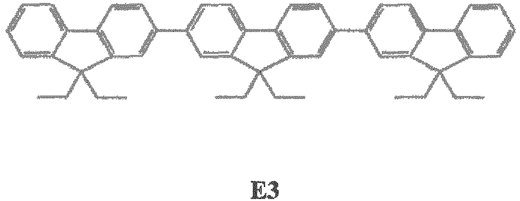

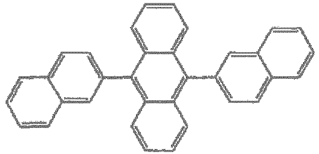

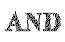

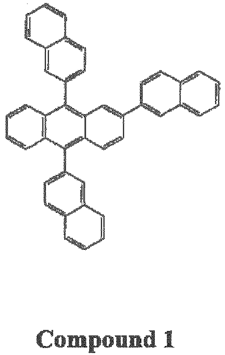

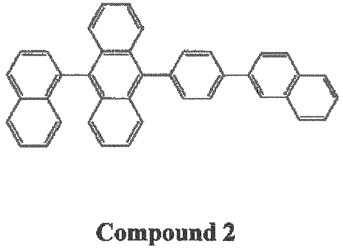

The reduction potential of compounds of formula (I) is particularly well-matched to the reduction potential of the fluorescent blue emission layer; thereby electrons are transported into the emission layer at such a rate as to enable low operating voltage, high external quantum efficiency (EQE) and/or lifetime.

When using the organic electroluminescent device in one of the before discussed arrangements, the best results with respect to voltage, external quantum efficiency and/or lifetime are achieved.

Preferably, Ar² is selected from the group consisting of phenyl, naphthyl, anthranyl, phenanthryl, pyrenyl, 9-fluorenyl, 2-fluorenyl, 3-fluorenyl, 4-fluorenyl, 5-fluorenyl and formula (IIa) to (IIh).

A further preferred selection for Ar² is unsubstituted aryl, non-fluorenyl aryl, aryl substituted with one or more of the compounds according to formula (IIa) to (IIh), or fluorenyl substituted with one or more of the substituents according to formula (IIa) to (IIh).

By choosing Ar² respectively, in particularly well-performing organic electroluminescent devices were prepared.

Even preferred, R¹ is C₁-C₁₂ alkyl, preferably methyl, or C₁-C₁₂ alkoxy, preferably methoxy, and R² to R⁷ are each H.

By the respective specific selection of R¹ and R² to R⁷, compounds were achieved featuring best performances with respect to voltage and/or quantum efficiency and/or lifetime.

It may be further preferred that Ar¹ is phenyl, biphenyl, naphthyl, phenanthryl or anthranyl.

Furthermore, it may be preferred that 5-fluorenyl is excluded from the possible selection of Ar¹.

By choosing Ar¹ respectively, the inventors found out that organic electroluminescent devices having best performance with respect to voltage and/or EQE were achieved.

Superior results were achieved when combining the respective Ar¹, Ar² and R¹ to R⁷ groups.

Extraordinary good performing organic electroluminescent devices were achieved by selecting the compound of formula (I) from

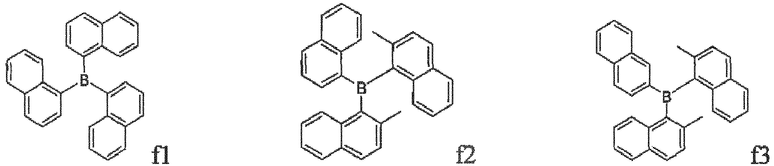

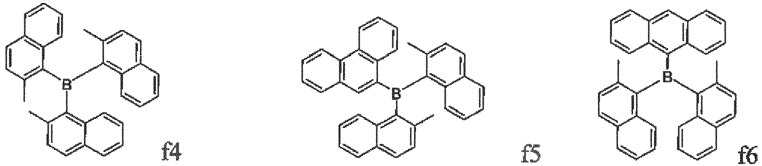

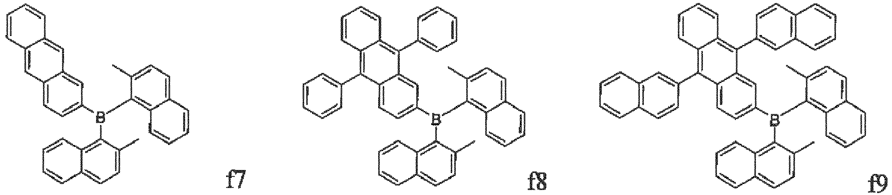

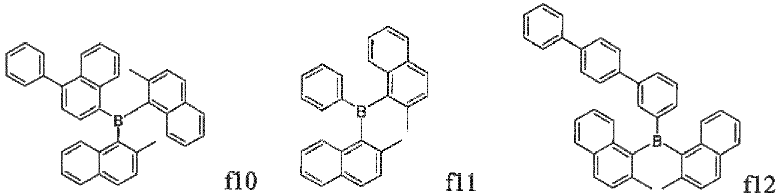

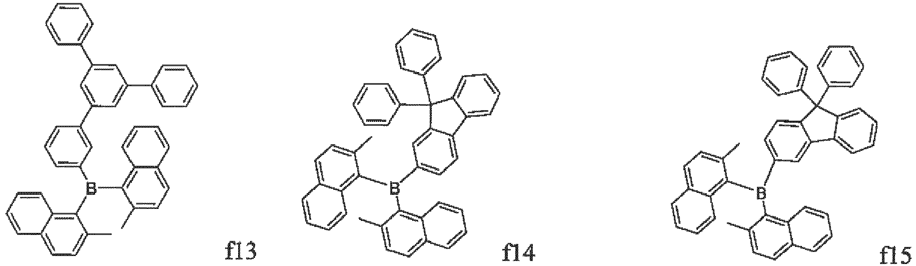

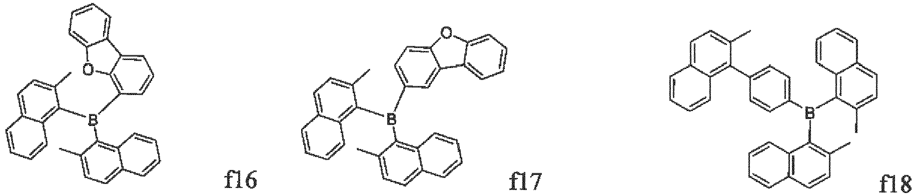

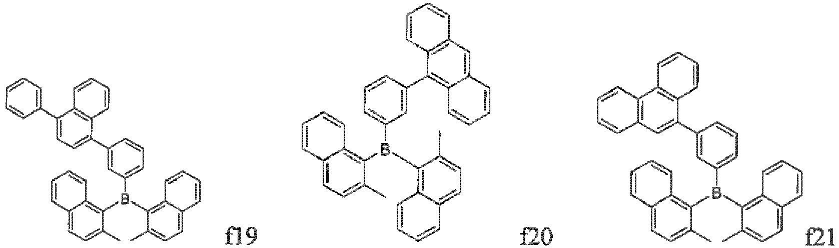

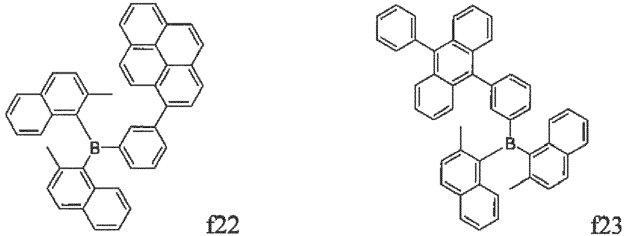

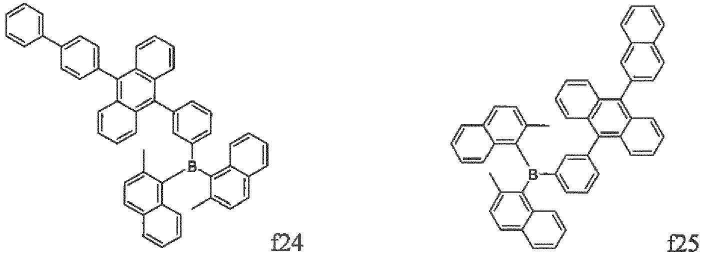

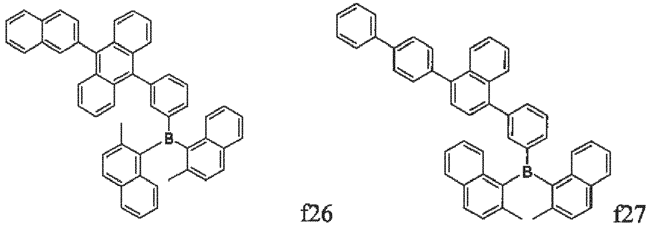

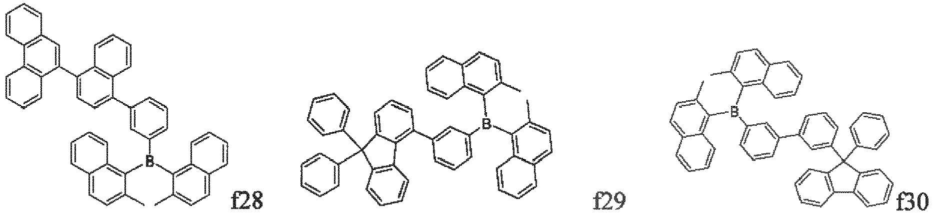

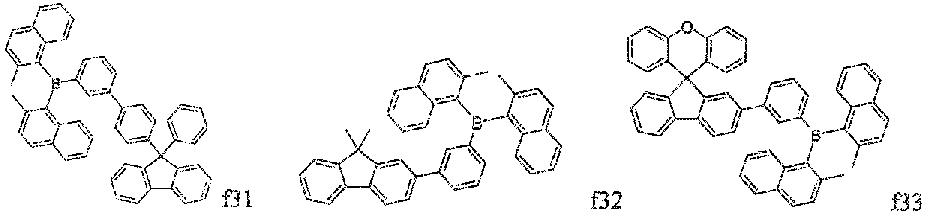

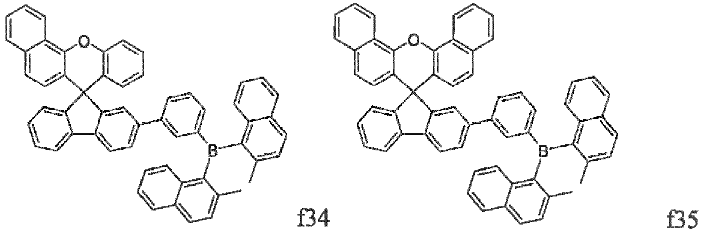

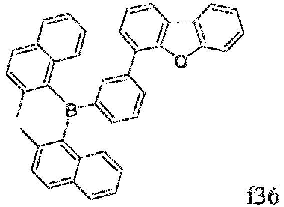

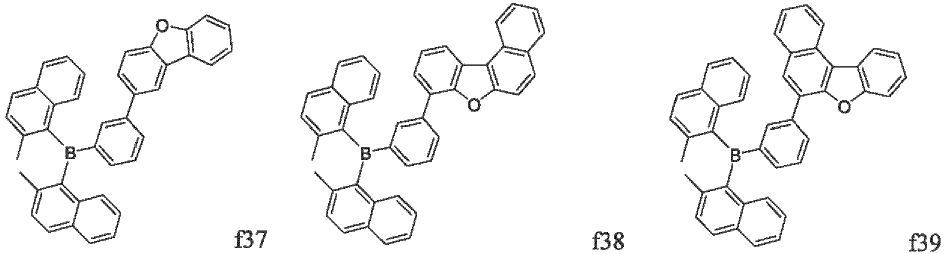

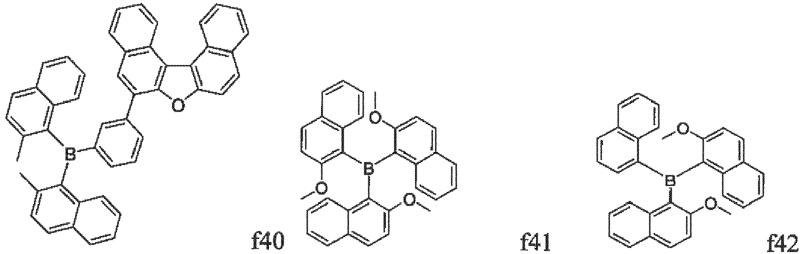

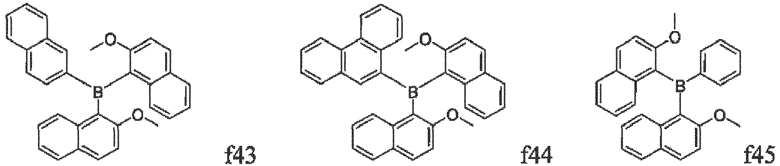

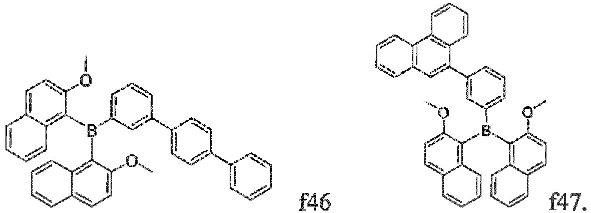

The before mentioned organic luminescent devices may comprise one or more of the following components, selected from substrate, anode electrode, hole injection layer, emission layer, hole blocking layer, electron transport layer, electron injection layer, and cathode electrode as defined below.

### Substrate

The substrate may be any substrate that is commonly used in manufacturing of organic light-emitting diodes. If light is emitted through the substrate, the substrate may be a transparent material, for example a glass substrate or a transparent plastic substrate, having excellent mechanical strength, thermal stability, transparency, surface smoothness, ease of handling, and waterproofness. If light is emitted through the top surface, the substrate may be a transparent or non-transparent material, for example a glass substrate, a plastic substrate, a metal substrate or a silicon substrate.

### Anode electrode

The anode electrode may be formed by depositing or sputtering a compound that is used to form the anode electrode. The compound used to form the anode electrode may be a high work-function compound, so as to facilitate hole injection. The anode material may also be selected from a low work function material (i.e. Aluminum).The anode electrode may be a transparent or reflective electrode. Transparent conductive compounds, such as indium tin oxide (ITO), indium zinc oxide (IZO), tin-dioxide (SnO₂), and zinc oxide (ZnO), may be used to form the anode electrode 120. The anode electrode 120 may also be formed using magnesium (Mg), aluminum (Al), aluminum-lithium (Al-Li), calcium (Ca), magnesium-indium (Mg-In), magnesium-silver (Mg-Ag), silver (Ag), gold (Au), or the like.

### Hole injection layer

The hole injection layer (HIL) 130 may be formed on the anode electrode 120 by vacuum deposition, spin coating, printing, casting, slot-die coating, Langmuir-Blodgett (LB) deposition, or the like. When the HIL 130 is formed using vacuum deposition, the deposition conditions may vary according to the compound that is used to form the HIL 130, and the desired structure and thermal properties of the HIL 130. In general, however, conditions for vacuum deposition may include a deposition temperature of 100°C to 500°C, a pressure of 10⁻⁸ to 10⁻³ Torr (1 Torr equals 133.322 Pa), and a deposition rate of 0.1 to 10 nm/sec.

When the HIL 130 is formed using spin coating, printing, coating conditions may vary according to a compound that is used to form the HIL 130, and the desired structure and thermal properties of the HIL 130. For example, the coating conditions may include a coating speed of about 2000 rpm to about 5000 rpm, and a thermal treatment temperature of about 80° C to about 200°C. Thermal treatment removes a solvent after the coating is performed.

The HIL 130 may be formed of any compound that is commonly used to form an HIL. Examples of compounds that may be used to form the HIL 130 include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL 130 may be a pure layer of p-dopant or may be selected from a hole-transporting matrix compound doped with a p-dopant. Typical examples of known redox doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile (PD1). α-NPD doped with 2,2',2"-(cyclopropane-1,2,3-triylidene)tris(2-(p-cyanotetrafluorophenyl)acetonitrile) (PD2). Dopant concentrations can be selected from 1 to 20 wt.-%, more preferably from 3 wt.-% to 10 wt.-%.

The thickness of the HIL 130 may be in the range of about 1 nm to about 100 nm, and for example, about 1 nm to about 25 nm. When the thickness of the HIL 130 is within this range, the HIL 130 may have excellent hole injecting characteristics, without a substantial increase in driving voltage.

### Hole transport layer

The hole transport layer (HTL) 140 may be formed on the HIL 130 by vacuum deposition, spin coating, slot-die coating, printing, casting, Langmuir-Blodgett (LB) deposition, or the like. When the HTL 140 is formed by vacuum deposition or spin coating, the conditions for deposition and coating may be similar to those for the formation of the HIL 130. However, the conditions for the vacuum or solution deposition may vary, according to the compound that is used to form the HTL 140.

The HTL 140 may be formed of any compound that is commonly used to form a HTL. Compound that can be suitably used is disclosed for example in Yasuhiko Shirota and Hiroshi Kageyama, Chem. Rev. 2007, 107, 953-1010 and incorporated by reference. Examples of the compound that may be used to form the HTL 140 are: a carbazole derivative, such as N-phenylcarbazole or polyvinylcarbazole; an amine derivative having an aromatic condensation ring, such as N,N'-bis(3-methylphenyl)-N,N'-diphenyl-[1,1-biphenyl]-4,4'-diamine (TPD), or N,N'-di(naphthalen-1-yl)-N,N'-diphenyl benzydine (alpha -NPD); and a triphenylamine-based compound, such as 4,4',4"-tris(N-carbazolyl)triphenylamine (TCTA). Among these compounds, TCTA can transport holes and inhibit excitons from being diffused into the EML.

The thickness of the HTL 140 may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL 140 may be 170 nm to 200 nm.

When the thickness of the HTL 140 is within this range, the HTL 140 may have excellent hole transporting characteristics, without a substantial increase in driving voltage.

### Emission layer (EML)

The EML may be formed on the HTL by vacuum deposition, spin coating, slot-die coating, printing, casting, LB, or the like. When the EML is formed using vacuum deposition or spin coating, the conditions for deposition and coating may be similar to those for the formation of the HIL. However, the conditions for deposition and coating may vary, according to the compound that is used to form the EML.
The emission layer (EML) may be formed of a combination of a host and a dopant. Example of the host are Alq3, 4,4'-N,N'- dicarbazole-biphenyl (CBP), poly(n-vinylcarbazole) (PVK), 9,10-di(naphthalene-2-yl)anthracene (ADN), 4,4',4"-Tris(carbazol-9-yl)-triphenylamine
(TCTA), 1,3,5-tris(N-phenylbenzimidazole-2-yl)benzene (TPBI), 3-tert-butyl-9,10-di-2-naphthylanthracenee (TBADN), distyrylarylene (DSA), Bis(2-(2-hydroxyphenyl)benzo-thiazolate)zinc (Zn(BTZ) 2), E3 below, AND, Compound 1 below, and Compound 2 below.

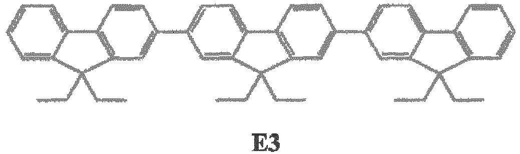

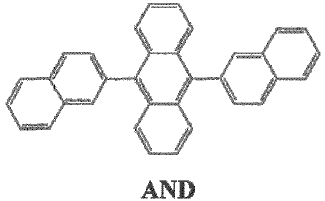

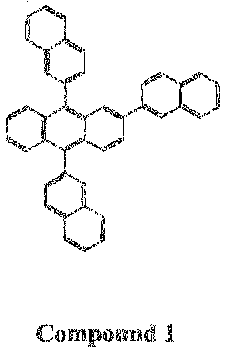

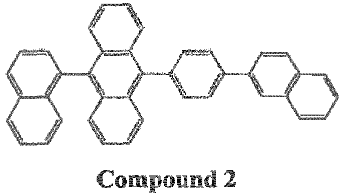

The dopant may be a phosphorescent or fluorescent emitter. Phosphorescent emitters are preferred due to their higher efficiency

Examples of a red dopant are PtOEP, Ir(piq) 3, and Btp 21r(acac), but are not limited thereto. These compounds are phosphorescent emitters, however, fluorescent red dopants could also be used.

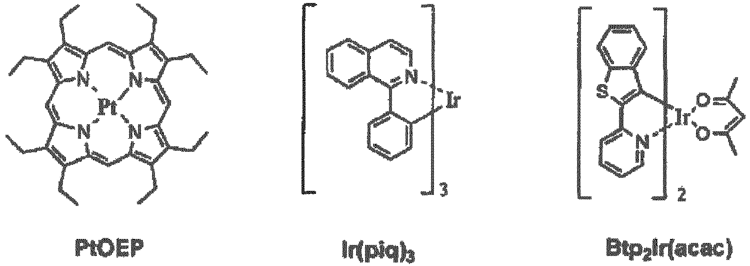

Examples of a phosphorescent green dopant are Ir(ppy) 3 (ppy = phenylpyridine), Ir(ppy) 2(acac), Ir(mpyp) 3 are shown below. Compound 3 is an example of a fluorescent green emitter and the structure is shown below.

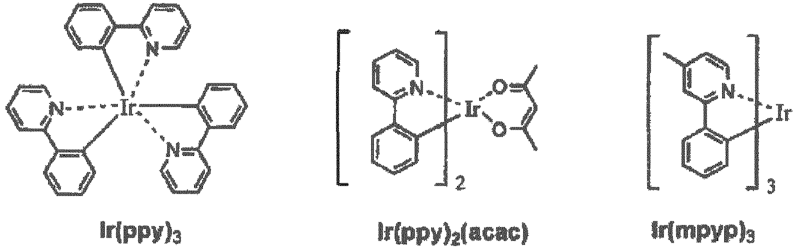

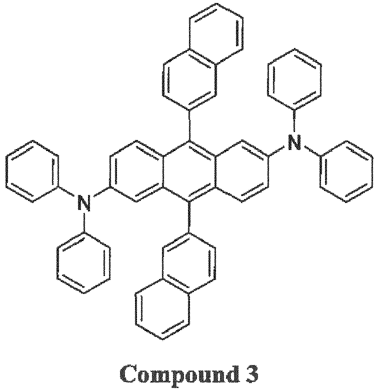

Examples of a phosphorescent blue dopant are F₂Irpic, (F₂ppy) ₂Ir(tmd) and Ir(dfppz) 3, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue dopants.

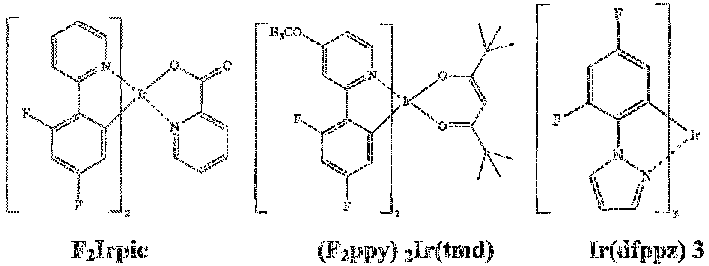

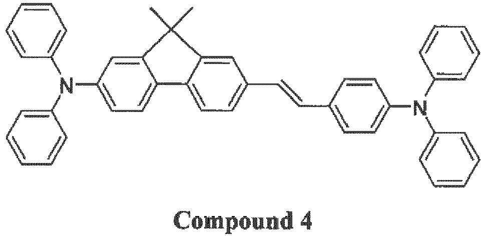

The amount of the dopant may be in the range of about 0.01 to about 50 parts by weight, based on 100 parts by weight of the host. The EML may have a thickness of about 10 nm to about 100 nm, for example, about 20 nm to about 60 nm. When the thickness of the EML is within this range, the EML may have excellent light emission, without a substantial increase in driving voltage.

### Hole blocking layer (HBL)

When the EML comprises a phosphorescent dopant, a hole blocking layer (HBL) may be formed on the EML, by using vacuum deposition, spin coating, slot-die coating, printing, casting, LB deposition, or the like, in order to prevent the diffusion of triplet excitons or holes into the ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include an oxadiazole derivative, a triazole derivative, and a phenanthroline derivative.

The HBL may have a thickness of about 5 nm to about 100 nm, for example, about 10 nm to about 30 nm. When the thickness of the HBL is within this range, the HBL may have excellent hole-blocking properties, without a substantial increase in driving voltage.

### Compounds used in the electron transport layer (ETL)

The OLED according to the present invention may not contain an electron transport layer (ETL). However, the OLED according to the present invention may optional contain an electron transport layer (ETL).

According to various embodiments the OLED may comprises an electron transport layer or an electron transport layer stack comprising at least a first electron transport layer and at least a second electron transport layer.

According to various embodiments of the OLED of the present invention the electron transport layer may comprises at least one matrix compound.

According to various embodiments of the OLED the matrix compound may be selected from:
- an anthracene based compound or a heteroaryl substituted anthracene based compound, preferably 2-(4-(9,10-di(naphthalen-2-yl)anthracene-2-yl)phenyl)-1-phenyl-1H-benzo[d]imidazole and/or N4,N4"-di(naphthalen-1-yl)-N4,N4"-diphenyl-[1,1':4',1"-terphenyl]-4,4"-diamine;
- a phosphine oxide based compound, preferably (3-(dibenzo[c,h]acridin-7-yl)phenyl)diphenylphosphine oxide and/or phenyl bis(3-(pyren-1-yl)phenyl)phosphine oxide and/or 3-Phenyl-3H-benzo[b]dinaphtho[2,1-d:1',2'-f]phosphepine-3-oxide; or
- a substituted phenanthroline compound, preferably 2,4,7,9-tetraphenyl-1,10-phenanthroline, 4,7-diphenyl-2,9-di-p-tolyl-1,10-phenanthroline, or 2,9-di(biphenyl-4-yl)-4,7-diphenyl-1,10-phenanthroline.

According to various embodiments of the OLED the matrix compound of the electron transport layer may be preferably selected from:
- a phosphine oxide based compound, preferably (3-(dibenzo[c,h]acridin-7-yl)phenyl)diphenylphosphine oxide, 3-phenyl-3H-benzo[b]dinaphtho[2,1-d:1',2'-f]phosphepine-3-oxide and/or phenyl bis(3-(pyren-1-yl)phenyl)phosphine oxide; or
- a substituted phenanthroline compound, preferably 2,4,7,9-tetraphenyl-1,10-phenanthroline, 4,7-diphenyl-2,9-di-p-tolyl-1,10-phenanthroline, or 2,9-di(biphenyl-4-yl)-4,7-diphenyl-1,10-phenanthroline.

According to various embodiments of the OLED the matrix compound of the electron transport layer may be more preferred selected from:
- a phosphine oxide based compound, preferably (3-(dibenzo[c,h]acridin-7-yl)phenyl)diphenylphosphine oxide, 3-phenyl-3H-benzo[b]dinaphtho[2,1-d:1',2'-f]phosphepine-3-oxide and/or phenyl bis(3-(pyren-1-yl)phenyl)phosphine oxide.

According to various embodiments of the OLED of the present invention the thicknesses of the electron transport layer may be in the range of about ≥ 0.5 nm to about ≤ 95 nm, preferably of about ≥ 3 nm to about ≤ 80 nm, further preferred of about ≥ 5 nm to about ≤ 60 nm, also preferred of about ≥ 6 nm to about ≤ 40 nm, in addition preferred about ≥ 8 nm to about ≤ 20 nm and more preferred of about ≥10 nm to about ≤ 18 nm.

According to various embodiments of the OLED of the present invention the thicknesses of the electron transport layer stack can be in the range of about ≥ 25 nm to about ≤ 100 nm, preferably of about ≥ 30 nm to about ≤ 80 nm, further preferred of about ≥ 35 nm to about ≤ 60 nm, and more preferred of about ≥ 36 nm to about ≤ 40 nm.

According to various embodiments of the OLED of the present invention the electron transport layer may comprises:
a) about ≥ 10 wt.-% to about ≤ 70 wt.-%, preferably about ≥ 20 wt.-% to about ≤ 65 wt.-% and also preferred about ≥ 50 wt.-% to about ≤ 60 wt.-% of a lithium halide or an lithium organic complex of a lithium quinolate, a lithium borate, a lithium phenolate and/or a lithium Schiff base, preferably of a lithium quinolate complex has the formula III, IV or V: 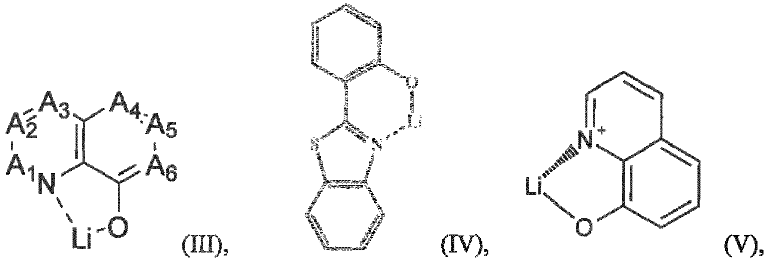 wherein
   - A1 to A6 are same or independently selected from CH, CR, N, O,
   - R is same or independently selected from hydrogen, halogen, alkyl or aryl or heteroaryl with 1 to 20 carbon atoms, and more preferred of a lithium 8-hydroxyquinolate;
b) about ≤ 90 wt.-% to about ≥ 30 wt.-%, preferably about ≤ 80 wt.-% to about ≥ 35 wt.-% and also preferred about ≤ 50 wt.-% to about ≥ 40 wt.-% of a matrix compound of:
   - an anthracene based compound or a hetero substituted anthracene based compound, preferably 2-(4-(9,10-di(naphthalen-2-yl)anthracene-2-yl)phenyl)-1-phenyl-1H-benzo[d]imidazole and/or N4,N4"-di(naphthalen-1-yl)-N4,N4"-diphenyl-[1,1':4',1"-terphenyl]-4,4"-diamine; or
   - a phosphine oxide based compound, preferably (3-(dibenzo[c,h]acridin-7-yl)phenyl)diphenylphosphine oxide and/or phenyl bis(3-(pyren-1-yl)phenyl)phosphine oxide and/or 3-Phenyl-3H-benzo[b]dinaphtho[2,1-d:1',2'-f]phosphepine-3-oxide; or
   - a substituted phenanthroline compound, preferably 2,4,7,9-tetraphenyl-1,10-phenanthroline, 4,7-diphenyl-2,9-di-p-tolyl-1,10-phenanthroline, or 2,9-di(biphenyl-4-yl)-4,7-diphenyl-1,10-phenanthroline; whereby
   more preferred is a phosphine oxide based compound and most preferred is (3-(dibenzo[c,h]acridin-7-yl)phenyl)diphenylphosphine oxide;
based on the total weight of the electron transport layer.

According to one embodiment of the OLED, the electron transport layer comprises of about ≥ 50 wt.-% to about ≤ 60 wt.-% of a first lithium halide or a first lithium organic complex and about ≤ 50 wt.-% to about ≥ 40 wt.-% of a matrix compound of:
- a phosphine oxide based compound, preferably (3-(dibenzo[c,h]acridin-7-yl)phenyl)diphenylphosphine oxide, 3-phenyl-3H-benzo[b]dinaphtho[2,1-d:1',2'-f]phosphepine-3-oxide and/or phenyl bis(3-(pyren-1-yl)phenyl)phosphine oxide; or
- a substituted phenanthroline compound, preferably 2,4,7,9-tetraphenyl-1,10-phenanthroline, 4,7-diphenyl-2,9-di-p-tolyl-1,10-phenanthroline, or 2,9-di(biphenyl-4-yl)-4,7-diphenyl-1,10-phenanthroline.

The light-emitting diode (OLED) may comprises at least two electrodes, an anode electrode and a second cathode electrode.

The electron transport layer/s or electron transport layer stack is not an electrode. The electron transport layer/s or electron transport layer are sandwiched between two electrodes, namely sandwiched between an anode and a second cathode.

The ETL may be formed optional on an EML or on the HBL if the HBL is formed. The ETL includes a first layer including a first lithium halide or a first lithium organic complex; and optional a second electron transport layer including a second lithium halide or a second lithium organic complex, wherein optional the first lithium organic complex is not the same as the second lithium organic complex and wherein the first lithium halide is not the same as the second lithium halide.

The ETL includes a first layer comprising a first matrix compound and a lithium halide or a lithium organic complex; and optional a second electron transport layer comprising a second matrix compound and a metal dopant selected from a group comprising alkali, alkaline earth and rare earth metals.

The ETL includes a first layer comprising a first matrix compound and a lithium halide or a lithium organic complex; and optional a second electron transport layer comprising a second matrix compound and is free of dopant.

The ETL may have a stacked structure, preferably of two ETL-layers, so that injection and transport of electrons may be balanced and holes may be efficiently blocked. In a conventional OLED, since the amounts of electrons and holes vary with time, after driving is initiated, the number of excitons generated in an emission area may be reduced. As a result, a carrier balance may not be maintained, so as to reduce the lifetime of the OLED.

However, in the ETL, the first layer and the second layer may have similar or identical energy levels, so that the carrier balance may be uniformly maintained, while controlling the electron-transfer rate.

Matrix compound for the electron layer that can be suitable used are selected from the group comprising anthracen compounds, preferably 2-(4-(9,10-di(naphthalen-2-yl)anthracen-2-yl)phenyl)-1-phenyl-1H-benzo[d]imidazole
Anthracene compounds that can be used as matrix materials are disclosed in US 6878469 B and incorporated by reference.

Other matrix compounds that can be used are diphenylphosphine oxide,preferably (3-(dibenzo[c,h]acridin-7-yl)phenyl)diphenylphosphine oxide, phenylbis(3-(pyren-1-yl)phenyl)phosphine oxide, 3-phenyl-3H-benzo[b]dinaphtho[2,1-d:1',2'-f]phosphepine-3-oxide, phenyldi(pyren-1-yl)phosphine oxide.

Diphenylphosphine oxide compounds that can be used as matrix materials are disclosed in EP 2395571 A1, WO2013079217 A1, EP 13187905, EP13199361 and JP2002063989 A1, incorporated by reference.

Other suitable matrix compounds that can be used are phenanthroline compounds, preferably selected from the group comprising of 2,4,7,9-tetraphenyl-1,10-phenanthroline, 4,7-diphenyl-2,9-di-p-tolyl-1,10-phenanthroline, and 2,9-di(biphenyl-4-yl)-4,7-diphenyl-1,10-phenanthroline. Phenanthroline compounds that can be used as matrix materials are disclosed in EP 1786050 A1 and incorporated by reference.

The matrix compound of the electron transport layer may be a compound that efficiently transports electrons, such as an anthracene-based compound, diphenylphosphine oxide based compound, or a phenanthroline based compound, preferably a matrix compound mentioned in Table 4. For example, the matrix compound of the electron transport layer may be selected from the group consisting of Compound 5, a compound represented by Formula 2, and a compound represented by Formula 3 below:

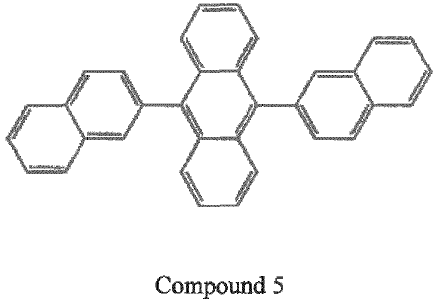

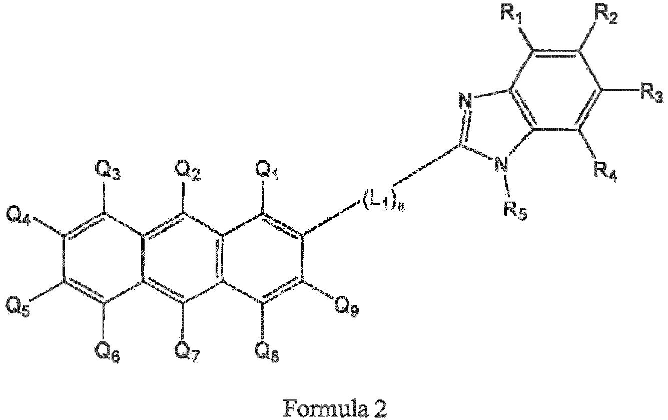

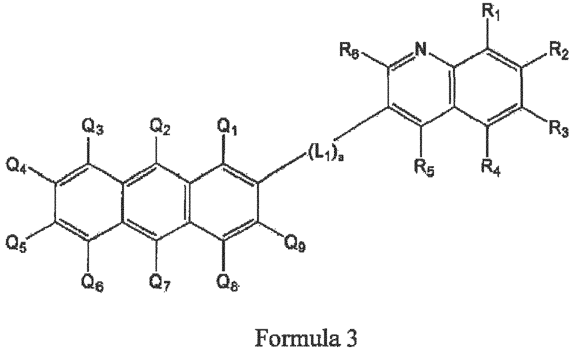

In Formulae 2 and 3, R₁ to R₆ are each independently a hydrogen atom, a halogen atom, a hydroxy group, a cyano group, a substituted or unsubstituted C₁-C₃₀ alkyl group, a substituted or unsubstituted C₁-C₃₀ alkoxy group, a substituted or unsubstituted C₁-C₃₀ acyl group, a substituted or unsubstituted C₂-C₃₀ alkenyl group, a substituted or unsubstituted C₂-C₃₀ alkynyl group, a substituted or unsubstituted C₆-C₃₀ aryl group, or a substituted or unsubstituted C₃-C₃₀ heteroaryl group. At least two adjacent R₁ to R₆ groups are optionally bonded to each other, to form a saturated or unsaturated ring. L₁ is a bond, a substituted or unsubstituted C₁-C₃₀ alkylene group, a substituted or unsubstituted C₆-C₃₀ arylene group, or a substituted or unsubstituted C₃-C₃₀ hetero arylene group. Q₁ through Q₉ are each independently a hydrogen atom, a substituted or unsubstituted C₆-C₃₀ aryl group, or a substituted or unsubstituted C₃-C₃₀ hetero aryl group, and "a" is an integer from 1 to 10.

For example, R₁ to R₆ may be each independently selected from the group consisting of a hydrogen atom, a halogen atom, a hydroxy group, a cyano group, a methyl group, an ethyl group, a propyl group, a butyl group, a methoxy group, an ethoxy group, a propoxy group, a butoxy group, a phenyl group, a naphthyl group, an anthryl group, a pyridinyl group, and a pyrazinyl group.

In particular, in Formula 2 and/or 3, R₁ to R₄ may each be a hydrogen atom, R₅ may be selected from the group consisting of a halogen atom, a hydroxy group, a cyano group, a methyl group, an ethyl group, a propyl group, a butyl group, a methoxy group, an ethoxy group, a propoxy group, a butoxy group, a phenyl group, a naphthyl group, an anthryl group, a pyridinyl group, and a pyrazinyl group. In addition, in Formula 3, R₁ to R₆ may each be a hydrogen atom.

For example, in Formula 2 and/or 3, Q₁ to Q₉ are each independently a hydrogen atom, a phenyl group, a naphthyl group, an anthryl group, a pyridinyl group, and a pyrazinyl group. In particular, in Formulae 2 and/or 3, Q₁, Q₃-Q₆, Q₈ and Q₉ are hydrogen atoms, and Q₂ and Q₇ may be each independently selected from the group consisting of a phenyl group, a naphthyl group, an anthryl group, a pyridinyl group, and a pyrazinyl group.

For example, L_{I}, in Formula 2 and/or 3, may be selected from the group consisting of a phenylene group, a naphthylene group, an anthrylene group, a pyridinylene group, and a pyrazinylene group. In particular, L₁ may be a phenylene group or a pyridinylene group. For example, "a" may be 1, 2, or, 3.

The matrix compound for the ETL-layer may be further selected from Compound 5, 6, or 7 below:

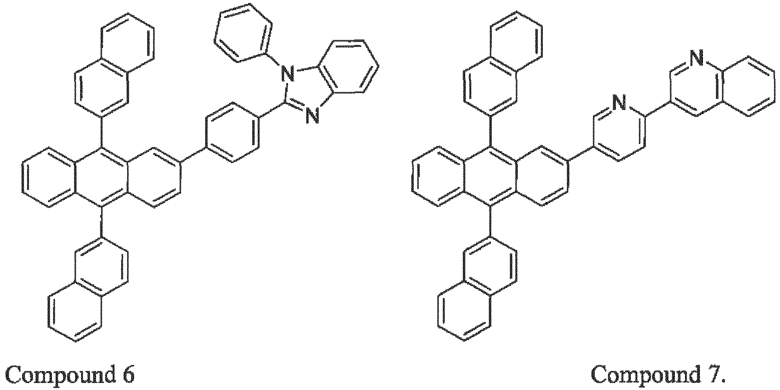

**Table 2**

| Chemical structures of matrix materials that can be suitable used for ETL- and /or EIL-layer | | | |
|---|---|---|---|
| Compound | Name | Structure | Reference |
| MX 1 | 2-(4-(9,10-di(naphthalen-2-yl)anthracen-2-yl)phenyl)-1-phenyl-1H-benzo[d]imidazole | 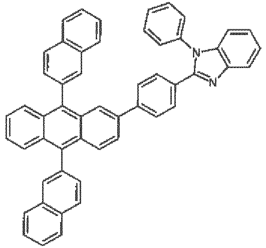 | US 6878469 B2. |
| MX 2 | (3-(dibenzo[c,h]acridin-7-yl)phenyl)diphenylphosphine oxide | 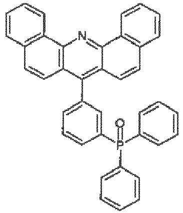 | EP 2395571B1, WO2013079217A1 |
| MX 3 | Phenylbis(3-(pyren-1-yl)phenyl)phosphine oxide | 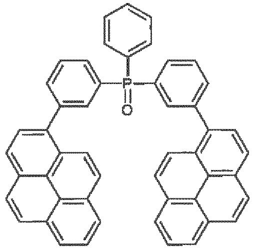 | EP13187905.8 |
| MX 4 | 3-Phenyl-3H-benzo[b] dinaphtho [2,1-d:1',2'-f]phosphepine-3-oxide | 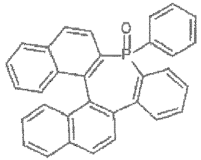 | EP13199361.0 |
| MX 5 | Phenyldi(pyren-1-yl)phosphine oxide | 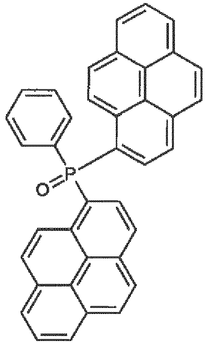 | JP4876333 |
| MX 6 | 2,4,7,9-tetraphenyl-1,10-phenanthroline | 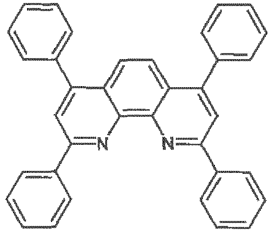 | EP1786050 |
| MX 8 | 2,9-di(biphenyl-4-yl)-4,7-diphenyl-1,10-phenanthroline | 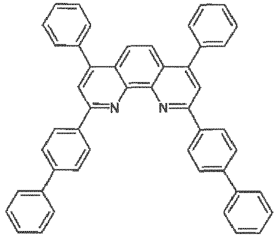 | EP1786050 |
| MX 9 | 4,7-diphenyl-2,9-di-p-tolyl-1,10-phenanthroline | 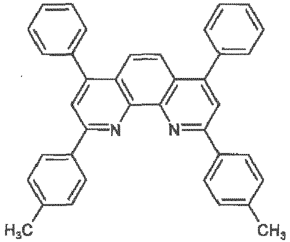 | EP1786050 |

The electron transport layer may comprises a lithium halide or a lithium organic complex.

Suitable organic ligands to form a lithium organic complex that can be used for the electron transport layer are disclosed, and incorporated by reference, for example in US 2014/0048792 and Kathirgamanathan, Poopathy; Arkley, Vincent; Surendrakumar, Sivagnanasundram; Chan, Yun F.; Ravichandran, Seenivasagam; Ganeshamurugan, Subramaniam; Kumaraverl, Muttulingam; Antipan-Lara, Juan; Paramaswara, Gnanamolly; Reddy, Vanga R., Digest of Technical Papers - Society for Information Display International Symposium (2010), 41(Bk. 1), 465-468.

The organic ligand of the lithium organic complex of the electron transport layer may be selected from the group comprising a quinolate, a borate, a phenolate, a pyridinolate or a Schiff base ligand, or Table 1;
- preferably the lithium quinolate complex has the formula III: 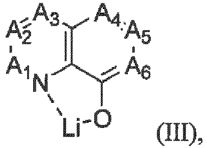 wherein
   A₁ to A₆ are same or independently selected from CH, CR, N, O;
   R is same or independently selected from hydrogen, halogen, alkyl or aryl or heteroaryl with 1 to 20 carbon atoms; and more preferred A₁ to A₆ are CH;
- preferably the borate based organic ligand is a tetra(1H-pyrazol-1-yl)borate;
- preferably the phenolate is a 2-(pyridin-2-yl)phenolate or a 2-(diphenylphosphoryl)phenolate;
- preferably the lithium Schiff base has the structure 100, 101,102 or 103: 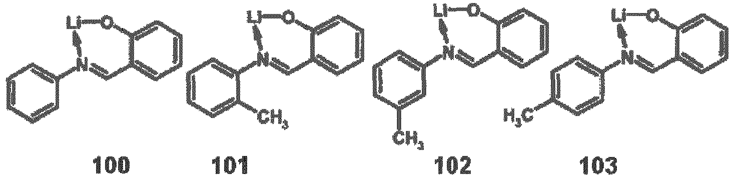
- more preferred the lithium organic complex is selected from a compound of Table 1.
The lithium halide of the electron transport layer may be selected from the group comprising a LiF, LiCl, LiBr or LiJ, and preferably LiF.

The ETL may be formed on the EML by vacuum deposition, spin coating, slot-die coating, printing, casting, or the like. When the ETL is formed by vacuum deposition or spin coating, the deposition and coating conditions may be similar to those for formation of the HIL 130. However, the deposition and coating conditions may vary, according to a compound that is used to form the ETL.

### Electron injection laver (EIL)

The optional EIL, which may facilitates injection of electrons from the cathode, may be formed on the ETL, preferably directly on the electron transport layer. Examples of materials for forming the EIL include LiQ, LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to a material that is used to form the EIL.

The thickness of the EIL may be in the range of about 0.1 nm to 10 nm, for example, in the range of 0.5 nm to 9 nm. When the thickness of the EIL is within this range, the EIL may have satisfactory electron-injecting properties, without a substantial increase in driving voltage.

### Cathode electrode

The cathode electrode is formed on the EIL if present. The cathode electrode may be a cathode, which is an electron-injecting electrode. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. In addition, the cathode electrode may be formed of a transparent conductive material, such as ITO or IZO.

The thickness of the cathode electrode may be in the range of about 5 nm to 1000 nm, for example, in the range of 10 nm to 100 nm. When the cathode electrode is in the range of 5 nm to 50 nm, the electrode will transparent even if a metal or metal alloy is used.

The cathode electrode is not an electron injection layer or electron transport layer.

Since the layers of the ETL have similar or identical energy levels, the injection and transport of the electrons may be controlled, and the holes may be efficiently blocked. Thus, the OLED may have long lifetime.

### Light-emitting diode (OLED)

According to another aspect of the present invention, there is provided an organic light-emitting diode (OLED) comprising: a substrate; a anode electrode formed on the substrate; a hole injection layer, a hole transport layer, an emission layer, and a cathode electrode.

According to another aspect of the present invention, there is provided an organic light-emitting diode (OLED) comprising: a substrate; a anode electrode formed on the substrate; a hole injection layer, a hole transport layer, an emission layer, hole blocking layer and a cathode electrode.

According to another aspect of the present invention, there is provided an organic light-emitting diode (OLED) comprising: a substrate; a anode electrode formed on the substrate; a hole injection layer, a hole transport layer, an emission layer, hole blocking layer, electron transport layer, and a cathode electrode.

According to another aspect of the present invention, there is provided an organic light-emitting diode (OLED) comprising: a substrate; a anode electrode formed on the substrate; a hole injection layer, a hole transport layer, an emission layer, hole blocking layer, electron transport layer, an electron injection layer, and a cathode electrode.

According to various embodiments of the present invention, there is provided an organic light-emitting diode (OLED) further comprising an electron injection layer formed between the electron transport layer and the cathode electrode.

According to various embodiments of the OLED of the present invention, the OLED may not comprises an electron injection layer.

According to various embodiments of the OLED of the present invention, the OLED may not comprises an electron transport layer.

According to various embodiments of the OLED of the present invention, the OLED may not comprises an electron transport layer and an electron injection layer.

According to another aspect of the present invention, there is provided a method of manufacturing an organic light-emitting diode (OLED), the method using:
- at least one deposition source, preferably two deposition sources and more preferred at least three deposition sources; and/or
- deposition via vacuum thermal evaporation; and/or
- deposition via solution processing, preferably the processing is selected from spin-coating, printing, casting and/or slot-die coating.
The object of the invention is further achieved by a compound of formula (I) 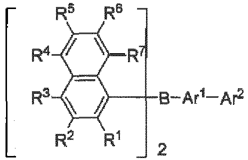 wherein R¹, R³ and R⁷ are independently selected from a group consisting of H, D, C₁-C₁₆ alkyl and C₁-C₁₆ alkoxy; R², R⁴, R⁵ and R⁶ are independently selected from a group consisting of H, D, C₁-C₁₆ alkyl, C₁-C₁₆ alkoxy and C₆-C₂₀ aryl; Ar¹ is selected from substituted or unsubstituted C₆-C₂₀ aryl, wherein, in case that Ar¹ is substituted, the substituents are independently selected from a group consisting of D, C₁-C₁₂ alkyl, C₁-C₂₀ alkoxy and C₆-C₂₀ aryl; Ar² is selected from a group consisting of substituted or unsubstituted C₆-C₄₀ aryl and groups of the following formulas (IIa) to (IIh), wherein * marks the position in the respective Ar² group for binding the Ar² group to the Ar¹ group, 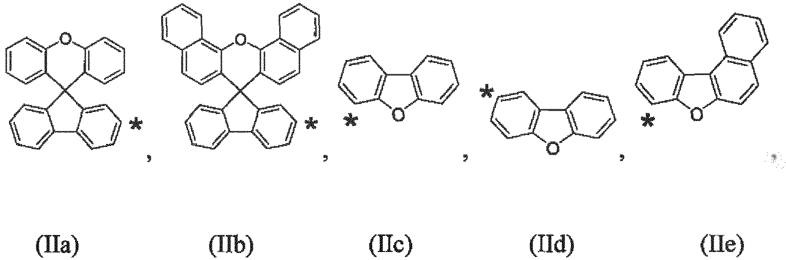 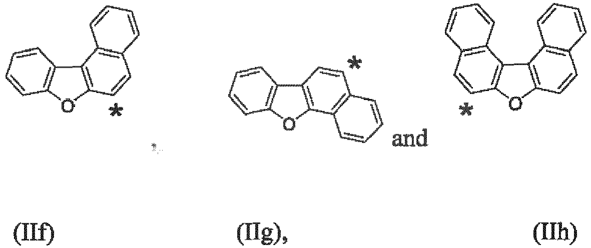 wherein in case that Ar² is substituted, the respective substituents are each independently selected from a group consisting of D, halide, C₁-C₁₂ alkyl and C₁-C₁₂ alkyoxy, C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl; wherein Ar¹ and Ar² may be further linked via a methylene (-CR⁸R⁹-) or an oxy (-O-) moiety to form a fluorene or dibenzofuran structure, wherein R⁸ and R⁹ may be independently selected from H and C₆-C₂₀ aryl.

In another aspect, a compound of formula (I) is provided 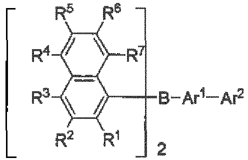 wherein R¹, R³ and R⁷ are independently selected from a group consisting of H, D, C₁-C₁₆ alkyl and C₁-C₁₆ alkoxy; R², R⁴, R⁵ and R⁶ are independently selected from a group consisting of H, D, C₁-C₁₆ alkyl, C₁-C₁₆ alkoxy and C₆-C₂₀ aryl; Ar¹ is selected from substituted or unsubstituted C₆-C₂₀ aryl, wherein, in case that Ar¹ is substituted, the substituents are independently selected from a group consisting of D, C₁-C₁₂ alkyl, C₁-C₂₀ alkoxy and C₆-C₂₀ aryl; Ar² is selected from a group consisting of substituted or unsubstituted C₆-C₄₀ aryl and groups of the following formulas (IIa) to (IIh), wherein * marks the position in the respective Ar² group for binding the Ar² group to the Ar¹ group, 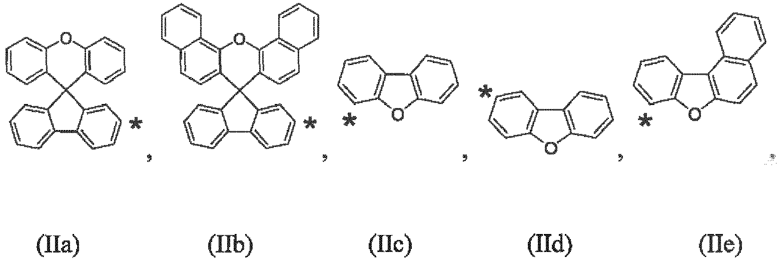 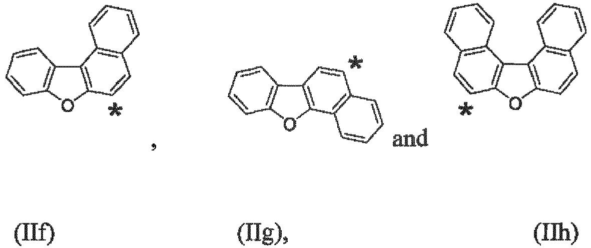 wherein in case that Ar² is substituted, the respective substituents are each independently selected from a group consisting of D, halide, C₁-C₁₂ alkyl and C₁-C₁₂ alkyoxy, C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl; wherein Ar¹ and Ar² may be further linked via an oxy (-O-) moiety to form a dibenzofuran structure.

In another aspect, a compound of formula (I) is provided 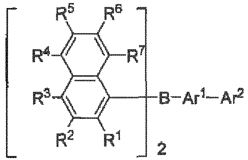 wherein R¹, R³ and R⁷ are independently selected from a group consisting of H, D, C₁-C₁₆ alkyl and C₁-C₁₆ alkoxy; R², R⁴, R⁵ and R⁶ are independently selected from a group consisting of H, D, C₁-C₁₆ alkyl, C₁-C₁₆ alkoxy and C₆-C₂₀ aryl; Ar¹ is selected from substituted or unsubstituted C₆-C₂₀ aryl, wherein, in case that Ar¹ is substituted, the substituents are independently selected from a group consisting of D, C₁-C₁₂ alkyl, C₁-C₂₀ alkoxy and C₆-C₂₀ aryl; Ar² is selected from a group consisting of substituted or unsubstituted C₆-C₄₀ aryl and groups of the following formulas (IIa) to (IIh), wherein * marks the position in the respective Ar² group for binding the Ar² group to the Ar¹ group, 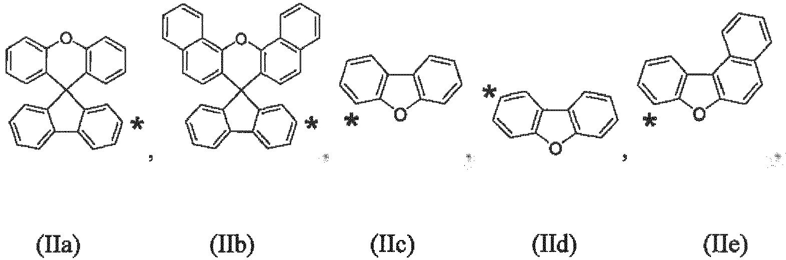 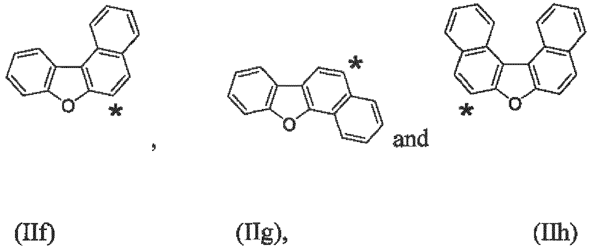 wherein in case that Ar² is substituted, the respective substituents are each independently selected from a group consisting of D, halide, C₁-C₁₂ alkyl and C₁-C₁₂ alkyoxy, C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl.

In a preferred embodiment, Ar² is selected from a group consisting of phenyl, biphenyl, naphthyl, anthranyl, phenanthryl, pyrenyl, 9-fluorenyl, 2-fluorenyl, 3-fluorenyl, 4-fluorenyl, 5-fluorenyl and formula (IIa) to (IIh).

A further preferred selection for Ar² is unsubstituted aryl, non-fluorenyl aryl, aryl substituted with one or more of the compounds according to formula (IIa) to (IIh), or fluorenyl substituted with one or more of the substituents according to formula (IIa) to (IIh).

Preferably, R¹ is C₁-C₁₂ alkyl, preferably methyl, or C₁-C₁₂ alkoxy, preferably methoxy, and R² to R⁷ are each H.

More preferred, Ar¹ is phenyl, biphenyl, naphthyl or anthranyl.

Furthermore, it may be preferred that 5-fluorenyl is excluded from the possible selection of Ar¹.

When Ar² is selected as described above, the glass transition temperature (Tg) is improved compared to compounds of formula (I) with Ar² = hydrogen. A high Tg is preferred as it improves the temperature stability of the electroluminescent device. In particular, the layer comprising compound of formula (I) is less likely to undergo morphological changes at elevated temperatures when the Tg is high. Preferably, the Tg is above 80 °C, more preferred above 100 °C, even more preferred above 120 °C.

Finally, it is preferred that the compound of formula (I) is selected from

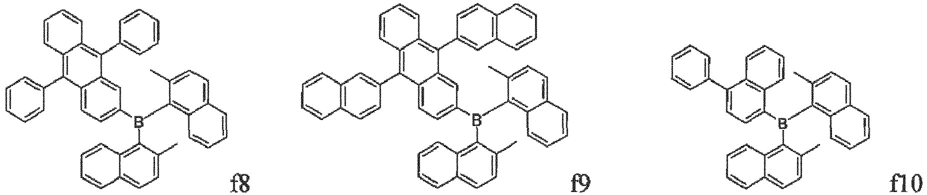

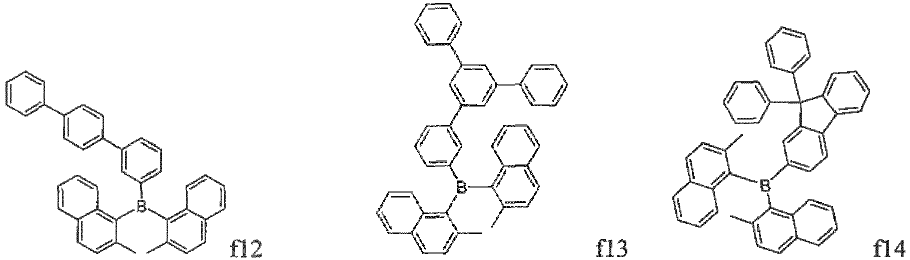

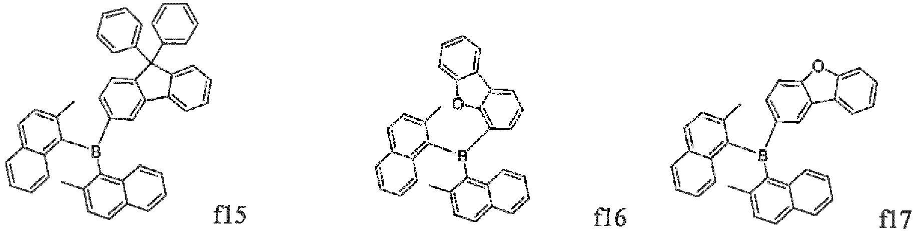

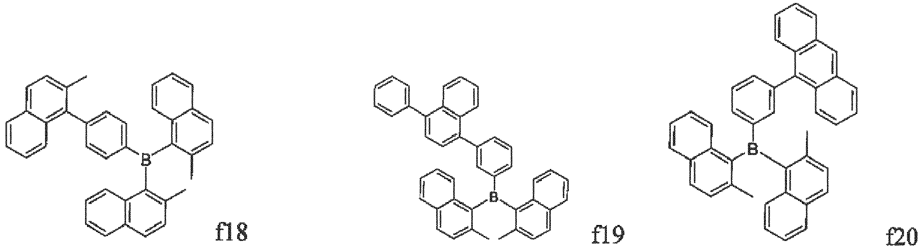

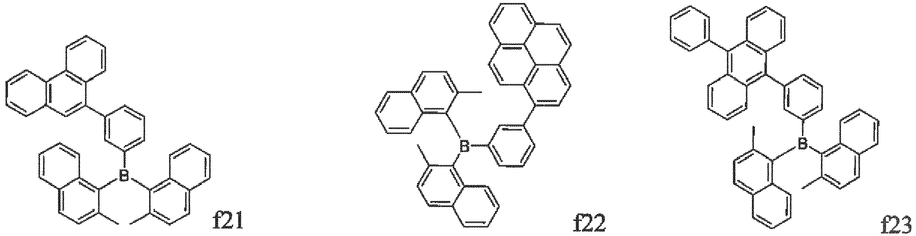

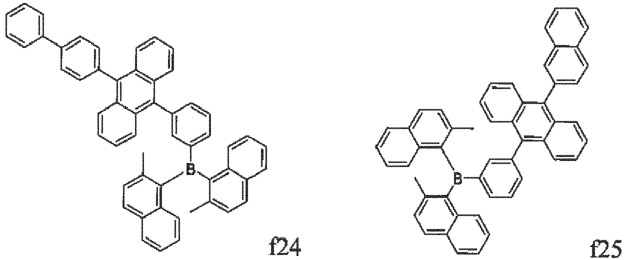

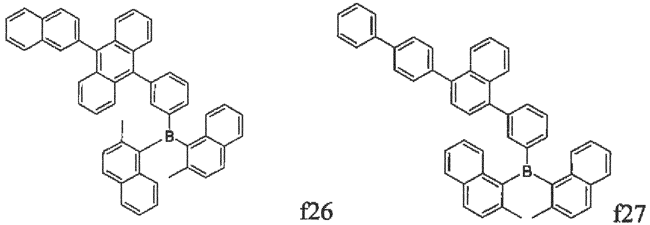

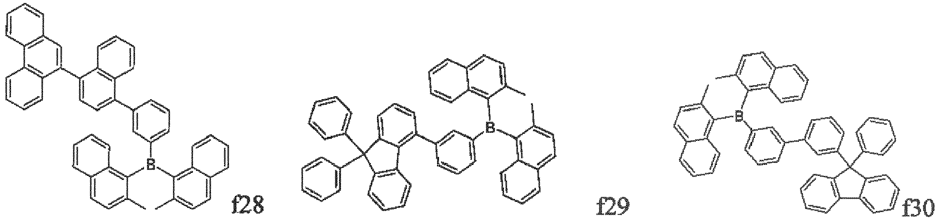

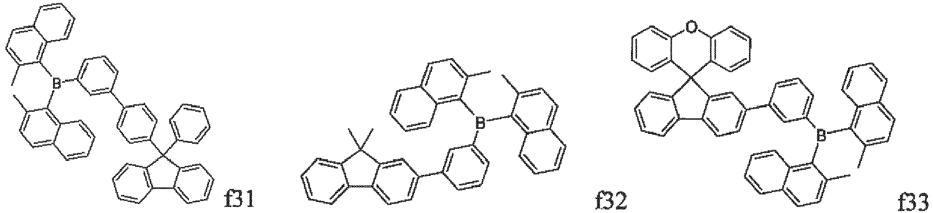

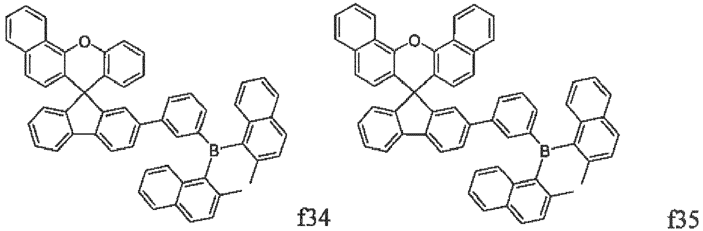

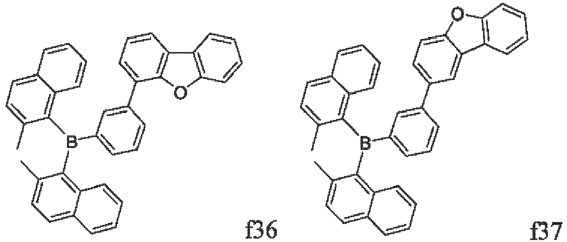

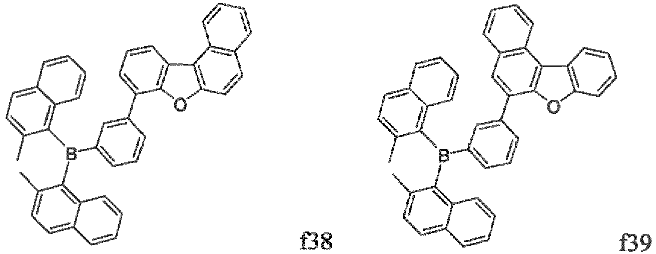

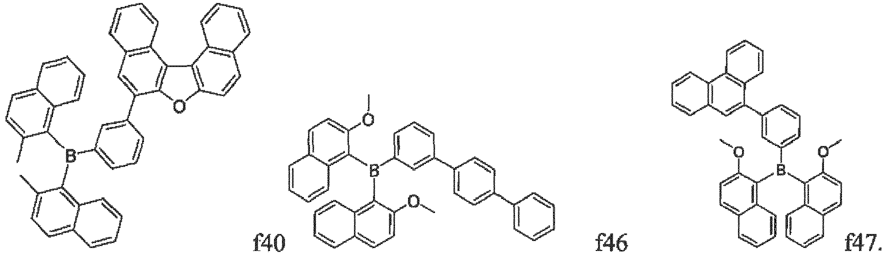

The object is further achieved by a method for preparing a compound of formula (I) comprising:
a) reacting a compound of formula (P1) 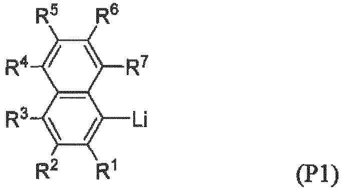 and a compound of formula (P2) 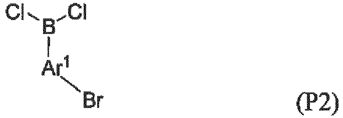 to obtain a compound of formula (P3) 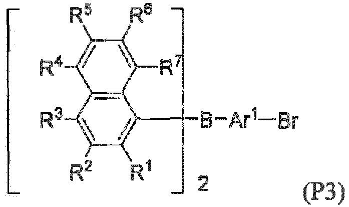 and
b) reacting the compound of formula (P3) obtained in step a) with a compound of the formula Ar²B(OR¹⁰)₂ wherein R¹⁰ is selected from hydrogen or C₁ to C₆ alkyl to obtain a compound of formula (I), 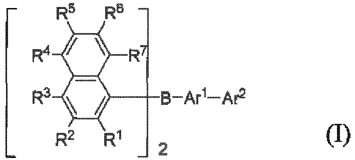 wherein R¹ to R⁷, Ar¹ and Ar² are defined in accordance with the definition of the inventive device.

"Reacting" in this regard encompasses all necessary measures to allow the reaction of the respective compounds. For example for reacting in step a), the compound P1 may be dissolved in a first solvent. Likewise, compound P2 may be dissolved in a second solvent. Especially, reacting comprises contacting molecules of the compound of formula P1 with molecules of the compound of formula P2. For this purpose, the compound of formula PI, optionally dissolved in a first solvent, may be added to the compound of formula P2, optionally dissolved in a second solvent. Likewise, it is possible to add the compound of formula P2 to the compound of formula P1 wherein, of course, both compounds may be dissolved in respective solvents. Reacting will be at a temperature allowing to react the respective compounds in an appropriate reaction velocity. Keeping in mind that the inventive method has to be industrial applicable, an appropriate reaction velocity is from several seconds to several days. Preferred is a reaction velocity allowing the fastest reaction of the respective compounds. It may be preferred to conduct the step of reacting at lower temperatures - notwithstanding a lower reaction velocity - to avoid exothermic heat release and/or side reactions.

The first solvent may be present when performing step a). The first solvent may be selected from a group comprising dialkyl ethers, alkyl esters, alkyl nitriles; dialkyl amides, dialkyl sulfoxides, halogenated alkanes and aromatic compounds. Preferably, the first solvent is selected from a group comprising diethyl ether, methyl-tert-butylether (MTBE), diglyme, tetrahydrofurane, ethyl acetate, acetonitrile, dimethoxy sulfoxide (DMSO), N,N-dimethylformamide (DMF), dichloromethane, chloroform, toluene.

Improved control of an internal (reaction-) temperature in step a) is achieved if the compound of formula (P1) is added as a mixture in a first solvent. P1 may be dissolved or suspended in the first solvent.

The second solvent may be selected from dialkyl ethers, preferably diethyl ether, methyl-tert-butylether (MTBE), diglyme and tetrahydrofurane.

In a preferred embodiment reacting P1 and P2 in step a) is in the presence of diethylether and/or tertrahydrofuran.

The internal temperature is measured with a thermometer or thermocouple which is inserted into the reaction mixture. Preferably, the internal temperature is below 0 °C, even more preferred below -20 °C, also preferred below - 50 °C, also preferred below - 70 °C.

Surprisingly, it was found that the inventive organic electroluminescent device as well as the compounds when used in such a device solve the problem underlying the present invention by being superior over the organic electroluminescent devices and compounds known in the art, in particular with respect to operating voltage and external quantum efficiency. The inventors have surprisingly found that particular good performance can be achieved when using the organic electroluminescent device as a fluorescent blue device. The specific arrangements mentioned herein as preferred were found to be particularly advantageous. Likewise, some compounds falling within the scope of the broadest definition of the present invention have surprisingly be found to be particularly well performing with respect to the mentioned properties of voltage and/or quantum efficiency. These compounds are discussed herein to be particularly preferred.

### BRIEF DESCRIPTION OF THE DRAWINGS

These and/or other aspects and advantages of the present invention will become apparent and more readily appreciated from the following description of the exemplary embodiments, taken in conjunction with the accompanying drawings, of which:
FIG. 1 is a schematic sectional view of an organic light-emitting diode (OLED), according to an exemplary embodiment of the present invention;
FIG. 2 is a schematic sectional view of an OLED, according to an exemplary embodiment of the present invention.
FIG. 3 is a schematic sectional view of an OLED, according to an exemplary embodiment of the present invention.

### DETAILED DESCRIPTION

Reference will now be made in detail to the exemplary embodiments of the present invention, examples of which are illustrated in the accompanying drawings, wherein like reference numerals refer to the like elements throughout. The exemplary embodiments are described below, in order to explain the aspects of the present invention, by referring to the figures.

Herein, when a first element is referred to as being formed or disposed "on" a second element, the first element can be disposed directly on the second element, or one or more other elements may be disposed there between. When a first element is referred to as being formed or disposed "directly on" a second element, no other elements are disposed there between.

FIG. 1 is a schematic sectional view of an organic light-emitting diode (OLED) 100, according to an exemplary embodiment of the present invention. The OLED 100 includes a substrate 110. On the substrate 110 an anode 120 is disposed. On the anode 120 a hole injection layer 130 is disposed and thereon a hole transport layer 140. Onto the hole transport layer 140 an emission layer 150 comprising the compound of formula (I) and a cathode electrode 190 are disposed.

FIG. 2 is a schematic sectional view of an organic light-emitting diode (OLED) 100, according to an exemplary embodiment of the present invention. The OLED 100 includes a substrate 110, a first electrode 120, a hole injection layer (HIL) 130, a hole transport layer (HTL) 140, an emission layer (EML) 150, an electron transport layer (ETL) 161. The electron transport layer (ETL) 161 comprising or consisting of the compound of formula (I) is formed directly on the EML 150. Onto the electron transport layer (ETL) 161 a cathode electrode 190 is disposed.

Instead of a single electron transport layer 161, optional an electron transport layer stack (ETL) can be used.

Fig. 3 is a schematic sectional view of an OLED 100, according to another exemplary embodiment of the present invention. Fig. 3 differs from Fig. 2 in that the OLED 100 of Fig. 3 comprises a hole blocking layer (HBL) 155 and an electron injection layer (EIL) 180.

Referring to Fig. 3 the OLED 100 includes a substrate 110, an anode electrode 120, a hole injection layer (HIL) 130, a hole transport layer (HTL) 140, an emission layer (EML) 150, a hole blocking layer (HBL) 155, an electron transport layer (ETL) 161, an electron injection layer (EIL) 180 and a cathode electrode 190. The electron transport layer (ETL) 161 or the electron injection layer (EIL) 180 comprise or consist of the compound of formula (I).

In the description above the method of manufacture an OLED of the present invention is started with a substrate 110 onto which an anode electrode 120 is formed, on the anode electrode 120, an hole injection layer 130, hole transport layer 140, an emission layer 150, optional a hole blocking layer 155, optional at least one electron transport layer 161, optional at least one electron injection layer 180, and a cathode electrode 190 are formed, in that order or the other way around.

While not shown in Fig. 1, Fig. 2 and Fig. 3, a sealing layer may further be formed on the cathode electrodes 190, in order to seal the OLEDs 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

### Examples

### Synthetic procedures

### Synthesis of Compound f12([1,1':4',1"-terphenyl]-3-ylbis(2-methylnaphthalen-1-yl)borane)

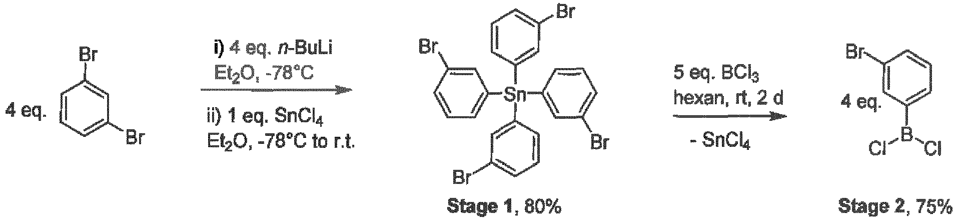

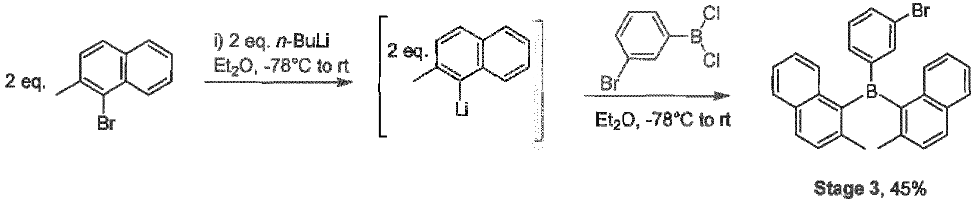

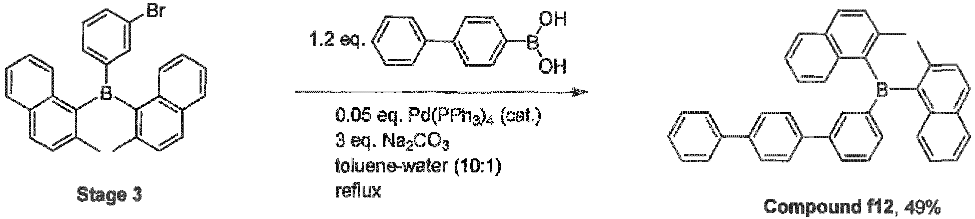

### 1. Tetrakis(3-bromophenyl)stannane Stage 1

**Sn(*m*-C₆H₄Br)₄:** 1,3-Dibromobenzene (5.89 g, 24.97 mmol) was dissolved in 60 mL of ether and cooled to -50 °C. Then 16.2 mL of a 1.6 M solution of ***n*BuLi** (26.00 mmol) in hexane was added dropwise. After having been stirred for 120 min the reaction mixture was cooled to -78 °C, and 0.73 mL (6.25 mmol) of SnCl₄ was added dropwise. After the mixture was stirred for 12 h at ambient temperature, 20 mL of 1 M HCl was added, and the product was extracted with ether (3 x 70 mL). The organic phase was washed with H₂O and dried with MgSO4. After removal of the solvent *in vacuo,* 30 mL of cold MeOH was added to the resulting oil and the mixture was stirring at 0-5°C. The precipitate was filtered and washed with cold MeOH(1 x 3 mL). After drying *in vacuo* Sn(*m*-C₆H₄Br)₄ was obtained as a colorless crystalline powder (3.70 g, 5.00 mmol, 80% yield). M.p.119-120°C. IR (ATR): U = 1553, 1456, 1382, 1188, 1081, 996, 771, 715, 681, 643 cm-¹. ¹H NMR (400 MHz, CDCl₃): δ = 7.64-7.62 (m, 4H), 7.61-7.56 (m, 4H), 7.44 (d, ³J(H-H) = 7.3 Hz, 4H), 7.32 (t, ³J(H-H) = 7.6 Hz, 4H) ppm; ¹³C NMR (100 MHz, CDCl₃): δ = 139.1 (²J(¹¹⁹Sn-C) = 41.8 Hz, CH), 138.8 (¹J(¹¹⁹Sn-C) = 528.2 Hz, Sn-C), 135.2 (²J(¹¹⁹Sn-C) = 35.2 Hz, CH), 133.0 (⁴J(¹¹⁹Sn-C) = 11.0 Hz, CH), 130.7 (³J(¹¹⁹Sn-C) = 55.0 Hz, CH), 124.2 (Br-C) ppm. MS: [M]⁺ (0.1%) 739.7, [M-Br]⁺ (0.1%) 660.8, [M-C₆H₄Br]⁺ (20%) 584.8, [M-2C₆H₄Br]⁺ (7%) 429.8, [M-3C₆H₄Br]⁺ (27%) 274.9, PhSn (100) 196.9.

### 2. (3-Bromophenyl)dichloroborane Stage 2

To a 50 mL (50.00 mmol) of 1M solution of BCl₃ in hexane at -78°C was added 7.43 g (10.00 mmol) of Sn(*m*-C₆H₄Br)₄ and the resulting mixture was stirring 1 h at -78°C and 2 d at r.t. After removal of volatiles (hexane, SnCl4 and excess of BCl₃) with membrane pump (70-75°C oil bad, 40 mbar), the residue was distilled *in vacuo* at 105-110°C (oil bad)/0.2 mbar giving 7.06 g (29.70 mmol, 75%) of (3-bromophenyl)dichloroborane. - ¹H-NMR (400 MHz, CDCl₃): δ = 7.37 (t, J = 7.8 Hz, 1H), 7.77 (ddd, J = 7.8, 2.1, 1.1 Hz, 1H), 8.06 (ddd, J = 7.8, 2.1, 1.1 Hz, 1H), 8.24 (dd, J = 2.1, 1.1 Hz, 1H) ppm. ¹³C NMR (100 MHz, CDCl₃): δ = 139.3 (CH), 137.8 (CH), 137.6 (B-C), 135.2 (CH), 129.9 (CH), 122.9 (Br-C) ppm. ¹¹B NMR (192 MHz, CDCl₃) δ = 54.9 ppm.

### 3. (3-Bromophenyl)bis(2-methylnaphthalen-1-yl)borane Stage 3

To a solution of 4.00 g (3.60 g of pure compound, 16.00 mmol) 90% 1-bromo-2-methylnaphthalene in 80 ml of diethyl ether at -78°C was added drop wise in 15 min 11 mL (17.6 mmol) 1.6 M *n*BuLi. After stirring at -78°C for 1 h and at 0°C for 2 h to the resulting mixture cooled to -78°C was added in 5 min at vigorous stirring 2.02 g (8.50 mmol) (3-bromophenyl)dichloroborane. After stirring for 1 h at -78°C the cooling bad was removed and reactions mixture was stirring additionally over night at ambient temperature, then cooled to 5°C and quenched with 5 drops of conc. HCl. Ether was removed *in vacuo,* the residue was mixed with water (100 mL), extracted with CHCl₃ (3 x 70 mL), organic lay was washed with water and dried with calcium chloride. Borane **Stage 3** was purified by a silica gel column chromatography using petrol ether as eluent to give a light yellow solid (1.65 g, 3.67 mmol, 45%). M.p. 157-158°C. IR (ATR): U = 1592, 1505, 1421, 1389, 1225, 1192, 808, 743, 604, 510, 503 cm⁻¹.¹H NMR (600 MHz, CDCl₃) δ = 7.86-7.79 (m, 4H), 7.61-7.53 (m, 4H), 7.37-7.28 (m, 5H), 7.18-7.11 (m, 3H), 2.24 (s, 6H, Me) ppm. ¹³C NMR (150 MHz, CDCl₃): δ =148.4 (br s, B-C_{phenyl}), 141.9 (br s, 2C, B-C_{Naphthyl}), 139.6 (2Cq), 139.2 (CH), 135.9 (2Cq), 135.6 (CH), 135.3 (CH), 131.8 (Cq), 131.7 (Cq), 130.1 (CH), 130.0 (CH), 129.9 (CH), 129.5 (CH), 129.4 (CH), 129.1 (CH), 129.0 (CH), 128.5 (CH), 128.4 (CH), 125.5 (2CH), 124.5 (2CH), 122.9 (C-Br), 23.8 (Me), 23.6 (Me) ppm. ¹¹B NMR (192 MHz, CDCl₃) δ = 74.3 ppm. MS: [M]⁺ (12%) 448; [M-(1-methylnaphthalene)]⁺ (17%) 306; [M-(1-methylnaphthalene)-Br]⁺ (12%) 227; [1-methylnaphthalene)]⁺ (28%) 142.

### 4. [1,1':4',1"-terphenyl]-3-ylbis(2-methylnaphthalen-1-yl)borane Compound f12

A mixture of borane **Stage 3** (90 mg, 0.20 mmol), Pd(PPh₃)₄ (12 mg, 5mol.%, 0.01 mmol), 1,1'-biphenyl]-4-ylboronic acid (48 mg, 0.24 mmol), Na₂CO₃ (64 mg, 0.60 mmol) and 1 mL water in toluene (15 mL) was degassed by N₂ bubbling for 15 min. The reaction mixture was then heated to 105-110°C and monitored via TLC until complete, typically 8-12 h. After removal of the solvent, the residue was diluted with 10 mL water, acidified with 3 drops conc. HCl, extracted with CHCl₃ (3 x 20 mL), the organic lay was washed with water and dried with calcium chloride. **Compound f12** was purified by a silica gel column chromatography using petrol ether as eluent to give a white solid (51 mg, 0.098 mmol, 49%). M.p. 180-181°C. Tg 87 °C.. IR (ATR): U = 1591, 1506, 1420, 1384, 1224, 1189, 811, 740, 606, 512, 505 cm⁻¹.¹H NMR (400 MHz, CDCl₃) δ =7.85 (d, J = 8.3 Hz, 4H), 7.79-7.65 (m, 5H), 7.60-7.53 (m, 4H), 7.49-7.39 (m, 5H), 7.38-7.31 (m, 5H), 7.18 (d, J = 7.6 Hz, 1H), 7.14 (d, J = 7.5 Hz, 1H), 2.31 (s, 3H, Me), 2.30 (s, 3H, Me) ppm. ¹³C NMR (100 MHz, CDCl₃): δ =146.2 (br s, B-C_{Phenyl}), 142.5 (br s, 2C, B-C_{Naphthyl}), 140.6 (Cq), 140.1 (Cq), 140.0 (Cq), 139.9 (Cq), 139.5 (2Cq), 136.6 (CH), 136.2 (Cq), 136.1 (Cq), 136.0 (CH), 131.8 (Cq), 131.7 (Cq), 131.3 (CH), 129.9 (CH), 129.8 (2CH), 129.7 (CH), 129.2 (2CH), 128.8 (2CH), 128.6 (CH), 128.5 (CH), 128.4 (CH), 127.5 (2CH), 127.4 (2CH), 127.3 (CH), 127.0 (2CH), 125.3 (2CH), 124.4 (2CH), 23.9 (Me), 23.7 (Me) ppm. MS: [M]⁺ (35%) 522; [M - (1-methylnaphthalene)]⁺ (98%) 380; [M - (1-methylnaphthalene) - Ph + 2H]⁺ (100%) 306; [1-methylnaphthalene)⁺ (72%) 142.

### Synthesis of Compound f21(bis(2-methylnaphthalen-1-yl)(3-(phenanthren-9-yl)phenyl)borane)

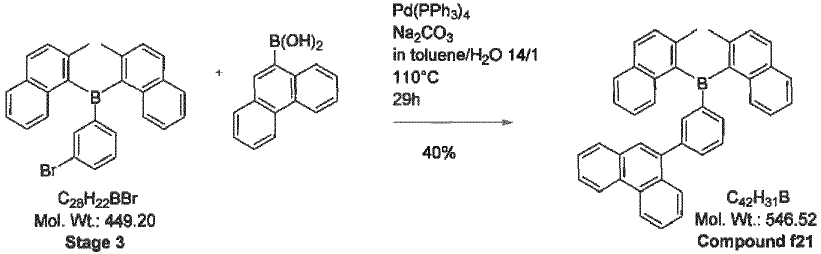

A mixture of (3-bromophenyl)bis(2-methylnaphthalen-1-yl)borane (Stage 3) (2.00 g, 4.45 mmol), Pd(PPh₃)₄ (0.26 mg, 5mol.%, 0.22 mmol), phenanthren-9-ylboronic acid (1.19 g, 5.36 mmol), Na₂CO₃ (1.40 g, 13.21 mmol) and 22 mL water in toluene (306 mL) was degassed by N₂ bubbling for 1h. The reaction mixture was then heated to 110°C and monitored via TLC until complete (29 h). After cooling to room temperature, the two phases were separated and the organic layer was washed with water (4 x 200 mL). Additionally, the organic layer was stirred twice with NaDTC (2 x 15 min) to remove palladium residues. After washing once more with water, the organic layer was dried with calcium chloride. The raw product was purified by column chromatography using hexane/ ethylacetat 98:2 as eluent to give a white solid (950 mg, 1.74 mmol, 40%). HPLC-MS 97 %, GC-MS 99.6 % (m/z 546), Tg 102°C (from DSC 10 K/min), no melting point observed. ¹H NMR (500 MHz, CD₂Cl₂) δ = 8.78 (d, 1H), 8.68 (d, 1H), 7.93-7.82 (m, 6H), 7.82-7.76 (d, 1H), 7.76-7.70 (m, 1H), 7.68 (s, 1H), 7.66-7.55 (m, 6H), 7.55-7.48 (m, 1H), 7.48-7.39 (m, 2H), 7.39-7.33 (m, 2H), 7.33-7.22 (m, 3H), 2.38 (s,3H, Me), 2.35 (s, 3H, Me) ppm. ¹³C NMR (125 MHz, CD₂Cl₂): δ = 146.5 (br, s B-C_{phenyl}), 143.1 (br, s, B-C_{naphthyl}), 141.0, 140.2 (d, *J* = 7.3Hz), 139.6, 139.0, 136.8 (d, *J* = 11.4Hz), 134.9, 132.6 (d*, J* = 3.8Hz), 132.0, 131.3, 131.0, 130.6, 130.4, 129.7, 129.1, 129.0, 128.1, 127.4, 127.2 (d, *J* = 8.0Hz), 127.0, 126.9, 125.9 (d, *J* = 6.2Hz), 125.1 (d, *J* = 1.7Hz), 123.4, 123.0, 24.2 (CH₃), 23.9 (CH₃) ppm.

Other compounds, in particular compounds f1 to f47 mentioned herein, were prepared accordingly. A person skilled in the art will understand that the specific reaction conditions for preparing the respective compounds may be slightly modified on basis of the general knowledge of this person to prepare the respective compounds.

### General procedure for fabrication of OLEDs

For bottom emission devices - Examples 1 to 5 and comparative examples 1 to 5, a 15Ω /cm 2 glass substrate (available from Corning Co.) with 100 nm Ag was cut to a size of 50 mm x 50 mm x 0.7 mm, ultrasonically cleaned with isopropyl alcohol for 5 minutes and then with pure water for 5 minutes, and cleaned again with UV ozone for 30 minutes, to prepare a first anode electrode.

Then, 92 wt.-% of a hole transport matrix doped with 8 wt.-% and 8 wt.-% of 2,2',2"-(cyclopropane-1,2,3-triylidene)tris(2-(p-cyanotetrafluorophenyl)acetonitrile) was vacuum deposited on the ITO electrode, to form a HIL having a thickness of 10 nm. Then, the hole transport matrix was vacuum deposited on the HIL, to form a HTL having a thickness of 130 nm. For Examples 1, 2, 4 and 5 and Comparative examples 1 to 5 (N4,N4"-di(naphthalen-1-yl)-N4,N4"-diphenyl-[1,1':4',1"-terphenyl]-4,4"-diamine) was used as hole transport matrix. For Example 3, Biphenyl-4-yl(9,9-diphenyl-9H-fluoren-2-yl)-[4-(9-phenyl-9H-carbazol-3-yl)phenyl]-amine was used.

Then 97 wt.-% of ABH113 (Sun Fine Chemicals) as a host and 3 wt.-% of NUBD370 (Sun Fine Chemicals) as a dopant were deposited on the HTL, to form a blue-emitting EML with a thickness of 20 nm.

Then the electron transport layer (ETL) is formed by depositing a matrix compound according to Example 1 to Example 5 and Comparative examples 1 to 5, see Table 2 and 3 respectively. Then the electron injection layer (EIL) is formed by deposing tetrakis (1,3,4,6,7,8-hexahydro-2H-pyrimido[1,2-a]pyrimidinato)ditungsten (II) (W-1) (Examples 1 and Comparative examples 1 and 3), 3-Phenyl-3H-benzo[b]dinaphtho[2,1-d:1',2'-f]phosphepine-3-oxide (EIM-1), doped with 30 wt.-% Lithium tetra(1H-pyrazol-1-yl)borate (Li-1) (Example 2 and 3 and Comparative examples 2 and 4) or LiQ (Example 4 and 5 and comparative example 5) to form a layer as specified in Table 2 and Table 3, respectively. The cathode electrode was evaporated at ultra-high vacuum of 10⁻⁷ bar. Therefore, a thermal single co-evaporation of one or several metals was performed with a rate of 0, 1 to 10 nm/s (0.01 to 1 Å/s) in order to generate a homogeneous cathode with a thickness of 5 to 1000 nm. The cathode electrode was formed from 100 nm aluminum.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured under ambient conditions (20°C). Current voltage measurements are performed using a Keithley 2400 sourcemeter, and recorded in V. At 10 mA/cm² for bottom emission and 15 mA/cm² for top emission devices, a calibrated spectrometer CAS140 from Instrument Systems is used for measurement of CIE coordinates and brightness in Candela. Lifetime LT of the device is measured at ambient conditions (20°C) and 15 mA/cm², using a Keithley 2400 sourcemeter, and recorded in hours. The brightness of the device is measured using a calibrated photo diode. The lifetime LT is defined as the time till the brightness of the device is reduced to 97 % of its initial value.

In bottom emission devices, the emission is predominately Lambertian and quantified in percent external quantum efficiency (EQE). To determine the efficiency EQE in % the light output of the device is measured using a calibrated photodiode at 10 mA/cm².

In top emission devices, the emission is forward directed, non-Lambertian and also highly dependent on the micro-cavity. Therefore, the efficiency EQE will be higher compared to bottom emission devices. To determine the efficiency EQE in % the light output of the device is measured using a calibrated photodiode at 15 mA/cm².

The above experiments were repeated with compounds having the formula f1 to f47. In all cases comparable results were obtained supporting the superiority of the inventive compounds (when used in the inventive manner) over the prior art with respect to at least one of reduced operating voltage, improved external quantum efficiency or life time in OLEDs.

### Technical Effect of the invention

### Bottom emission devices with electron transport layer comprising compound of formula (I) and free of dopant

The beneficial effect of inventive compounds of formula (I) on the performance of bottom emission devices can be seen in Table 3.

**Table 3: Voltage, external quantum efficiency (EQE) and lifetime of bottom emission OLEDs comprising an electron transport layer comprising a compound of formula (I) which is free of dopant**

| | ETL | d (ETL1) / nm | EIL | wt.-% Li organic complex*¹ | d (EIL) / nm | V at 10 mA/ cm² / V | EQE^{*2} / % | LT at 15mA/cm2/ / h |
|---|---|---|---|---|---|---|---|---|
| Comparative example 1 | 3TPYMB | 36 | W-1 | - | 4 | 6.3 | 3.0 | < 1 |
| Comparative example 2 | 3TPYMB | 36 | EIM-1 : Li-1 | 30 | 3 | 5.9 | 3.2 | < 1 |
| Comparative example 3 | tri(anthracen-9-yl)borane | 36 | W-1 | - | 4 | 4.4 | 0.5 | < 1 |
| Comparative example 4 | tri(anthracen-9-yl)borane | 36 | EIM-1 : Li-1 | 30 | 3 | 4.3 | 0.6 | <1 |
| Example 1 | Compound f1 | 36 | W-1 | - | 4 | 3.6 | 7.5 | 1 |
| Example 2 | Compound f1 | 36 | EIM-1 : Li-1 | 30 | 3 | 3.2 | 7.3 | 1 |
| Example 3 | Compound f12 | 36 | EIM-1 : Li-1 | 30 | 3 | 3.25 | 5.3 | 2 |

| | | | | | | | | |
|---|---|---|---|---|---|---|---|---|
| ^{*1} = the wt.-% of the matrix compound EIM and the wt.-% of the lithium organic complex are in total 100 wt.-% based on the weight of the EIL. ^{*2} = detecting the light output efficiency with a calibrated photo diode at 10 mA/cm². | | | | | | | | |

**Table 4: Voltage, external quantum efficiency (EQE) and lifetime of bottom emission OLEDs comprising an electron transport layer comprising a compound of formula (I) as ETL matrix and an ETL dopant selected from a metal or Li organic complex**

| | ETL matrix | ETL dopant | wt.-% ETL dopant^{*3} | d (ETL1) / nm | EIL | d (EIL) / nm | V at 10 mA/ cm² / V | EQE^{*4} / % | LT at 15mA/cm2/ h |
|---|---|---|---|---|---|---|---|---|---|
| Comparative example 5 | 3TPYMB | Mg | 5 | 36 | LiQ | 1.5 | 5.1 | 2.8 | not measured |
| Example 4 | Compound f1 | Mg | 5 | 36 | LiQ | 1.5 | 4.9 | 6.6 | 6 |

| | ETL matrix | ETL dopant | wt.-% ETL dopant*³ | d (ETL1) / nm | EIL | d (EIL) / nm | V at 10 mA/ cm² / V | EQE^{*4} / % | LT at 15mA/cm2 / h |
|---|---|---|---|---|---|---|---|---|---|
| Example 5 | Compound f1 | Li-1 | 25 | 36 | LiQ | 1.5 | 4.2 | 7.7 | 1 |

| | | | | | | | | | |
|---|---|---|---|---|---|---|---|---|---|
| ^{*3}= the wt.-% of the ETL matrix compound and the wt.-% of the ETL dopant are in total 100 wt.-% based on the weight of the EIL. ^{*4} = detecting the light output efficiency with a calibrated photo diode at 10 mA/cm². | | | | | | | | | |

In comparative examples 1 and 2 (Table 3), borane compound 3TPYMB (Tris(2,4,6-trimethyl-3-(pyridin-3-yl)phenyl)borane, CAS 929203-02-1, Formula B) is used. In comparative examples 3 and 4, borane compound tri(anthracen-9-yl)borane (CAS 281668-48-2, Formula A) is used. Two different electron injection layers are tested, tungsten paddle wheel complex W-1 and an organic matrix compound EIM-1 doped with Li organic complex Li-1. The choice of electron injection layer has a small effect on voltage but little effect on external quantum efficiency EQE.

The voltage required to achieve 10 mA/cm² is rather high for literature electron transport material 3TPYMB (Tris(2,4,6-trimethyl-3-(pyridin-3-yl)phenyl)borane, CAS 929203-02-1) and external efficiency is only 3 % EQE (comparative example 1 and 2, Table 2).

The voltage required to achieve 10 mA/cm² is reduced for borane compound tri(anthracen-9-yl)borane (CAS 281668-48-2) compared to 3TPYMB, but the efficiency is also significantly reduced to less than 1 % EQE (comparative example 3 and 4, Table 2).

In Example 1 and 2 (Table 3), inventive compound f1(CAS 6962-78-3) is used with two different electron injection layers. In both examples, the voltage required to achieve 10 mA/cm² is significantly lower for Example 1 and 2 compared to comparative examples 1 to 4. Therefore, the power consumption is lower. In a mobile device battery life is prolonged.

Most noticeable is the beneficial effect of compound f1 on external quantum efficiency (EQE). The efficiency in Example 1 and 2 is increased dramatically compared to comparative example 1 to 2, from 3% EQE for literature compound 3TPYMB (Tris(2,4,6-trimethyl-3-(pyridin-3-yl)phenyl)borane, CAS 929203-02-1) to 7.3 and 7.5 % EQE, respectively, for inventive compound f1.

Even more substantial is the improvement in efficiency compared to borane compound tri(anthracen-9-yl)borane (CAS 281668-48-2). The efficiency is improved from less than 1 % EQE for comparative example 3 and 4 to over 7 % for Example 1 and 2.

Compound f12 is tested with a different hole transport material compared to compound f1. Compound f1 does not have a glass transition temperature (Tg), while the Tg of compound f12 is 87°C. The voltage is comparable to Example 2 but the efficiency is a little bit lower. However, compared to comparative examples 1 to 4, both efficiency and voltage are improved.

Additionally, the lifetime is improved of Example 1 to 3 compared to comparative examples 1 to 4, see Table 3. The lifetime at 15 mA/cm² is an important parameter as it describes the longterm operational stability of the OLED.

### Bottom emission devices with electron transport layer comprising compound of formula (I) and further comprising a dopant of metal or Li organic complex

The beneficial effect of a semiconductive layer comprising compounds of formula (I) and a dopant on the performance of bottom emission devices can be seen in Table 4.

In comparative example 5 (Table 4), borane compound 3TPYMB (Tris(2,4,6-trimethyl-3-(pyridin-3-yl)phenyl)borane, CAS 929203-02-1) is used as ETL matrix compound. The ETL matrix compound is doped with 5 wt.-% elemental Magnesium, Mg, as ETL dopant. The voltage to achieve 10 mA/cm² is 5.1 V. The external quantum efficiency (EQE) is very low, only 2.8 % EQE. Therefore, the lifetime has not been measured.

In Example 4, inventive compound f1 is used as ETL matrix. The same dopant as above is used at the same concentration. The voltage required to achieve 10 mA/cm² is reduced from 5.1 to 4.9 V. Surprisingly, the external quantum efficiency (EQE) is increased significantly, from 2.8 % in comparative example 5 to 6.6 % EQE in Example 4.

In Example 5, inventive compound f1 is used as ETL matrix and Li organic complex Li-1 is used as ETL dopant. The concentration of dopant is 25 wt.-%. The voltage required to achieve 10 mA/cm² is even lower, only 4.2 V, and the efficiency is further improved to 7.7 % EQE.

In summary, a beneficial technical effect of a semiconductive layer comprising a compound of formula (I) can be observed not only for an undoped layer, but also for a layer comprising a dopant selected from elemental metal or Li organic complex.

Another aspect is directed to an organic light-emitting diode (OLED) comprising more than one emission layer (EML) 150, for example two, three or four emission layers may be present. An organic light-emitting diode (OLED) comprising more than one emission layer is also described as a tandem OLED or stacked OLED.

Another aspect is directed to a device comprising at least one organic light-emitting diode (OLED). A device comprising organic light-emitting diodes (OLED) is for example a display or a lighting panel.

## Claims

1. Organic electroluminescent device (100) comprising at least one semiconductive layer comprising a compound of formula (I) 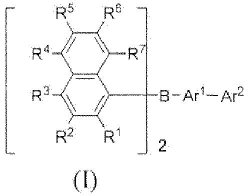
wherein R¹, R³ and R⁷ are independently selected from a group consisting of H, D, C₁-C₁₆ alkyl and C₁-C₁₆ alkoxy;
R², R⁴, R⁵ and R⁶ are independently selected from a group consisting of H, D, C₁-C₁₆ alkyl, C₁-C₁₆ alkoxy and C₆-C₂₀ aryl;
Ar¹ is selected from substituted or unsubstituted C₆-C₂₀ aryl, wherein, in case that Ar¹ is substituted, the substituents are independently selected from a group consisting of D, C₁-C₁₂ alkyl, C₁-C₁₆ alkoxy and C₆-C₂₀ aryl; and
Ar² is selected from a group consisting of H, D, substituted or unsubstituted C₆-C₄₀ aryl and groups of the following formulas (IIa) to (IIh), wherein * marks the position in the respective Ar² group for binding the Ar² to the Ar¹ group, 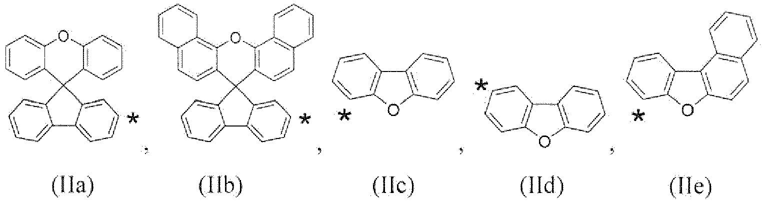 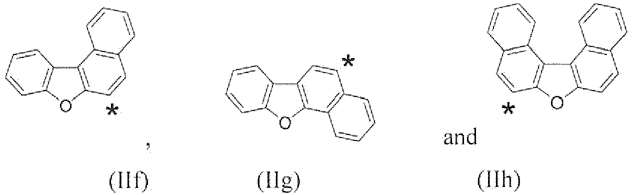
wherein in case that Ar² is substituted, the substituents are independently selected from a group consisting of D, halide, C₁-C₁₆ alkyl, C₁-C₁₆ alkoxy, and C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl;
wherein Ar¹ and Ar² may be further linked via a methylene (-CR⁸R⁹-) or an oxy (-O-) moiety to form a fluorene or dibenzofuran structure, wherein R⁸ and R⁹ may be independently selected from H, C₁-C₁₆ alkyl and C₁-C₁₆ alkoxy and C₆-C₂₀ aryl;
wherein the organic electroluminescent device (100) further comprising an emission layer (150) and a cathode (190), wherein the semiconductive layer comprising the compound of formula (I) is arranged between the emission layer (150) and the cathode electrode (190).

2. Organic electroluminescent device (100) according to claim 1 further comprising an electron injection layer (180), wherein the semiconductive layer comprising the compound of formula (I) is arranged between the emission layer (150) and the electron injection layer (180).

3. Organic electroluminescent device (100) according to any of the preceding claims, wherein the semiconductive layer comprising the compound of formula (I) further comprises a dopant being a lithium halide and/or a lithium organic complex.

4. Organic electroluminescent device (100) according to any of the preceding claims, wherein the semiconductive layer comprising the compound of formula (I) further comprises a dopant being a metal in its elemental form, wherein the metal is selected from an alkali, alkaline earth and rare earth metal and a mixture thereof.

5. Organic electroluminescent device (100) according to any of the preceding claims, wherein Ar² is selected from the group consisting of phenyl, naphthyl, anthranyl, phenanthryl, pyrenyl, 9-fluorenyl, 2-fluorenyl, 3-fluorenyl, 4-fluorenyl, 5-fluorenyl and formula (IIa) to (Ilh).

6. Organic electroluminescent device (100) according to any of the preceding claims, wherein R¹ is C₁-C₁₂ alkyl, preferably methyl, or C₁-C₁₂ alkoxy, preferably methoxy, and R² to R⁷ are each H.

7. Organic electroluminescent device (100) according to any of the preceding claims, wherein Ar¹ is phenyl, biphenyl, naphthyl, phenanthryl or anthranyl.

8. Organic electroluminescent device (100) according to any of the preceding claims, wherein the compound of formula (I) is selected from

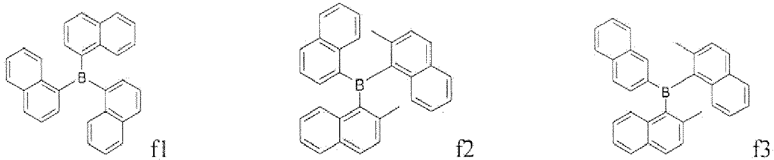

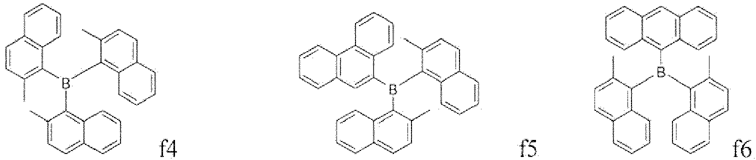

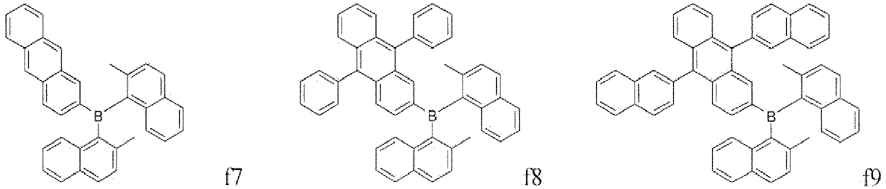

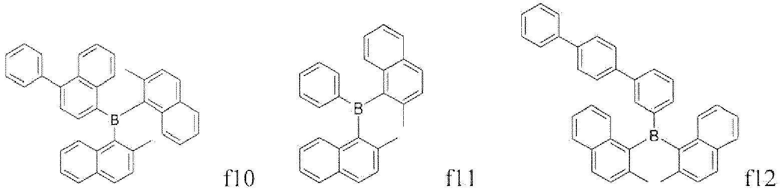

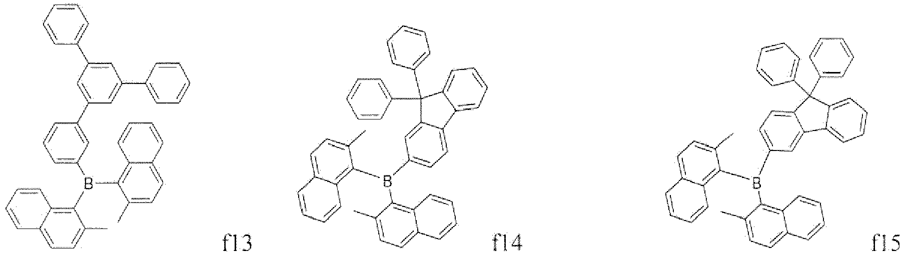

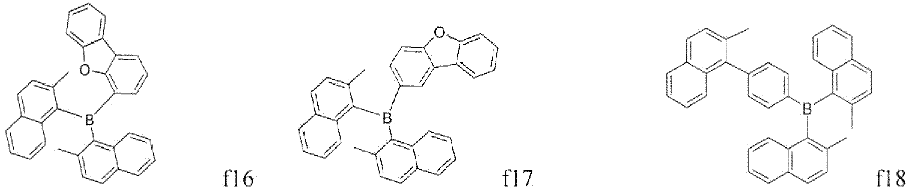

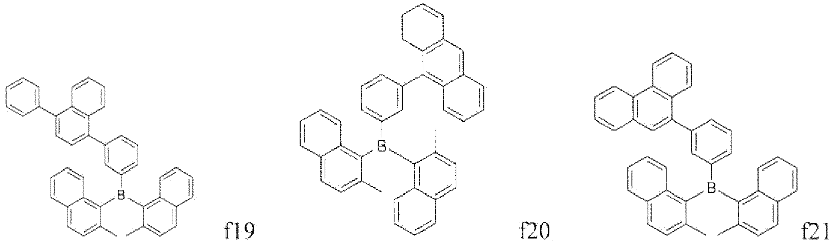

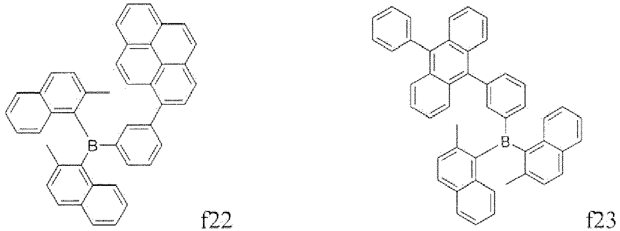

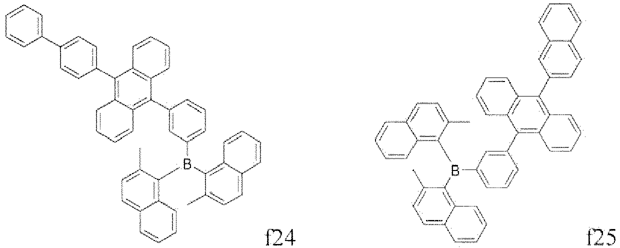

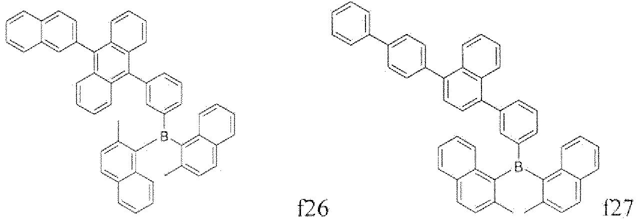

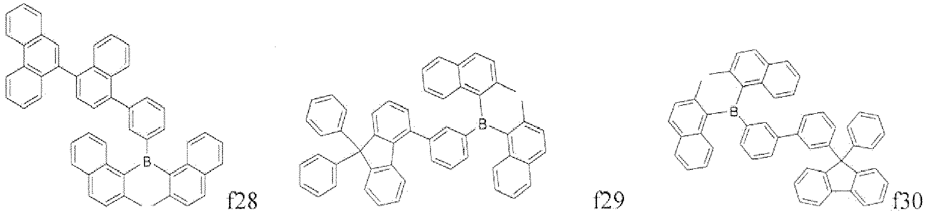

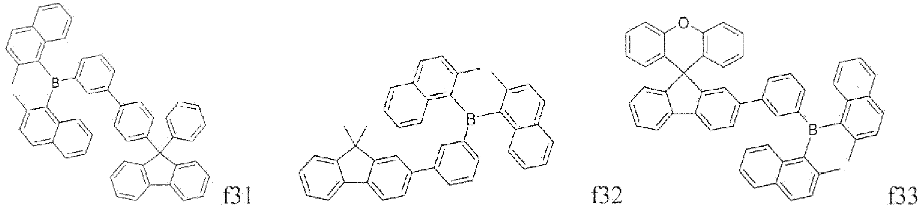

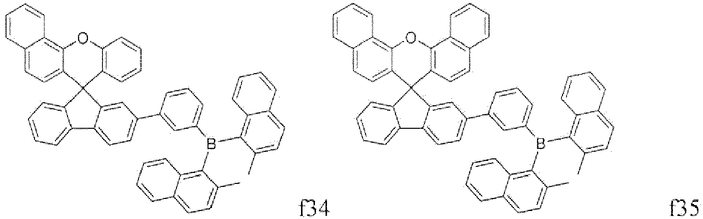

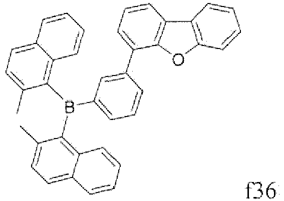

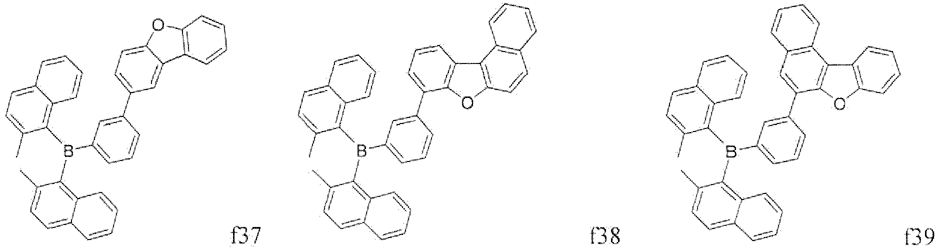

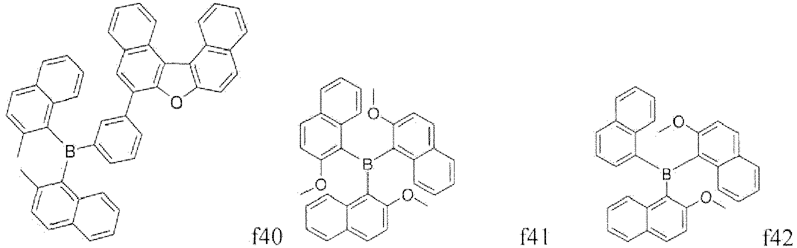

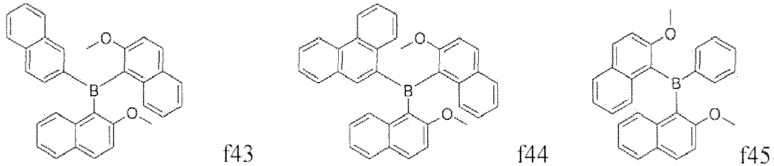

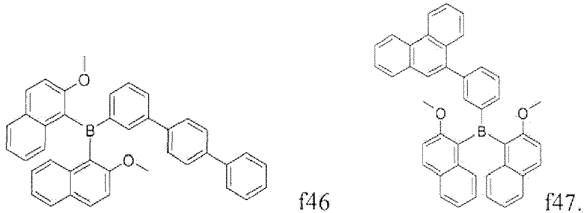

9. Compound of formula (I) 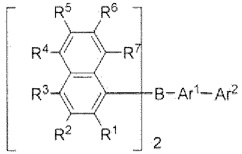
wherein R¹, R³ and R⁷ are independently selected from a group consisting of H, D, C₁-C₁₆ alkyl and C₁-C₁₆ alkoxy;
R², R⁴, R⁵ and R⁶ are independently selected from a group consisting of H, D. C₁₋C₁₆ alkyl, C₁-C₁₆ alkoxy and C₆-C₂₀ aryl;
Ar¹ is selected from substituted or unsubstituted C₆-C₂₀ aryl, wherein, in case that Ar¹ is substituted, the substituents are independently selected from a group consisting of D, C₁-C₁₂ alkyl, C₁-C₂₀ alkoxy and C₆-C₂₀ aryl;
Ar² is selected from a group consisting of substituted or unsubstituted C₆-C₄₀ aryl and groups of the following formulas (IIa) to (IIh), wherein * marks the position in the respective Ar² group for binding the Ar² group to the Ar¹ group, 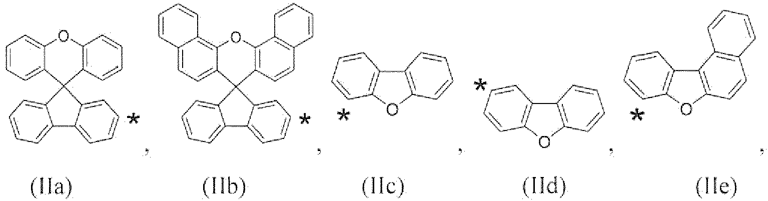 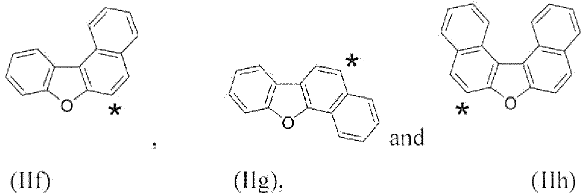
wherein in case that Ar² is substituted, the respective substituents are each independently selected from a group consisting of D, halide, C₁-C₁₂ alkyl and C₁-C₁₂ alkyoxy, C₆-C₂₀ aryl, preferably naphthyl, 9-fluorenyl, 2-fluorenyl, 3-fluorenyl and 4-fluorenyl, wherein the C₆-C₁₀ aryl may be unsubstituted or substituted with C₁-C₁₆ alkyl, C₁-C₁₆ heteroalkyl and C₆-C₄₀ aryl;
wherein Ar¹ and Ar² may be further linked via a methylene (-CR⁸R⁹-) or an oxy (-O-) moiety to form a fluorene or dibenzofuran structure, wherein R⁸ and R⁹ may be independently selected from H and C₆-C₂₀ aryl.

10. Compound according to claim 10, wherein Ar² is selected from a group consisting of phenyl, biphenyl, naphthyl, anthranyl,phenanthryl, pyrenyl, 9-fluorenyl, 2-fluorenyl, 3-fluorenyl, 4-fluorenyl, 5-fluorenyl and formula (IIa) to (IIh) as defined in claim 8.

11. Compound according to claims 9 or 10, wherein R¹ is C₁-C₁₂ alkyl, preferably methyl, or C₁-C₁₂ alkoxy, preferably methoxy, and R² to R⁷ are each H.

12. Compound according to any of the claims 9 to 11, wherein Ar¹ is phenyl, biphenyl, naphthyl or anthranyl.

13. Compound according to any of the claims 9 to 12, wherein the compound of formula (I) is selected from

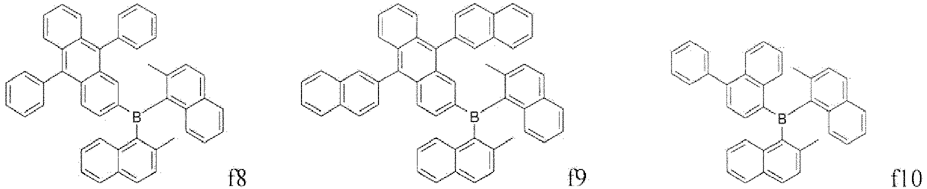

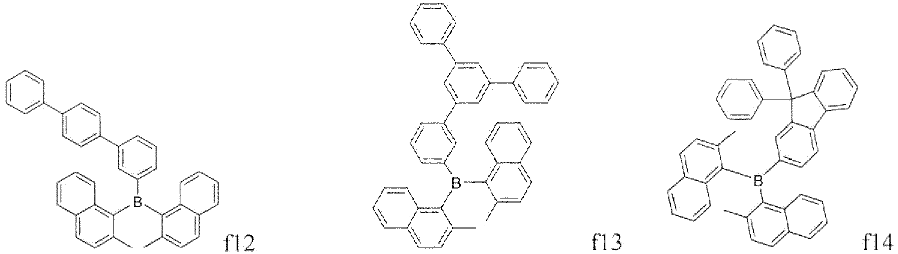

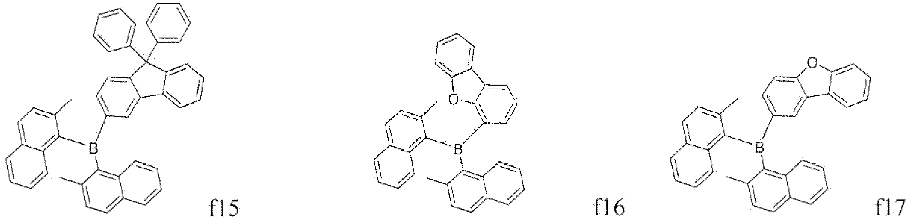

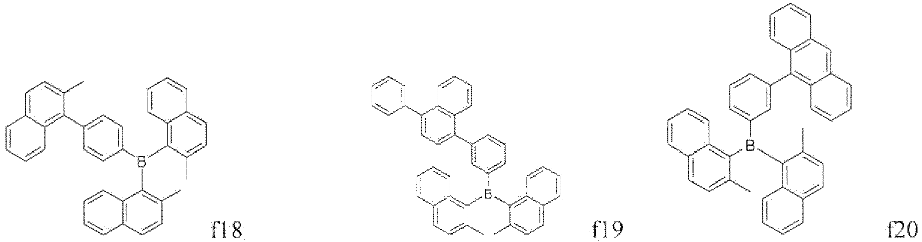

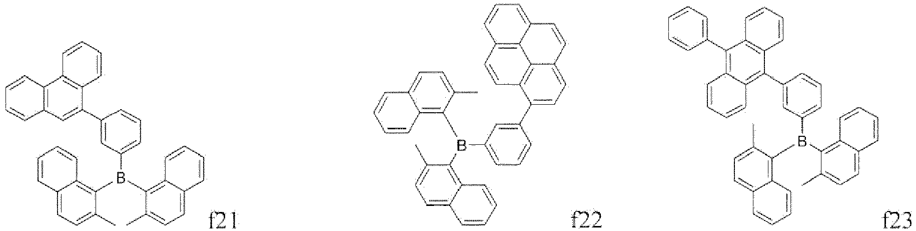

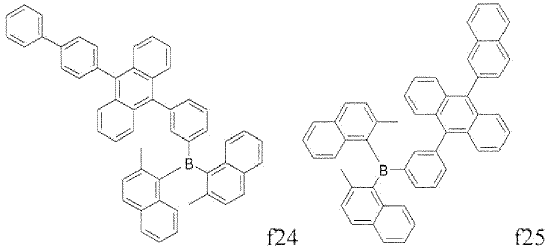

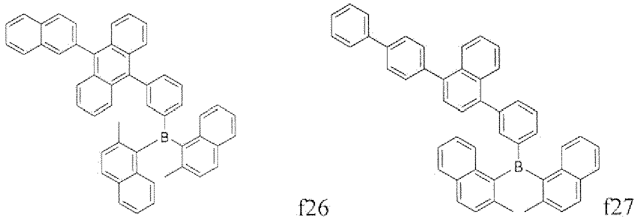

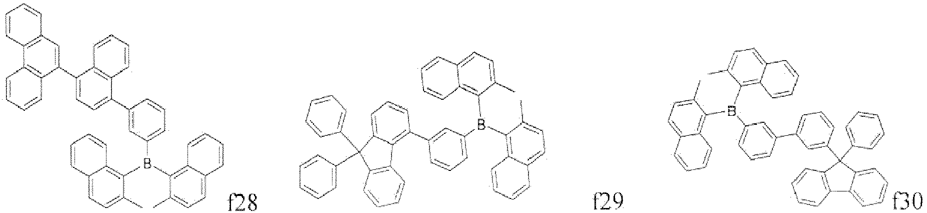

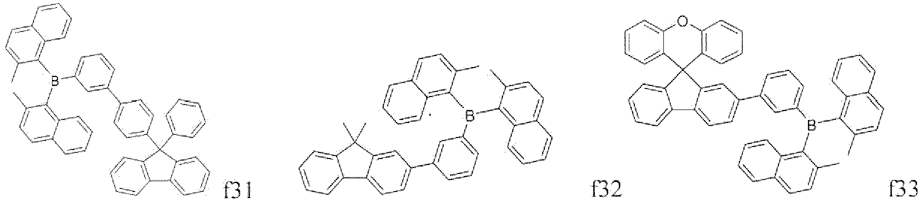

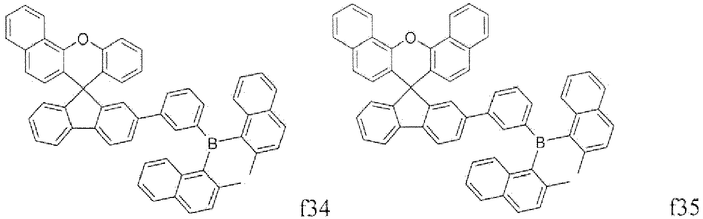

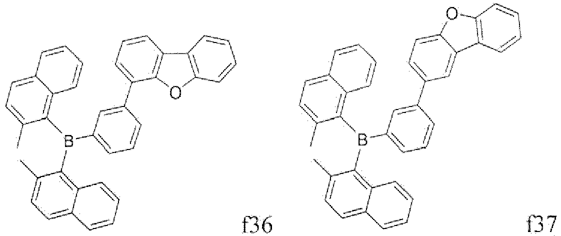

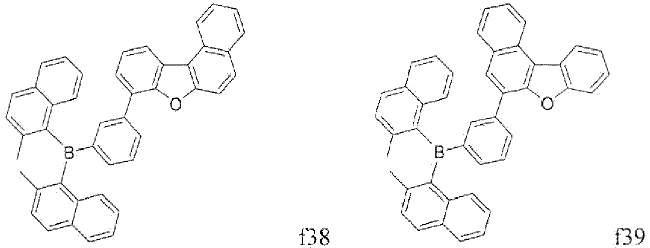

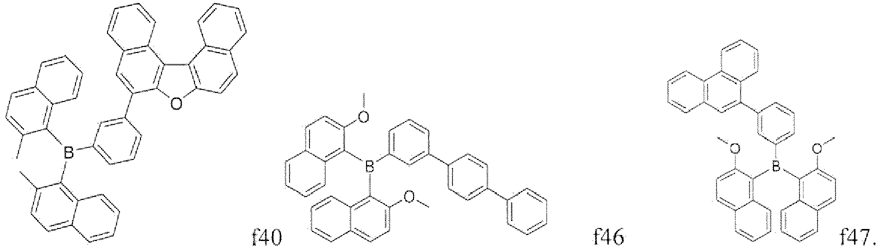

14. Method for preparing a compound of formula (I) as defined in claim 9 comprising the following steps:
a) reacting a compound of formula (P1) 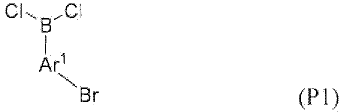 and a compound of formula (P2) 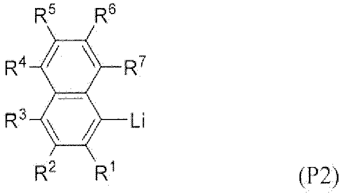 to obtain a compound of formula (P3) 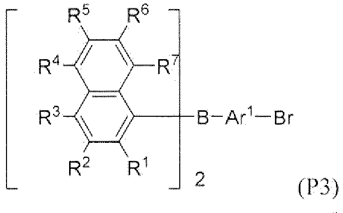 and
b) reacting the compound of formula (P3) obtained in step a) with a compound of the formula Ar²B(OR¹⁰)₂, wherein R¹⁰ is independently selected from hydrogen or C₁ to C₆ alkyl, to obtain a compound of formula (I), 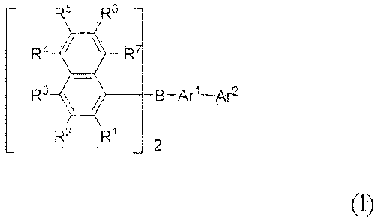 wherein R¹ to R⁷, Ar¹ and Ar² are defined as in claim 9.

15. Method according to claim 14, wherein reacting P1 and P2 in step a) is in the presence of diethylether and/or tertrahydrofuran.

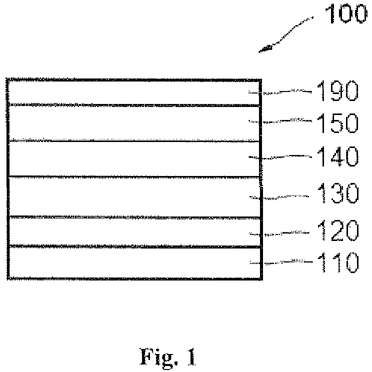

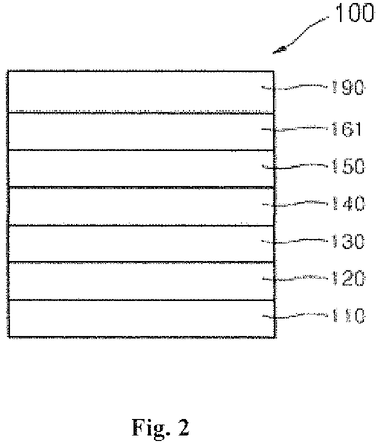

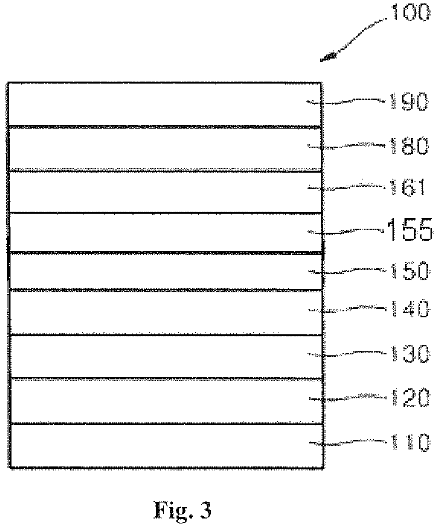

## Patentansprüche

1. Organische elektrolumineszente Vorrichtung (100), umfassend zumindest eine halbleitende Schicht, umfassend eine Verbindung der Formel (I) 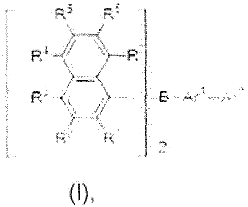
wobei R¹, R³ und R⁷ unabhängig ausgewählt sind aus einer Gruppe, bestehend aus H, D, C₁-C₁₆-Alkyl und C₁-C₁₆-Alkoxy;
R², R⁴, R⁵ und R⁶ unabhängig ausgewählt sind aus einer Gruppe, bestehend aus H, D, C₁-C₁₆-Alkyl, C₁-C₁₆-Alkoxy und C₆-C₂₀-Aryl;
Ar¹ ausgewählt ist aus substituiertem oder unsubstituiertem C₆-C₂₀-Aryl, wobei in dem Fall, dass Ar¹ substituiert ist, die Substituenten unabhängig ausgewählt sind aus einer Gruppe, bestehend aus D, C₁-C₁₂-Alkyl, C₁-C₁₆-Alkoxy und C₆-C₂₀-Aryl; und
Ar² ausgewählt ist aus einer Gruppe, bestehend aus H, D, substituiertem oder unsubstituiertem C₆-C₄₀-Aryl und Gruppen der folgenden Formeln (IIa) bis (IIh), wobei * die Position in der jeweiligen Ar²-Gruppe zum Binden der Ar²- zu der Ar¹-Gruppe markiert, 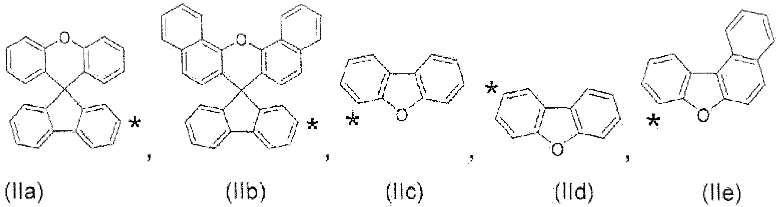 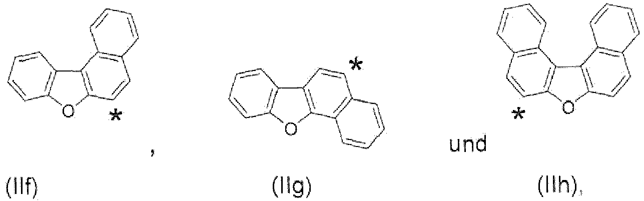
wobei in dem Fall, dass Ar² substituiert ist, die Substituenten unabhängig ausgewählt sind aus einer Gruppe, bestehend aus D, Halogenid, C₁-C₁₆Alkyl, C₁-C₁₆-Alkoxy und C₆-C₂₀-Aryl, vorzugsweise Naphthyl, 9-Fluorenyl, 2-Fluorenyl, 3-Fluorenyl und 4-Fluorenyl, wobei C₆-C₁₀-Aryl unsubstituiert oder substituiert sein kann mit C₁-C₁₆Alkyl, C₁-C₁₆-Heteroalkyl und C₆-C₄₀-Aryl;
wobei Ar¹ und Ar² ferner mittels eines Methylen(-CR⁸R⁹-)- oder eines Oxy(-O-)-Rests miteinander verbunden sein können, um eine Fluoren- oder Dibenzofuranstruktur zu bilden, wobei R⁸ und R⁹ unabhängig ausgewählt sein können aus H, C₁-C₁₆-Alkyl und C₁-C₁₆-Alkoxy und C₆-C₂₀-Aryl;
wobei die organische elektrolumineszente Vorrichtung (100) ferner eine Emissionsschicht (150) und eine Kathode (190) umfasst, wobei die halbleitende Schicht, die die Verbindung der Formel (I) umfasst, zwischen der Emissionsschicht (150) und der Kathodenelektrode (190) angeordnet ist.

2. Organische elektrolumineszente Vorrichtung (100) nach Anspruch 1, ferner umfassend eine Elektroneninjektionsschicht (180), wobei die halbleitende Schicht, die die Verbindung der Formel (I) umfasst, zwischen der Emissionsschicht (150) und der Elektroneninjektionsschicht (180) angeordnet ist.

3. Organische elektrolumineszente Vorrichtung (100) nach einem der vorangehenden Ansprüche, wobei die halbleitende Schicht, die die Verbindung der Formel (I) umfasst, ferner einen Dotanden umfasst, der ein Lithiumhalogenid und/oder ein Lithium-organischer Komplex ist.

4. Organische elektrolumineszente Vorrichtung (100) nach einem der vorangehenden Ansprüche, wobei die halbleitende Schicht, die die Verbindung der Formel (I) umfasst, ferner einen Dotanden umfasst, der ein Metall in dessen elementarer Form ist, wobei das Metall ausgewählt ist aus einem Alkali-, Erdalkali- oder Seltenerdmetall und einem Gemisch davon.

5. Organische elektrolumineszente Vorrichtung (100) nach einem der vorangehenden Ansprüche, wobei Ar² ausgewählt ist aus der Gruppe, bestehend aus Phenyl, Naphthyl, Anthranyl, Phenanthryl, Pyrenyl, 9-Fluorenyl, 2-Fluorenyl, 3-Fluorenyl, 4-Fluorenyl, 5-Fluorenyl und Formel (IIa) bis (IIh).

6. Organische elektrolumineszente Vorrichtung (100) nach einem der vorangehenden Ansprüche, wobei R¹ C₁-C₁₂-Alkyl, vorzugsweise Methyl, oder C₁-C₁₂-Alkoxy, vorzugsweise Methoxy, ist und R² bis R⁷ jeweils H sind.

7. Organische elektrolumineszente Vorrichtung (100) nach einem der vorangehenden Ansprüche, wobei Ar¹ Phenyl, Biphenyl, Naphthyl, Phenanthryl oder Anthranyl ist.

8. Organische elektrolumineszente Vorrichtung (100) nach einem der vorangehenden Ansprüche, wobei die Verbindung der Formel (I) ausgewählt ist aus

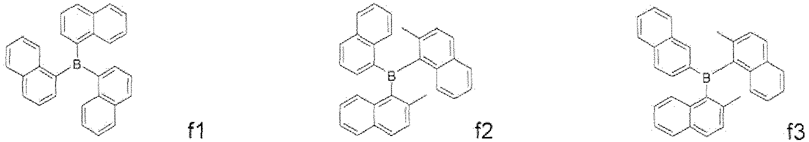

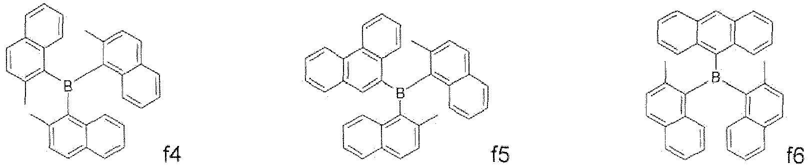

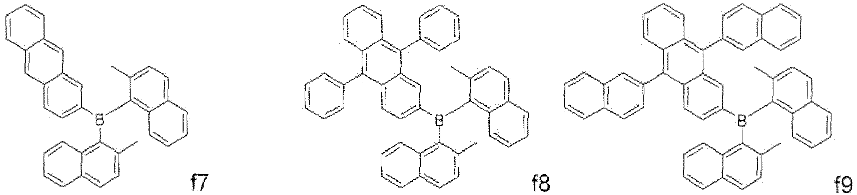

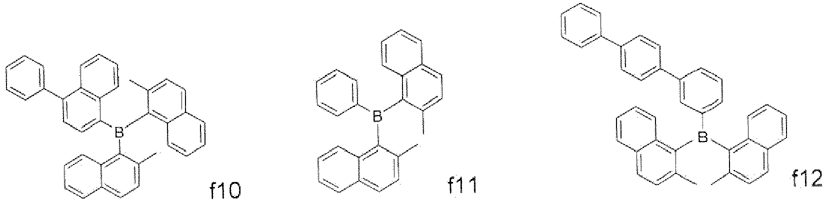

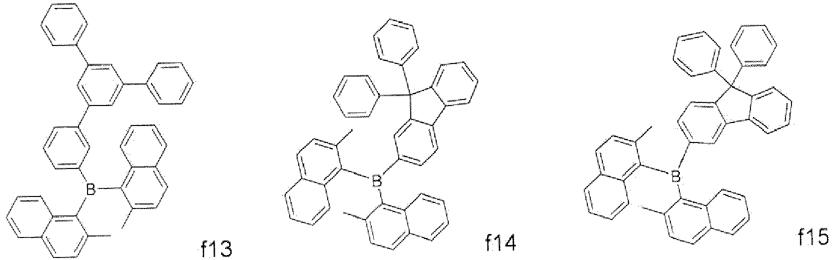

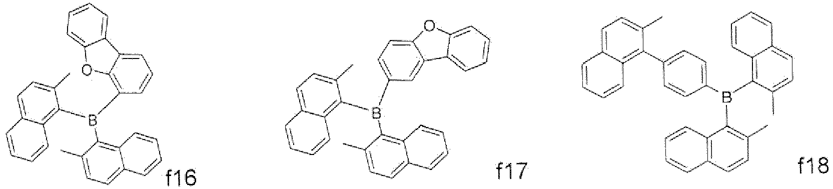

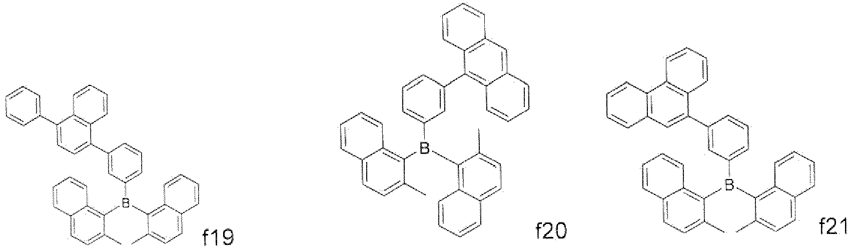

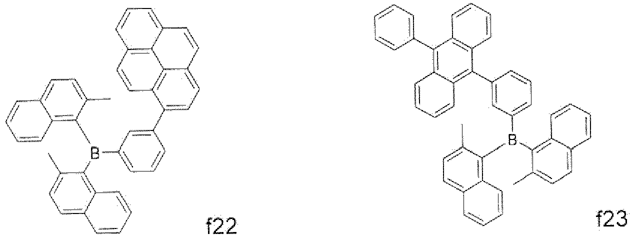

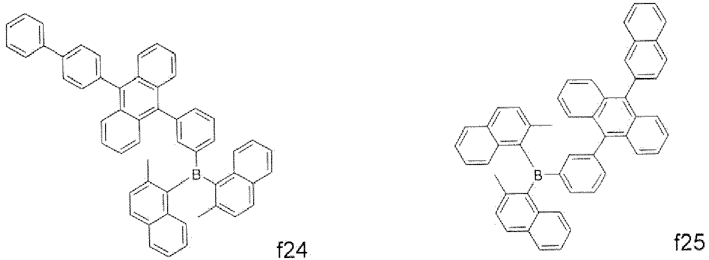

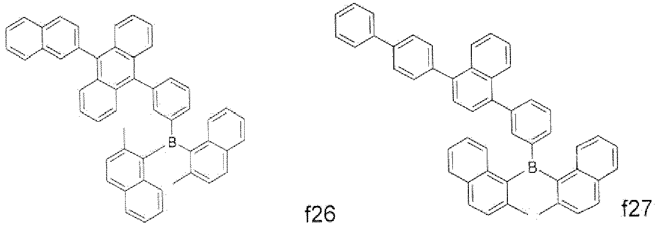

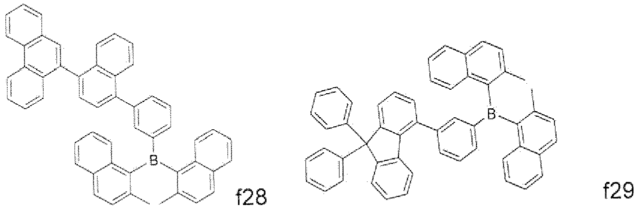

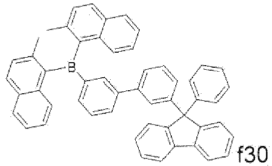

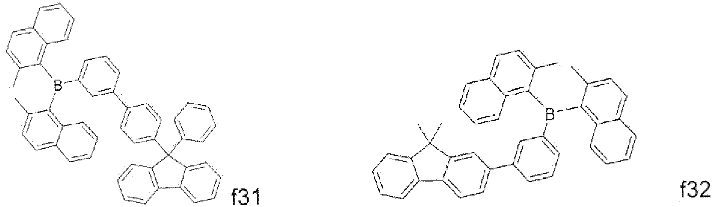

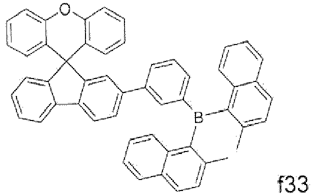

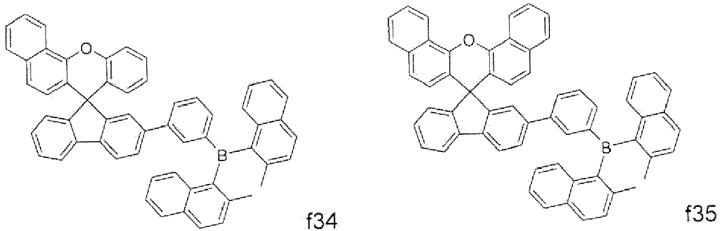

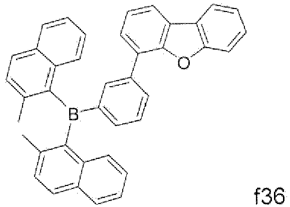

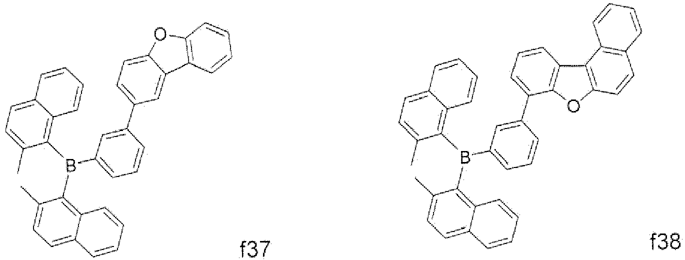

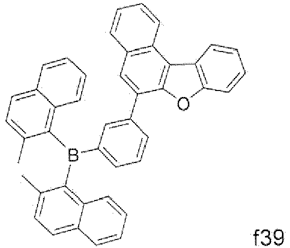

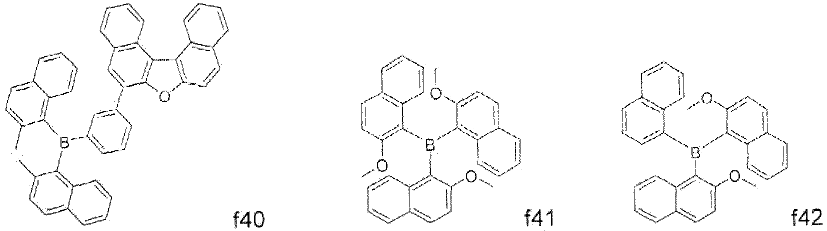

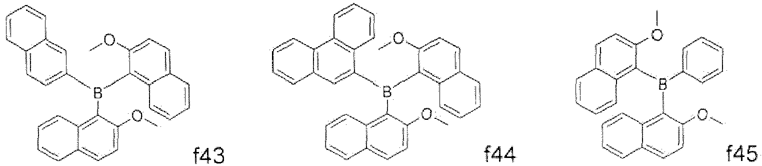

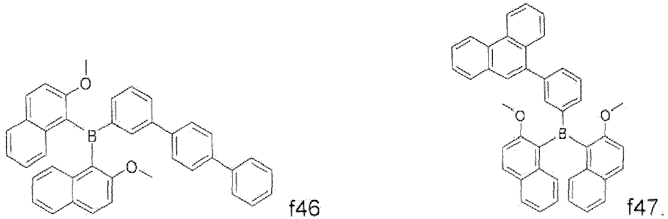

9. Verbindung der Formel (I) 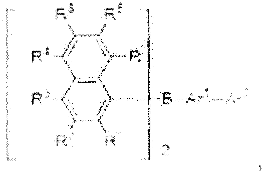
wobei R¹, R³ und R⁷ unabhängig ausgewählt sind aus einer Gruppe, bestehend aus H, D, C₁-C₁₆-Alkyl und C₁-C₁₆-Alkoxy;
R², R⁴, R⁵ und R⁶ unabhängig ausgewählt sind aus einer Gruppe, bestehend aus H, D, C₁-C₁₆Alkyl, C₁-C₁₆-Alkoxy und C₆-C₂₀-Aryl;
Ar¹ ausgewählt ist aus substituiertem oder unsubstituiertem C₆-C₂₀-Aryl, wobei in dem Fall, dass Ar¹ substituiert ist, die Substituenten unabhängig ausgewählt sind aus einer Gruppe, bestehend aus D, C₁-C₁₂-Alkyl, C₁-C₁₆-Alkoxy und C₆-C₂₀-Aryl;
Ar² ausgewählt ist aus einer Gruppe, bestehend aus substituiertem oder unsubstituiertem C₆-C₄₀-Aryl und Gruppen der folgenden Formeln (IIa) bis (IIh), wobei * die Position in der jeweiligen Ar²-Gruppe zum Binden der Ar²- zu der Ar¹-Gruppe markiert, 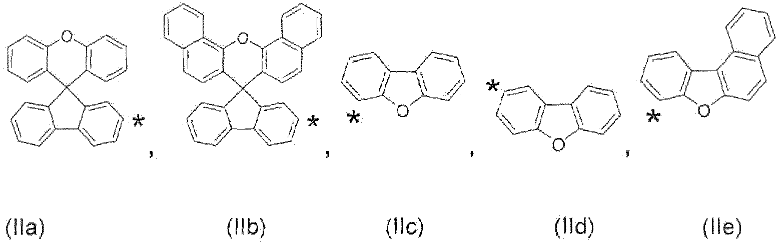 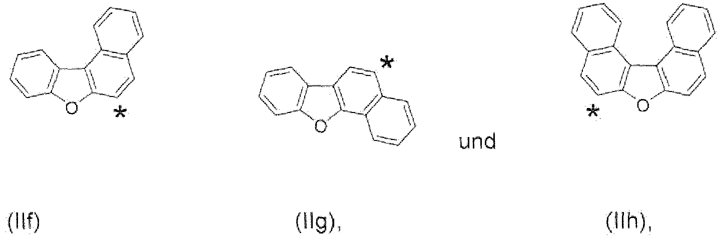
wobei in dem Fall, dass Ar² substituiert ist, die entsprechenden Substituenten unabhängig ausgewählt sind aus einer Gruppe, bestehend aus D, Halogenid, C₁-C₁₂-Alkyl und C₁-C₁₂-Alkyloxy, C₆-C₂₀-Aryl, vorzugsweise Naphthyl, 9-Fluorenyl, 2-Fluorenyl, 3-Fluorenyl und 4-Fluorenyl, wobei das C₆-C₁₀-Aryl unsubstiuiert oder substituiert sein kann mit C₁-C₁₆-Alkyl, C₁-C₁₆-Heteroalkyl und C₆-C₄₀-Aryl;
wobei Ar¹ und Ar² ferner mittels eines Methylen(-CR⁸R⁹-)- oder eines Oxy(-O-)-Rests miteinander verbunden sein können, um eine Fluoren- oder Dibenzofuranstruktur zu bilden, wobei R⁸ und R⁹ unabhängig ausgewählt sein können aus H und C₆-C₂₀-Aryl.

10. Verbindung nach Anspruch 10, wobei Ar² ausgewählt ist aus einer Gruppe, bestehend aus Phenyl, Biphenyl, Anthranyl, Phenanthranyl, Pyrenyl, 9-Fluorenyl, 2-Fluorenyl, 3-Fluorenyl, 4-Fluorenyl, 5-Fluorenyl und Formel (IIa) bis (IIh), wie in Anspruch 8 definiert.

11. Verbindung nach Anspruch 9 oder 10, wobei R¹ C₁-C₁₂-Alkyl, vorzugsweise Methyl, oder C₁-C₁₂-Alkoxy, vorzugsweise Methoxy, ist und R² bis R⁷ jeweils H sind.

12. Verbindung nach einem der Ansprüche 9 bis 11, wobei Ar¹ Phenyl, Biphenyl, Naphthyl oder Anthranyl ist.

13. Verbindung nach einem der Ansprüche 9 bis 12, wobei die Verbindung der Formel (1) ausgewählt ist aus

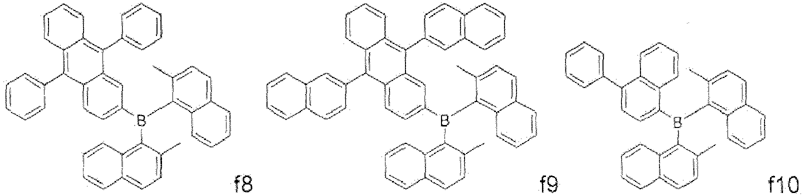

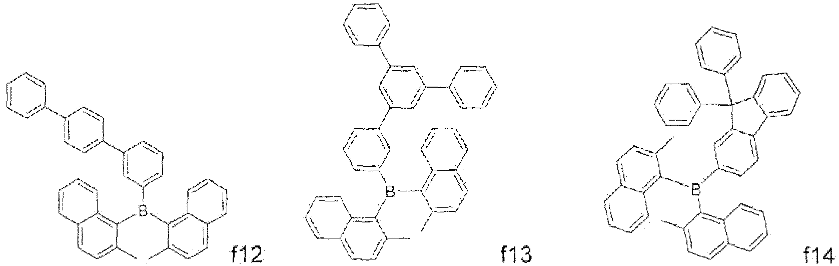

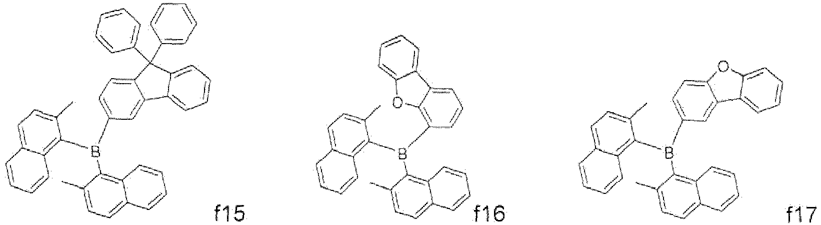

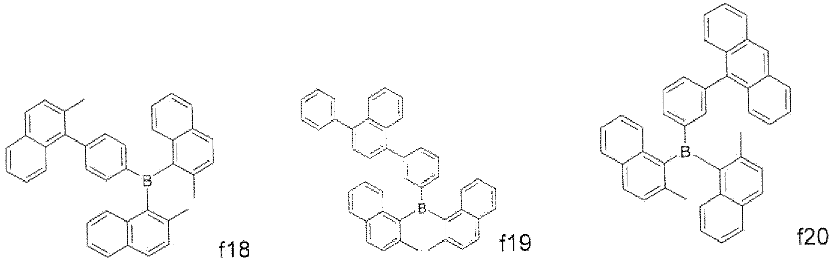

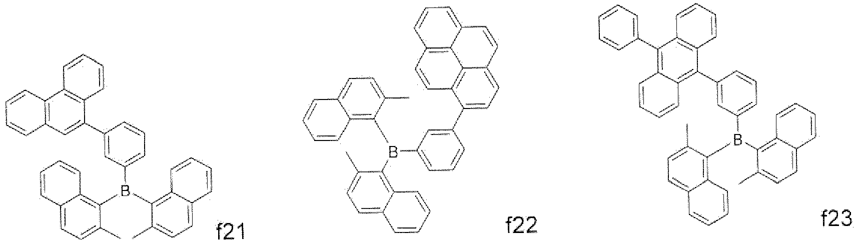

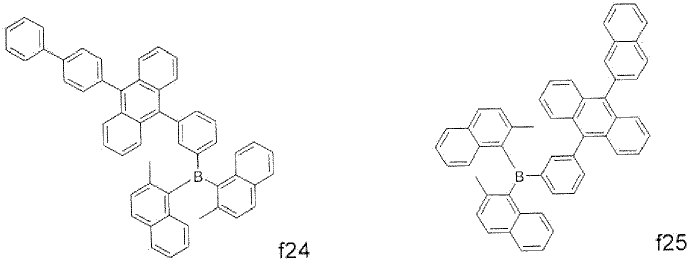

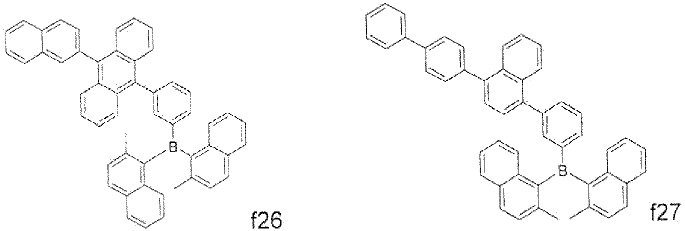

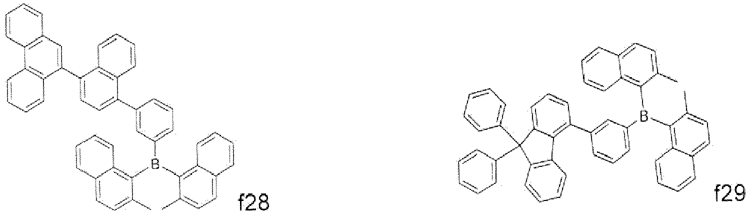

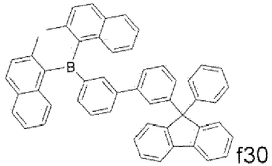

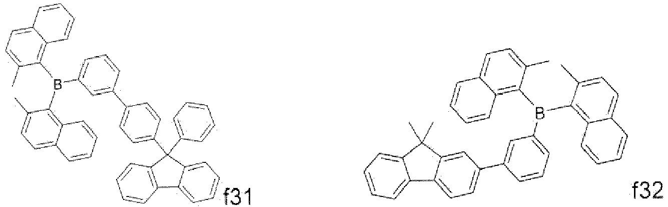

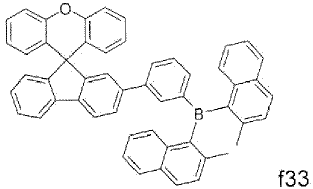

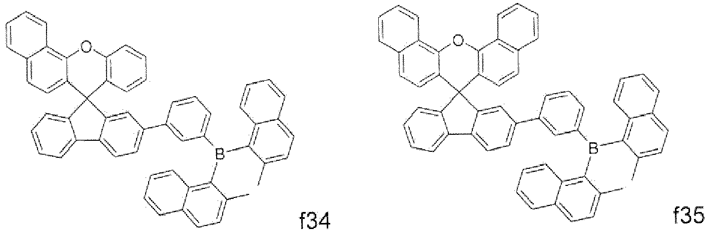

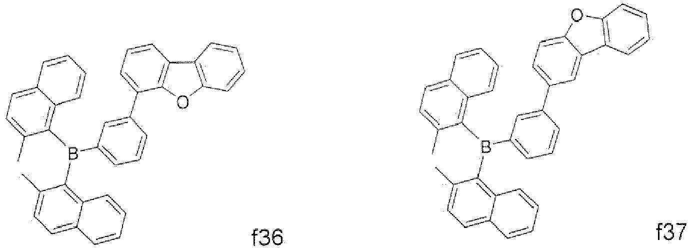

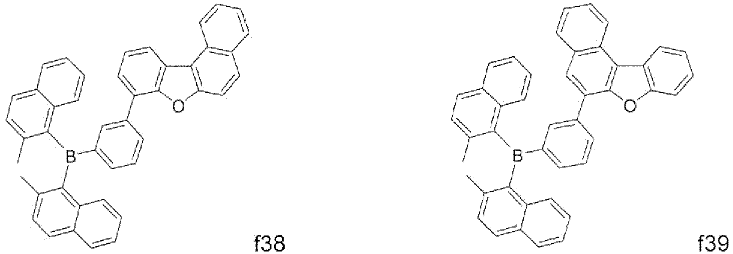

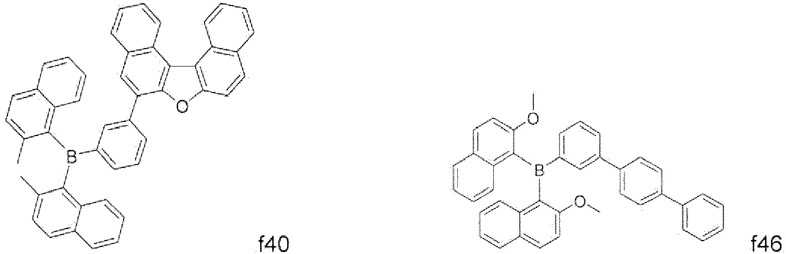

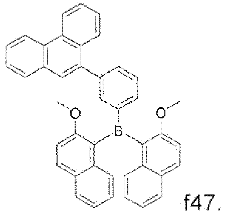

14. Verfahren zum Herstellen einer Verbindung der Formel (I), wie in Anspruch 9 definiert, umfassend die folgenden Schritte:
a) Reagieren einer Verbindung der Formel (P1) 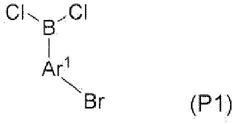 und einer Verbindung der Formel (P2) 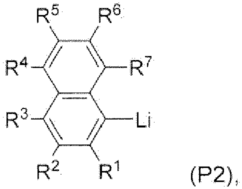 um eine Verbindung der Formel (P3) zu erhalten 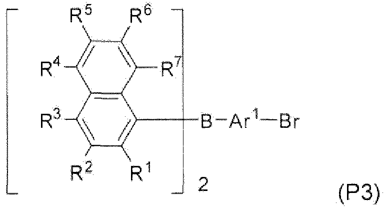 und
b) Reagieren der Verbindung der Formel (P3), die in Schritt a) erhalten wird, mit einer Verbindung der Formel Ar²B(OR¹⁰)₂, wobei R¹⁰ unabhängig ausgewählt ist aus Wasserstoff oder C₁- bis C₆-Alkyl, um eine Verbindung der Formel (I) zu erhalten 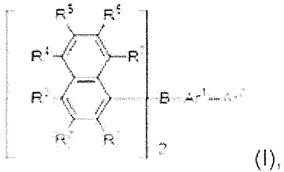 wobei R¹ bis R⁷, Ar¹ und Ar² wie in Anspruch 9 definiert sind.

15. Verfahren nach Anspruch 14, wobei das Reagieren von P1 und P2 in Schritt a) in Gegenwart von Diethylether und/oder Tetrahydrofuran ist.

## Revendications

1. Dispositif organique électroluminescent (100) comprenant au moins une couche semi-conductrice comprenant un composé de formule (I) 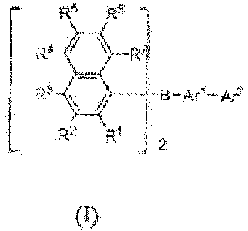
dans laquelle R¹, R³ et R⁷ sont indépendamment choisis dans un groupe constitué de H, de D, d'un alkyle en C₁-C₁₆ et d'un alcoxy en C₁-C₁₆ ;
R², R⁴, R⁵ et R⁶ sont indépendamment choisis dans un groupe constitué de H, de D, d'un alkyle en C₁-C₁₆, d'un alcoxy en C₁-C₁₆ et d'un aryle en C₆-C₂₀ ;
Ar¹ est choisi parmi un aryle en C₆-C₂₀ substitué ou non substitué, dans lequel, dans le cas où Ar¹ est substitué, les substituants sont indépendamment choisis dans un groupe constitué de D, d'un alkyle en C₁-C₁₂, d'un alcoxy en C₁-C₁₆ et d'un aryle en C₆-C₂₀ ; et
Ar² est choisi dans un groupe constitué de H, de D, d'un aryle en C₆-C₄₀ substitué ou non substitué et de groupes de formules (IIa} à (IIh) suivantes, dans lequel * marque la position dans le groupe Ar² respectif permettant la liaison du groupe Ar² au groupe Ar¹, 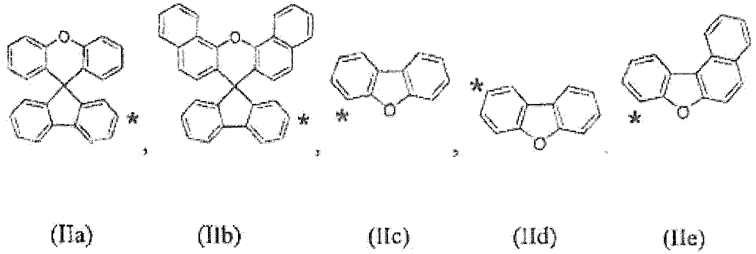 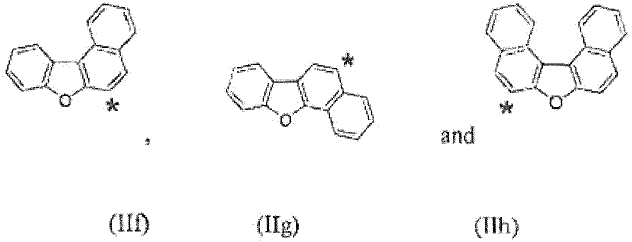
dans laquelle dans le cas où Ar² est substitué, les substituants sont indépendamment choisis dans un groupe constitué de D, d'un halogénure, d'un alkyle en C₁-C₁₆, d'un alcoxy en C₁-C₁₆ et d'un aryle en C₆-C₂₀, de préférence du naphtyle, du 9-fluorényle, du 2-fluorényle, du 3-fluorényle et du 4-fluorényle, dans laquelle l'aryle en C₆-C₁₀ peut être non substitué ou substitué par un alkyle en C₁-C₁₆, un hétéroalkyle en C₁-C₁₆ et un aryle en C₆-C₄₀ ;
dans laquelle Ar¹ et Ar² peuvent en outre être reliés par l'intermédiaire d'un fragment méthylène (-CR⁸R⁹-) ou d'un fragment oxy (-O-) afin de former une structure fluorène ou dibenzofurane, R⁸ et R⁹ peuvent être indépendamment choisis parmi H, un alkyle en C₁-C₁₆, un alcoxy en C₁-C₁₆ et un aryle en C₆-C₂₀ ;
dans lequel le dispositif organique électroluminescent (100) comprenant en outre une couche d'émission (150) et une cathode (190), dans lequel la couche semi-conductrice comprenant le composé de formule (I) est agencée entre la couche d'émission (150) et l'électrode de cathode (190).

2. Dispositif organique électroluminescent (100) selon la revendication 1 comprenant en outre une couche d'injection d'électrons (180), dans lequel la couche semi-conductrice comprenant le composé de formule (I) est agencée entre la couche d'émission (150) et la couche d'injection d'électrons (180).

3. Dispositif organique électroluminescent (100) selon l'une quelconque des revendications précédentes, dans lequel la couche semi-conductrice comprenant le composé de formule (I) comprend en outre un dopant étant un halogénure de lithium et/ou un complexe organique de lithium.

4. Dispositif organique électroluminescent (100) selon l'une quelconque des revendications précédentes, dans lequel la couche semi-conductrice comprenant le composé de formule (I) comprend en outre un dopant étant un métal dans sa forme élémentaire, dans lequel le métal est choisi parmi un alcalin, un alcalino-terreux et un métal des terres rares et un mélange de ceux-ci.

5. Dispositif organique électroluminescent (100) selon l'une quelconque des revendications précédentes, dans lequel Ar³ est choisi dans le groupe constitué du phényle, du naphtyle, de l'anthranyle, du phénanthryle, du pyrényle, du 9-fluorényle, du 2-fluorényle, du 3-fluorényle, du 4-fluorényle, du 5-fluorényle et des formules (IIa} à (IIb).

6. Dispositif organique électroluminescent (100) selon l'une quelconque des revendications précédentes, dans lequel R¹ représente un alkyle en C₁-C₁₂, de préférence un méthyle, ou un alcoxy en C₁-C₁₂, de préférence un méthoxy et R² à R⁷ représentent chacun H.

7. Dispositif organique électroluminescent (100) selon l'une quelconque des revendications précédentes, dans lequel Ar¹ représente le phényle, le biphényle, le naphtyle, le phénanthryle ou l'anthranyle.

8. Dispositif organique électroluminescent (100) selon l'une quelconque des revendications précédentes, dans lequel le composé de formule (I) est choisi parmi

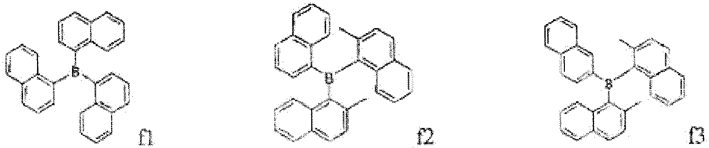

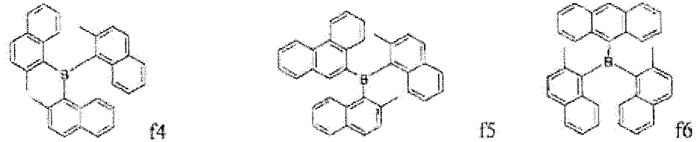

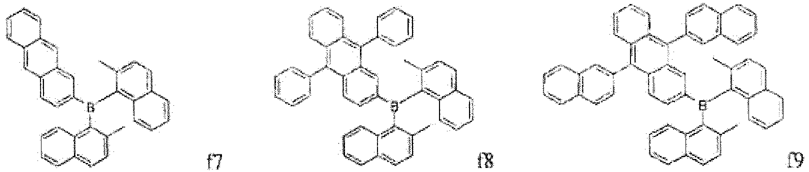

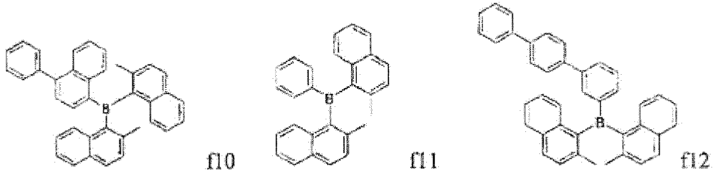

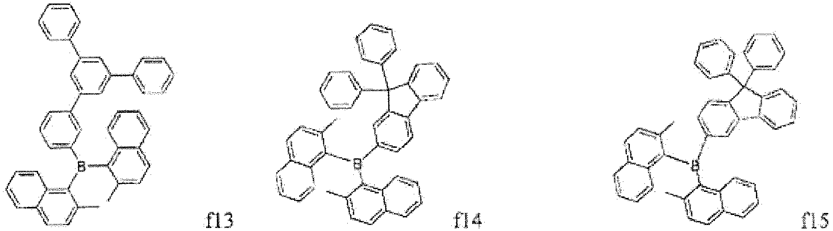

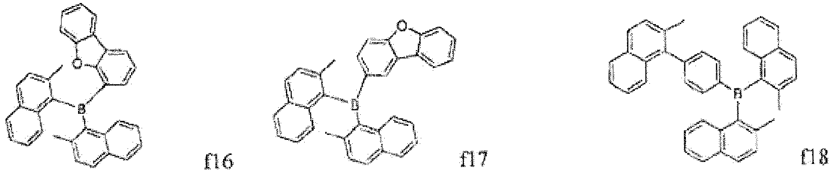

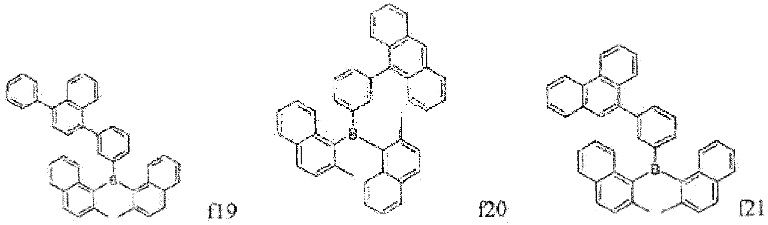

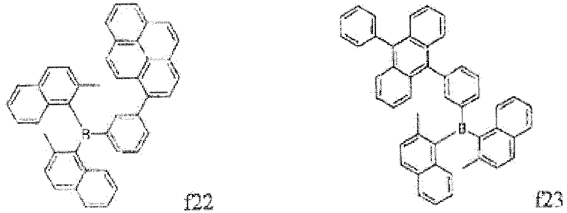

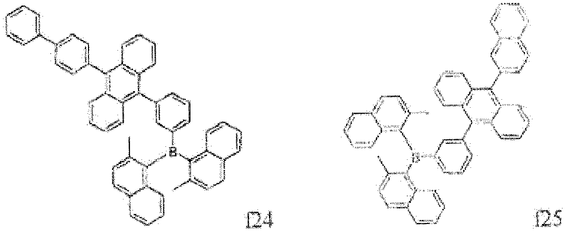

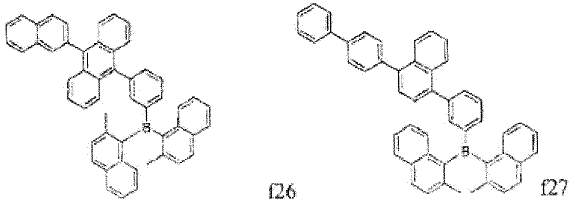

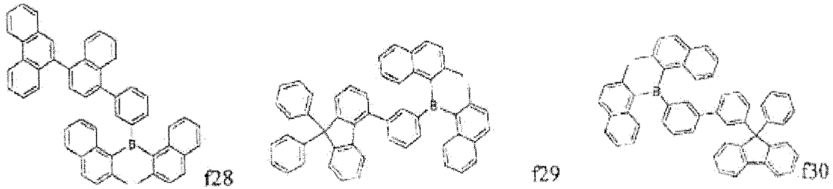

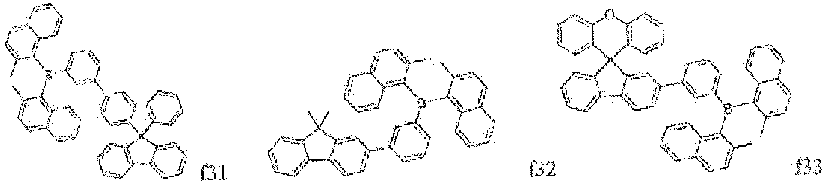

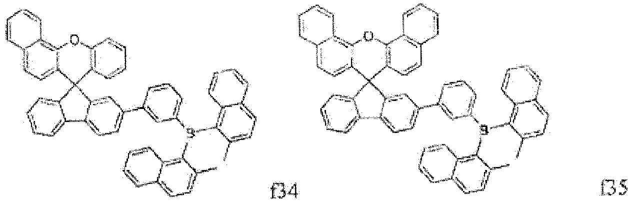

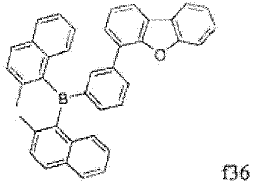

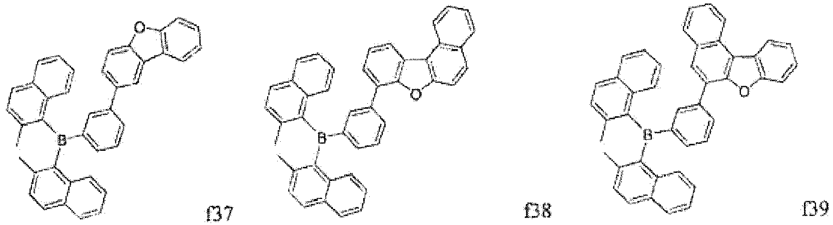

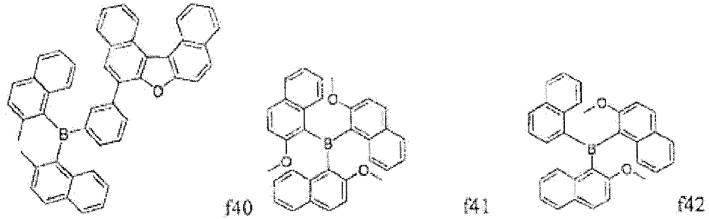

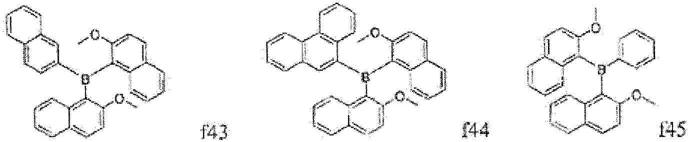

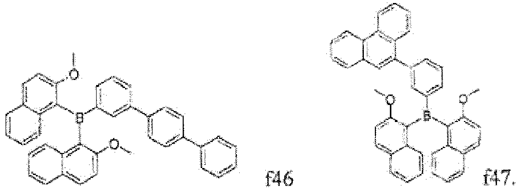

9. Composé de formule (I) 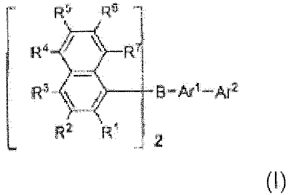
dans laquelle R¹, R³ et R⁷ sont indépendamment choisis dans un groupe constitué de H, de D, d'un alkyle en C₁-C₁₆ et d'un alcoxy en C₁-C₁₆ ;
R², R⁴, R⁵ et R⁶ sont indépendamment choisis dans un groupe constitué de H, de D, d'un alkyle en C₁-C₁₆, d'un alcoxy en C₁-C₁₆ et d'un aryle en C₆-C₂₀ ;
Ar¹ est choisi parmi un aryle en C₆-C₂₀ substitué ou non substitué, dans lequel, dans le cas où Ar¹ est substitué, les substituants sont indépendamment choisis dans un groupe constitué de D, d'un alkyle en C₁-C₁₂, d'un alcoxy en C₁-C₂₀ et d'un aryle en C₆-C₂₀ ;
Ar² est choisi dans un groupe constitué de H, de D, d'un aryle en C₆-C₄₀ substitué ou non substitué et de groupes de formules (IIa) à (IIh) suivantes, dans lesquelles * marque la position dans le groupe Ar² respectif permettant la liaison du groupe Ar² au groupe Ar¹, 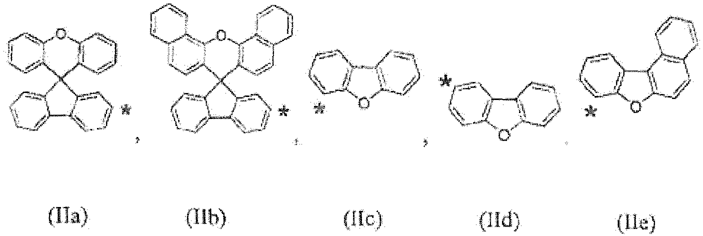 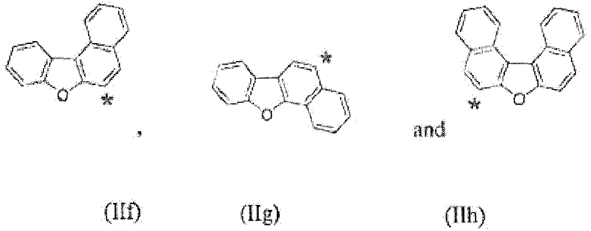
dans laquelle dans le cas où Ar² est substitué, les substituants sont indépendamment choisis dans un groupe constitué de D, d'un halogénure, d'un alkyle en C₁-C₁₂, d'un alcoxy en C₁-C₁₂, d'un aryle en C₆-C₂₀, de préférence du naphtyle, du 9-fluorényle, du 2-fluorényle, du 3-fluorényle et du 4-fluorényle, dans laquelle l'aryle en C₆-C₁₀ peut être non substitué ou substitué par un alkyle en C₁-C₁₆, un hétéroalkyle en C₁-C₁₆ et un aryle en C₆-C₄₀ ;
dans laquelle Ar¹ et Ar² peuvent en outre être reliés par l'intermédiaire d'un fragment méthylène (-CR⁸R⁹-) ou d'un fragment oxy (-O-) afin de former une structure fluorène ou dibenzofurane, dans laquelle R⁸ et R⁹ peuvent être indépendamment choisis parmi H et un aryle en C₆-C₂₀.

10. Composé selon la revendication 10, dans lequel Ar² est choisi dans le groupe constitué du phényle, du biphényle, du naphtyle, de l'anthranyle, du phénanthryle, du pyrényle, du 9-fluorényle, du 2-fluorényle, du 3-fluorényle, du 4-fluorényle, du 5-fluorényle et des formules (IIa} à (IIb) telles que définies dans la revendication 8.

11. Composé selon la revendication 9 ou la revendication 10, dans lequel R¹ représente un alkyle en C₁-C₁₂, de préférence un méthyle, ou un alcoxy en C₁-C₁₂, de préférence un méthoxy, et R² à R⁷ représentent chacun H.

12. Composé selon l'une quelconque des revendications 9 à 11, dans lequel Ar¹ représente le phényle, le biphényle, le naphtyle, le phénanthryle ou l'anthranyle.

13. Composé selon l'une quelconque des revendications 9 à 12, dans lequel le composé de formule (I) est choisi parmi

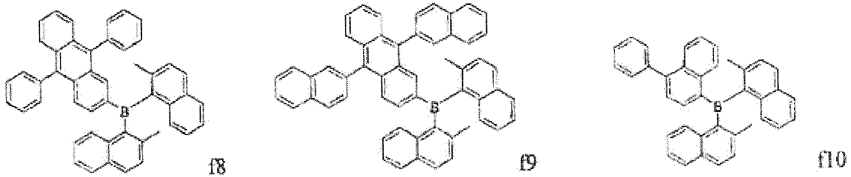

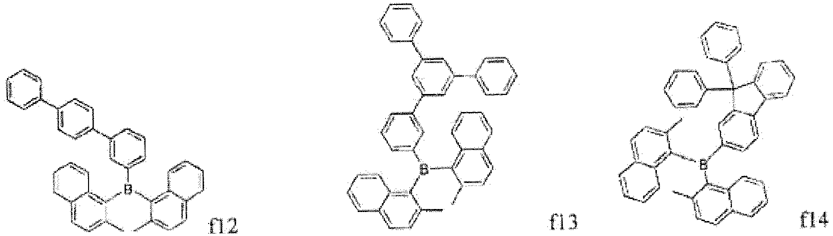

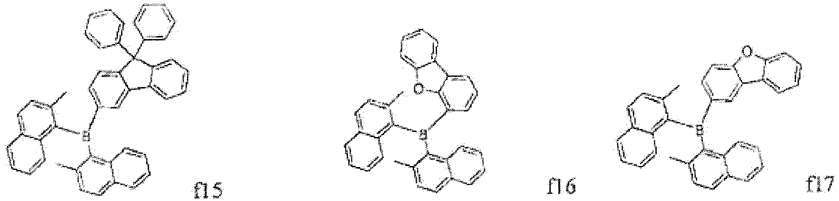

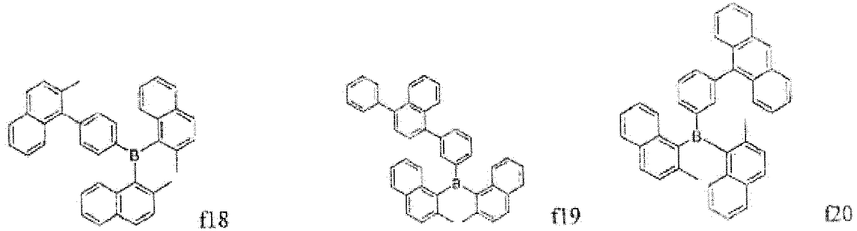

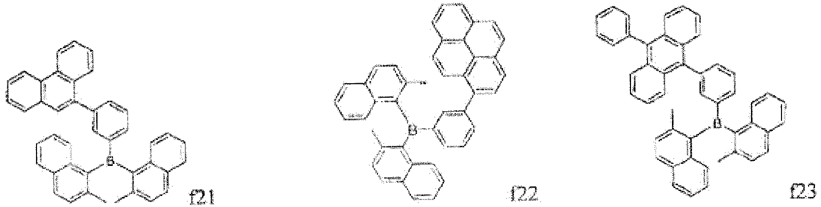

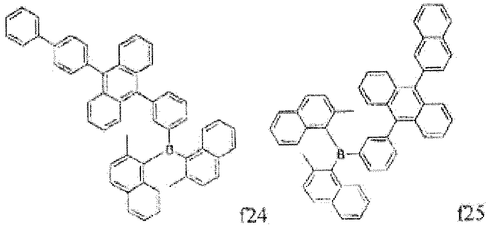

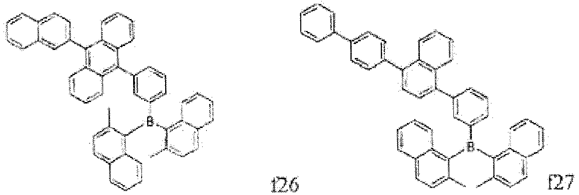

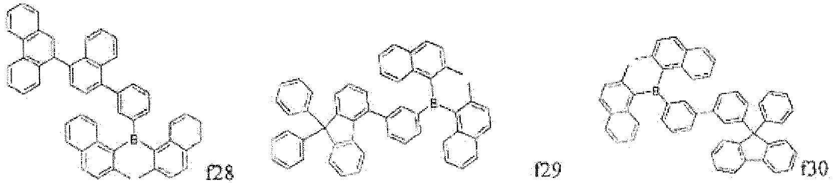

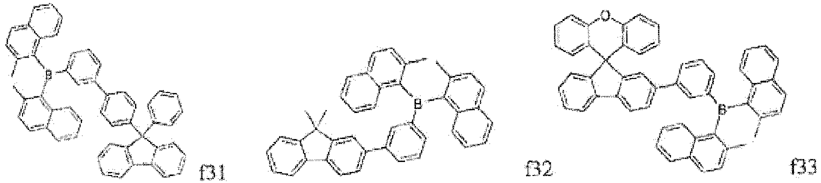

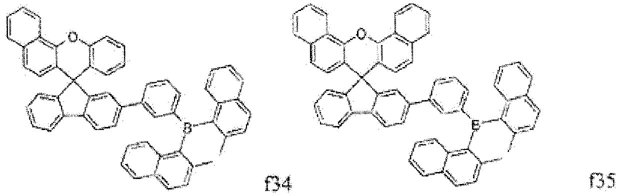

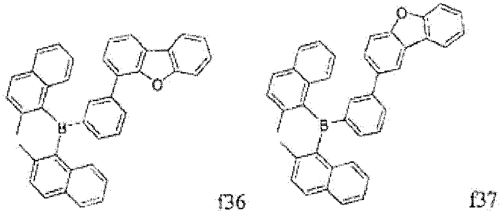

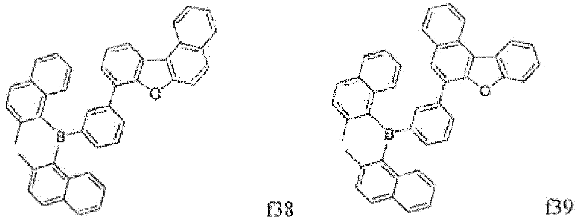

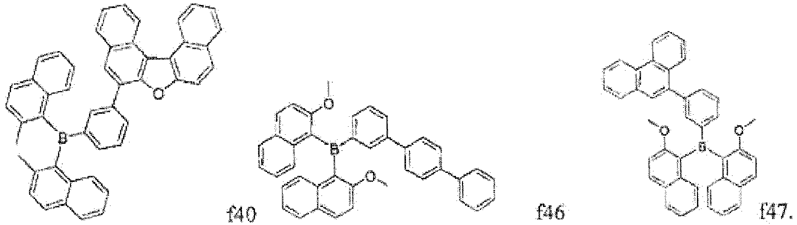

14. Procédé de préparation d'un composé de formule (I) tel que défini dans la revendication 9 comprenant les étapes suivantes :
a) la mise en réaction d'un composé de formule (P1) 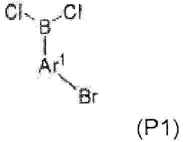 et d'un composé de formule (P2) 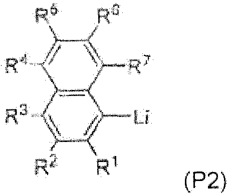 afin d'obtenir un composé de formule (P3) 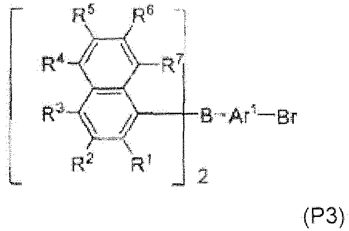 et
b) la mise en réaction du composé de formule (P3) obtenu lors de l'étape a) avec un composé de formule Ar²B(OR¹⁰)₂, dans laquelle R¹⁰ est indépendamment choisi parmi l'hydrogène ou un alkyle en C₁ à C₆, afin d'obtenir un composé de formule (I), 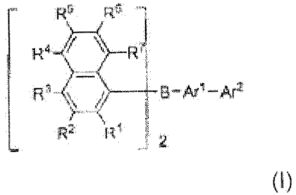 dans laquelle R¹ à R⁷, Ar¹ et Ar² sont tels que définis dans la revendication 9.

15. Procédé selon la revendication 14, dans lequel la réaction de P1 et de P2 dans l'étape a) s'effectue en présence d'éther diéthylique et/ou de tétrahydrofurane.
